# EUROPEAN PATENT SPECIFICATION

(11) **EP 3 526 803 B1**
(45) Date of publication and mention of the grant of the patent: **03.05.2023**
(21) Application number: 17790812.6
(22) Date of filing: 17.10.2017
(51) Int. Cl.: H01G 9/20, G01N 33/487

(54) **ARRAY OF LIGHT SENSITIVE MEMBRANES BASED ON PHOSPHOLIPIDS**
ARRAY LICHTEMPFINDLICHER MEMBRANEN AUF PHOSPHOLIPIDBASIS
RÉSEAU DE MEMBRANES SENSIBLES À LA LUMIÈRE À BASE DE PHOSPHOLIPIDES

(30) Priority: 17.10.2016 GB 201617569
(43) Date of publication of application: 21.08.2019
(73) Proprietor: Oxford University Innovation Limited, Oxford, Oxfordshire OX2 0JB (GB)
(72) Inventor: BAYLEY, Hagan, Oxford Oxfordshire OX1 3TA (GB); RESTREPO SCHILD, Vanessa, Oxford Oxfordshire OX1 3TA (GB)
(74) Representative: J A Kemp LLP
(86) International application number: PCT/GB2017/053147
(87) International publication number: WO 2018/073583

(56) References cited:
- WO-A1-2011/015870
- US-A1- 2014 038 065
- TIEN H T ET AL: "BILAYER LIPID MEMBRANES (BLM): AN EXPERIMENTAL SYSTEM FOR BIOMOLECULAR ELECTRONIC DEVICE DEVELOPMENT", JOURNAL OF MOLECULAR ELECTRONICS, JOHN WILEY AND SONS LTD. CHICHESTER, GB, vol. 4, 21 September 1988 (1988-09-21), pages S01-30, XP000098506,
- LIPING WEN ET AL: "Bio-inspired Photoelectric Conversion Based on Smart-Gating Nanochannels", ADVANCED FUNCTIONAL MATERIALS, WILEY - V C H VERLAG GMBH & CO. KGAA, DE, vol. 20, no. 16, 23 August 2010 (2010-08-23), pages 2636-2642, XP001556992, ISSN: 1616-301X, DOI: 10.1002/ADFM.201000239 [retrieved on 2010-07-06]

## Description

### FIELD OF THE INVENTION

The present invention relates to an array which is able to detect light and generate an ion flux. The present invention also relates to uses of the array and methods of preparing the array.

### BACKGROUND OF THE INVENTION

Biological cameras, such as the eye, contain a soft and high-resolution digital light-sensing electrical array: the retina¹. The array comprises photoreceptor cells, which are 1-10 µm across² and contain stacks of proteins, the rhodopsins³, which are activated by light. Nonbiological cameras are typically based on charge-coupled device (CCD) technology, with sensors consisting of 10-16 µm diameter pixels. Each pixel contains an internal depletion region, which means that only a portion of each pixel responds to light^{4, 5}. Furthermore, there is a limit to the size of a CCD pixel⁴. Biological retinas have higher spatial resolution² and spectral sensitivities^{6, 7} than current electronic devices. Further, the structural components of biological cameras are made of soft materials^{8, 9}, unlike CCDs which are hard silicon-based devices^{4, 5}.

Hydrogels have previously been used as soft materials to build electrical arrays¹¹. Hydrogel pillars can form bilayers with a second hydrogel surface, which has allowed the optical recording of currents from protein nanopores in multiple pillars simultaneously. Furthermore, the present inventors have previously made simple light-sensors from aqueous droplet networks containing bacteriorhodopsin (bR)¹², from *Halobacterium salinarum¹³.* bR is a light-driven pump, responding to green light (absorbance maximum of 570 nm), which generates current from the movement of charge, in the form of protons, across membranes¹³⁻¹⁵. Several groups have prototyped bioelectronic imaging devices with bR¹⁶⁻²⁰, by depositing the protein as films on electrode surfaces.

### SUMMARY OF THE INVENTION

The work leading to this invention has received funding from the European Research Council under the European Union's Seventh Framework Programme (FP7/2007-2013) / ERC grant agreement n° 294443.

The present inventors have created a synthetic biological (synbio) retina comprising a 4x4 array of light-sensing aqueous droplet bio-pixels. Aqueous droplets containing bacteriorhodopsin (bR), a light-driven proton pump, were arranged on a common hydrogel surface in lipid-containing oil. A separate lipid bilayer formed at the interface between each droplet and the hydrogel, which then incorporated bR. Electrodes in each droplet simultaneously measured the light-driven proton pumping activities of each bio-pixel. The synbio retina derived by this bottom-up synthetic biology approach can detect patterns of light moving across the device, which are transduced as electrical signals generated in each bio-pixel. The soft synbio retinas might be interfaced with living tissues. The patterned generation of proton currents might also be used to power selected regions of synthetic tissues. The soft synbio retinas also have the advantage of being biocompatible. Although efforts have been made to make silicon cameras flexible¹⁰, a combination of soft materials and light-sensing proteins has not been examined previously.

The present invention therefore provides an array for passing an electrical current between a first aqueous object and a second aqueous object, wherein:
(a) the array comprises a scaffold, two or more of the first aqueous objects and at least one of the second aqueous objects;
(b) said first aqueous objects of (a) each comprise amphipathic molecules on at least part of the surface of the first aqueous objects;
(c) said second aqueous objects of (a) each comprise amphipathic molecules on at least part of the surface of the second aqueous objects;
(d) said first aqueous objects of (b) each form an interface with the second aqueous object of (c), wherein the second aqueous object is:
   (i) a single common second aqueous object, or
   (ii) a different individual second aqueous object;
(e) said interface of (d) comprises a bilayer of said amphipathic molecules of (b) and (c); and
(f) the scaffold isolates said first aqueous objects of (b) from each other.

The present invention also provides an electrochemical circuit comprising the array of the present invention.

The present invention also provides a method for detecting electromagnetic radiation, such as light, comprising exposing electromagnetic radiation, such as light, to the array of the present invention and measuring ion flux generated as an electrical current.

The present disclosure also describes a method for semi-solubilising a membrane fraction comprising a membrane protein, wherein the method comprises:
- sonicating a first suspension comprising the membrane fraction in the presence of a detergent;
- centrifuging the sonicated first suspension to form a first pellet comprising the membrane protein;
- disposing of the supernatant;
- re-suspending the first pellet to form a second suspension; and
- centrifuging the second suspension to form a second pellet comprising the membrane protein.

The present disclosure also describes a method for preparing an aqueous droplet comprising a membrane protein, wherein the method comprises:
- sonicating a first suspension comprising a membrane fraction, comprising the membrane protein, in the presence of a detergent;
- centrifuging the sonicated first suspension to form a first pellet comprising the membrane protein;
- disposing of the supernatant;
- re-suspending the first pellet to form a second suspension;
- centrifuging the second suspension to form a second pellet comprising the membrane protein;
- re-suspending the second pellet to form a third suspension comprising the membrane protein; and
- dropping the third suspension into a hydrophobic medium to form the aqueous droplet.

The invention also provides a method for making the array of the present invention, comprising molding the scaffold and assembling the array.

The invention also provides use of the array of the present invention for testing the activity or function of a protein.

The invention also provides use of the array of the present invention for stimulating a voltage-sensitive membrane protein.

The invention also provides a method of generating an electrical signal, comprising exposing electromagnetic radiation, such as light, to the array of the present invention.

The disclosure also describes an aqueous droplet comprising from 1800 µg mL⁻¹ to 2200 µg mL⁻¹ of protein.

The disclosure also describes an aqueous droplet made according to the method of preparing the aqueous droplet of the invention.

### DESCRIPTION OF THE FIGURES

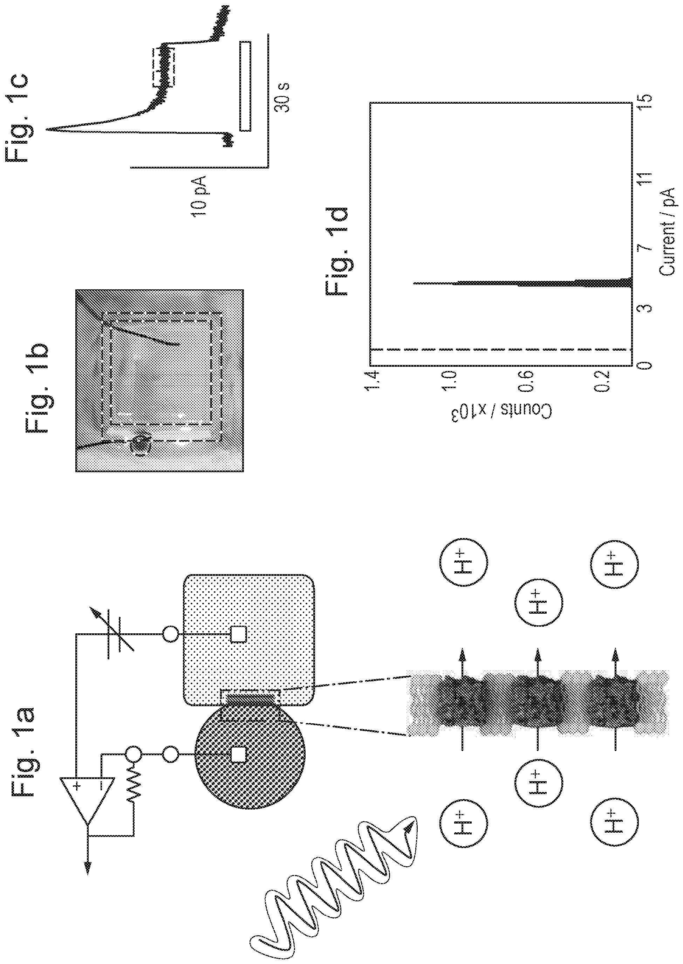

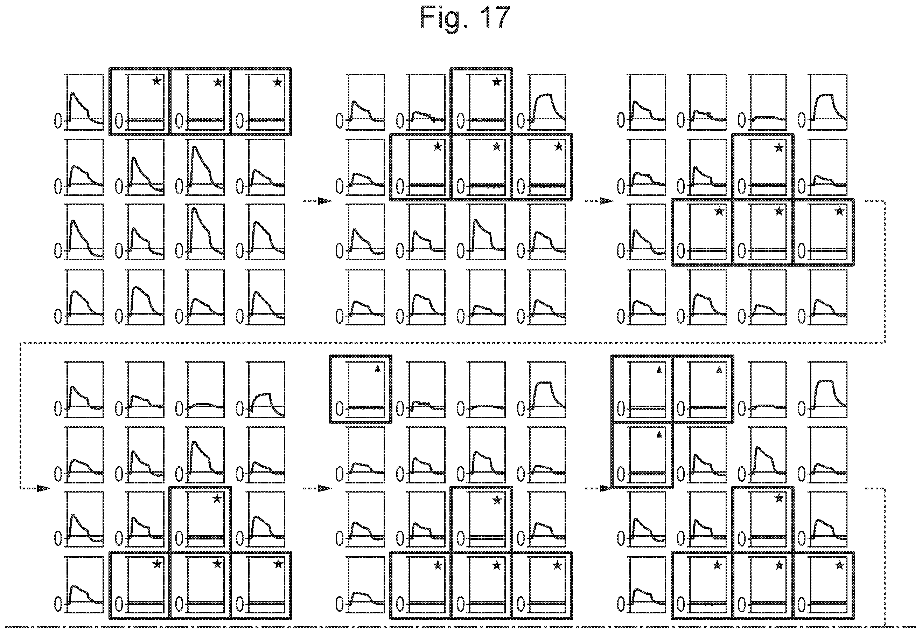

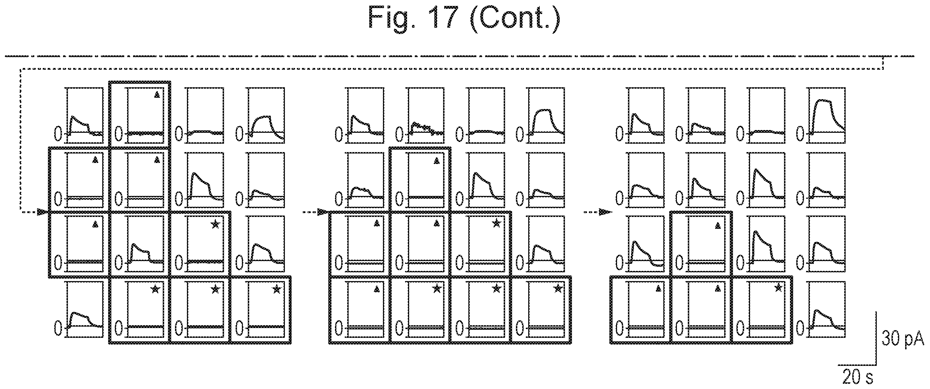

Figure 1 A light-sensing droplet hydrogel bilayer pixel.
   a, Schematic of a light-sensing droplet hydrogel bilayer (DHB) bio-pixel. In a lipid-in-oil solution, a bR-containing droplet (dark grey circle) forms a bilayer with a hydrogel cube (light grey). The bR proteins insert vectorially into the bilayer and pump protons across the membrane upon illumination with green light. The current across the membrane is measured with Ag/AgCl electrodes inserted in the droplet and the hydrogel. b, Image of a bio-pixel according to the design in (a). c, Ionic current activation occurs only upon illumination. The dashed grey box indicates the steady-state current. d, All points histogram of the steady-state current from (c). A bio-pixel is considered ON when the current is above a 1 pA cutoff (vertical dashed grey line).

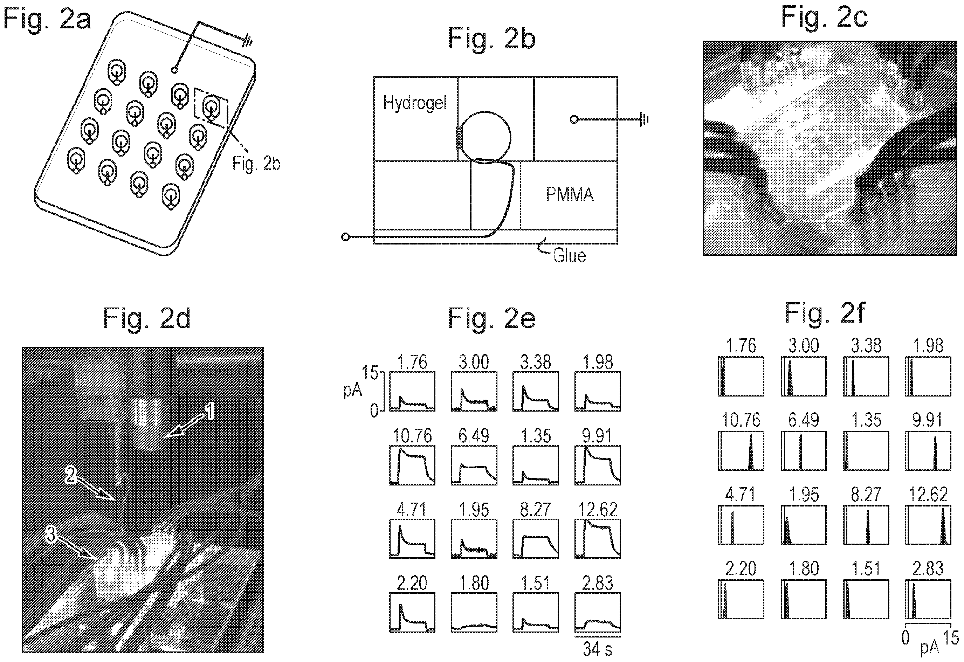

Figure 2 A light-sensing 4x4 synbio retina.
   a, Schematic of a 4x4 synbio retina. Sixteen bR droplets are patterned onto a hydrogel structure formed from agarose, in a 4x4 array. Each droplet and the hydrogel are connected to an external circuit with Ag/AgCl electrodes, b, Cross section of a single DHB bio-pixel from (a). A ground electrode is embedded in the hydrogel, while a recording electrode is inserted into the bR droplet. Each recording electrode is located within a cavity, such that it does not make contact with the hydrogel. c, Image of the 4x4 synbio retina according to the design in (a and b). d, Illumination of the synbio retina from above. (1) A fiber-coupled LED (560 nm) illuminates the synbio retina. (2) The common ground electrode enters from above and inserts into the hydrogel. (3) Connections from the synbio retina to a multichannel amplifier, e, Simultaneous current traces recorded from each bio-pixel of an illuminated 4x4 synbio retina, with the steady-state mean current values displayed at the top of each trace, f, Distribution of the steady-state current measurements from each pixel of a fully illuminated synbio retina (vertical white line represents the 1 pA cut-off, data below 1 pA is shown in a light grey box). All the bio-pixels are simultaneously detecting light, and generating a current above the cut-off.

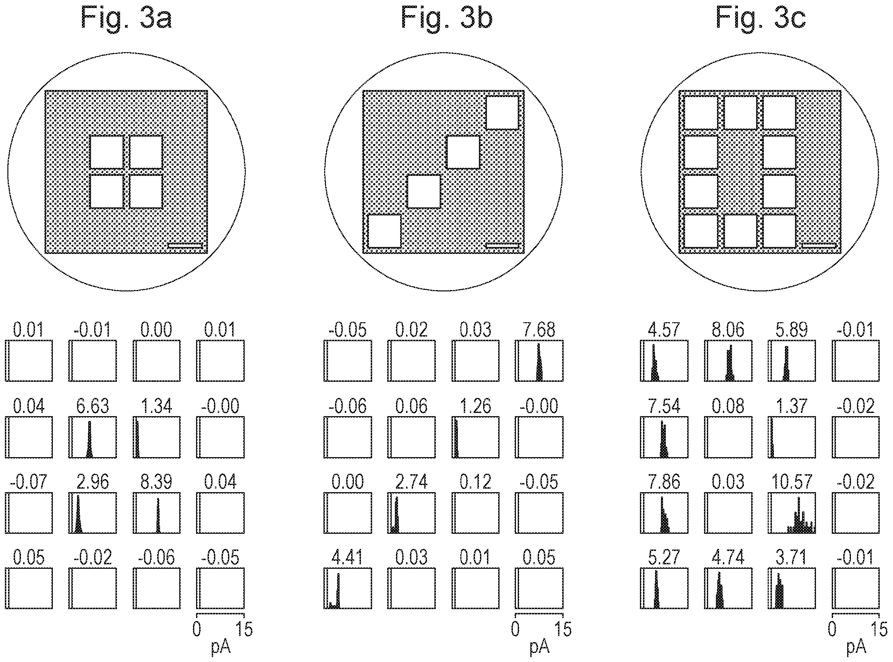

Figure 3 Static shape recognition with the synbio retina.
   a, A photomask of a 2x2 square shape was printed on a transparency foil and placed on top of the synbio retina. The square image is identified by the synbio retina when it is illuminated through the square photomask. Mean steady-state bio-pixel currents above the 1 pA threshold reveal the location of the square image. Bio-pixels above the cut-off are shown with a dark grey background and those below it have a light grey background. b, Recognition of a diagonal line. c, Recognition of the letter O. Scale bars represent 2 mm.

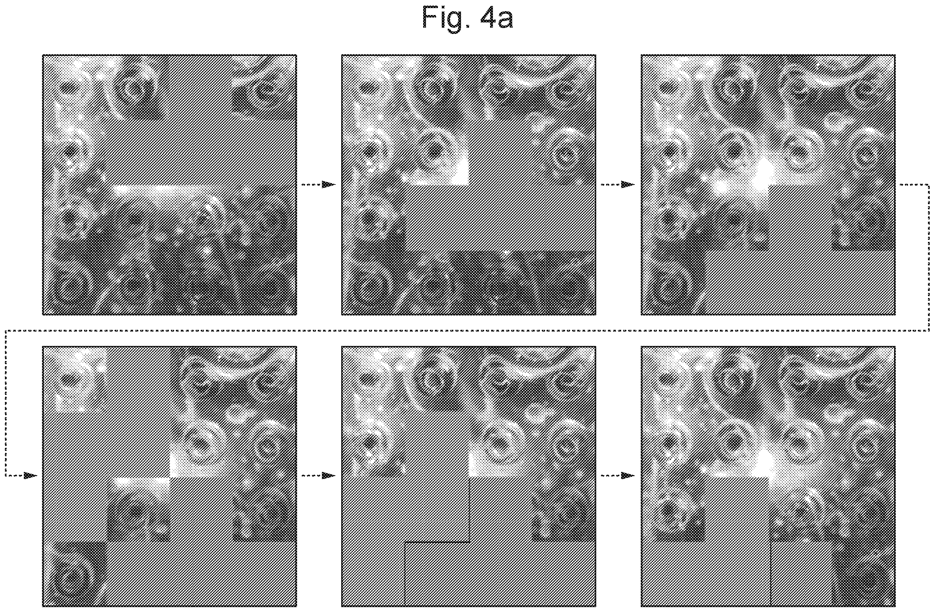

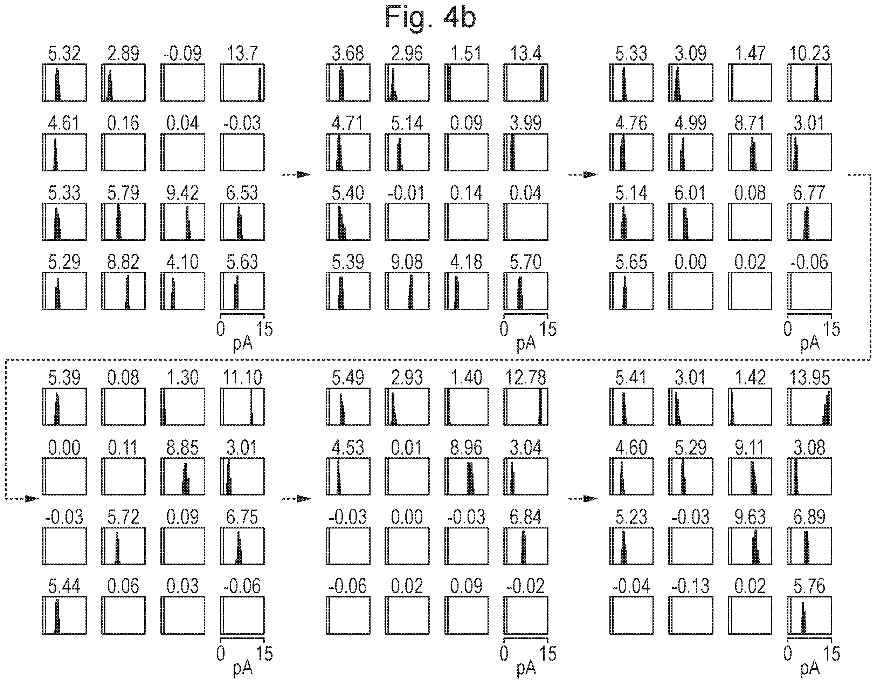

Figure 4 Detecting moving images with the synbio retina.
   a, Illustration showing two Tetris-based shapes moving down the face of the synbio retina one pixel at a time. When the bottom row is completed, both the Tetris blocks are moved down together by one pixel. b, The shapes are revealed by the absence of current in the occluded bio-pixels (light grey). Selected frames are shown here (all frames are shown in Figure 17).

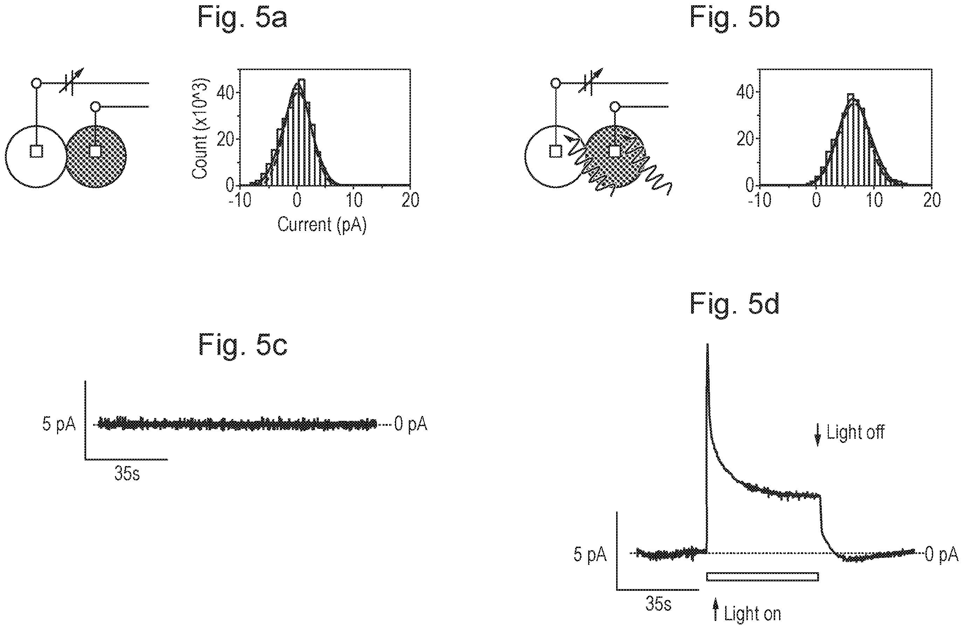

Figure 5 A DIB bio-pixel generates a current under illumination.
   a, Schematic of a droplet-interface-bilayer (DIB) pixel. A DIB is formed from a buffer (white) and bR (dark grey) droplet, each connected to an electrode. The ground electrode was inserted in the buffer droplet. A histogram illustrates the baseline noise centered about 0 pA. b, The bio-pixel was illuminated and a ~5 pA increase in the steady-state current was observed. c, Filtered (10 kHz low pass filter) current trace of a DIB bio-pixel without illumination. d, Filtered current trace of an illuminated DIB bio-pixel illustrates the bR current waveform. Five different datasets are plotted on the histograms shown in (a) and (b), and Gaussian fits (black lines) are shown for each.

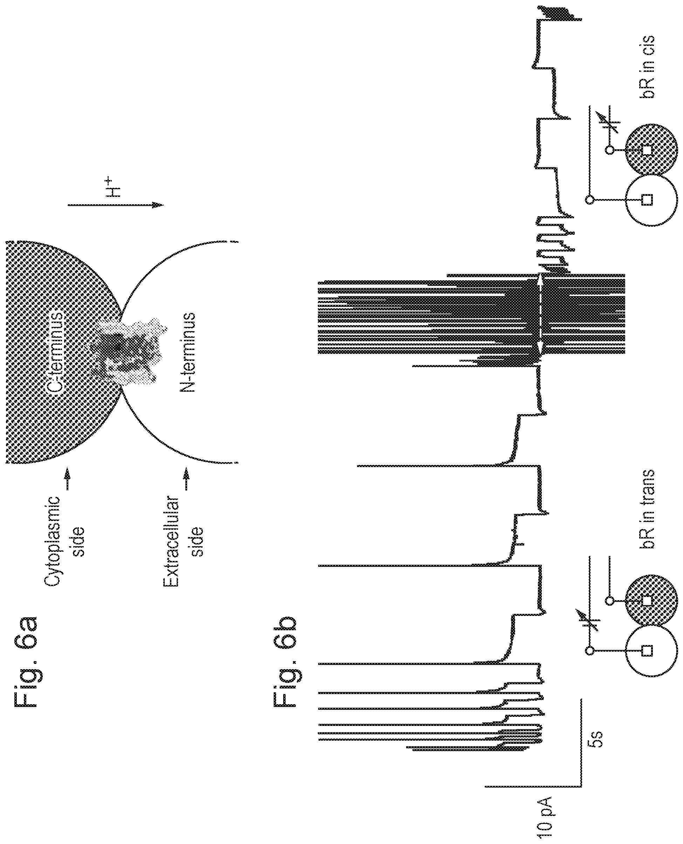

Figure 6 The majority of bR protein inserts N-terminus first
   a, Schematic of the insertion of bR in a DIB. Proton movement in bR is from the C-terminal side to the N-terminal side. In *H. salinarum*, the C-terminus of bR is in the cytoplasm and protons are pumped out of the cell. b, Current trace of bR pumping activity during sequential light pulses. The recording electrode (trans) is in the droplet-containing bR (dark grey), while the ground electrode (cis) is in the buffer-containing droplet (white). A positive current was recorded, with the protons moving to the buffer droplet. The configuration of the electrodes was then reversed (white dashed line) and a negative current was generated upon illumination. This indicates that the C-terminus of the bR must be in the bR droplet and the N-terminus in the buffer droplet.

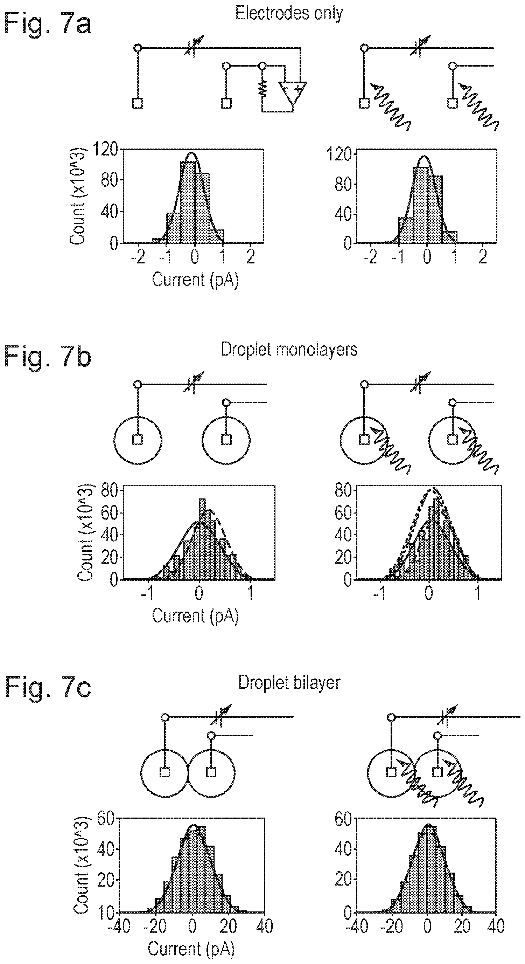

Figure 7 No current is observed from an illuminated DIB bio-pixel without bR.
   **a**, Bare Ag/AgCl electrodes were placed in 1:1 hexadecane:silicone oil containing DPhPC in the Faraday cage. The current output was measured with and without LED illumination (560 nm) and the baseline remained at 0 pA, indicating that the illumination had no measureable effect on the electrodes, **b**, Single Buffer A droplets were placed on each electrode. Illumination was performed as in (a) and the baseline remained at 0 pA. **c**, The two droplets were brought into contact and a bilayer was formed. The baseline noise increased as a result. Illumination was performed as in (a) and the baseline remained at 0 pA. Five different datasets are plotted on the histograms shown in (a), (b) and (c), and Gaussian fits are shown for each. The results indicate that illumination has no measurable effect on the current output of a bio-pixel in the absence of bR.

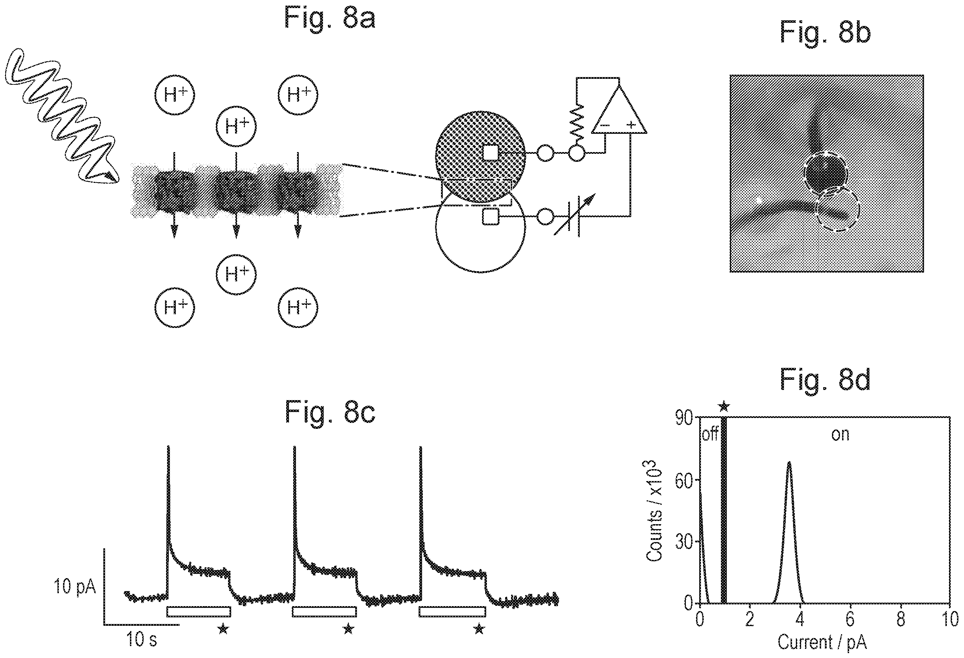

Figure 8 A light-sensing 4x4 DIB array
   **a**, Schematic of a DIB bio-pixel. Green light activates vectorial H⁺ pumping by bR generating a current across the membrane, which is measured through electrodes inserted into each droplet. **b**, Image of a bio-pixel according to the schematic in (a). **c**, Ionic current is generated only upon illumination (grey bars, each marked with a star). **d**, Gaussian fits of the OFF (light grey) and ON (dark grey) steady-state currents from (c). A pixel is considered ON when the steady-state current is above the cut-off of 1 pA (vertical grey line, marked with a star). **e**, bR droplets were patterned onto a 4x4 array of recording electrodes, while a single buffer droplet was suspended on a moving agarose-coated electrode. The moving droplet was guided through the array, forming a DIB pixel with each bR droplet in turn. **f**, Schematic of a 4x4 synbio retina, with a 3x3 section illuminated from above. **g**, The fiber-coupled LED (560 nm) was held perpendicular to the array. **h**, Identification of the illuminated DIB pixels from steady-state current distributions. When the steady state current is above the 1 pA cut-off (white line), the pixel is dark grey; and when below the cut-off, it is light grey. **i**, An image of the 4x4 light-sensing DIB array showing (1) the moving electrode and (2) a bR droplet.

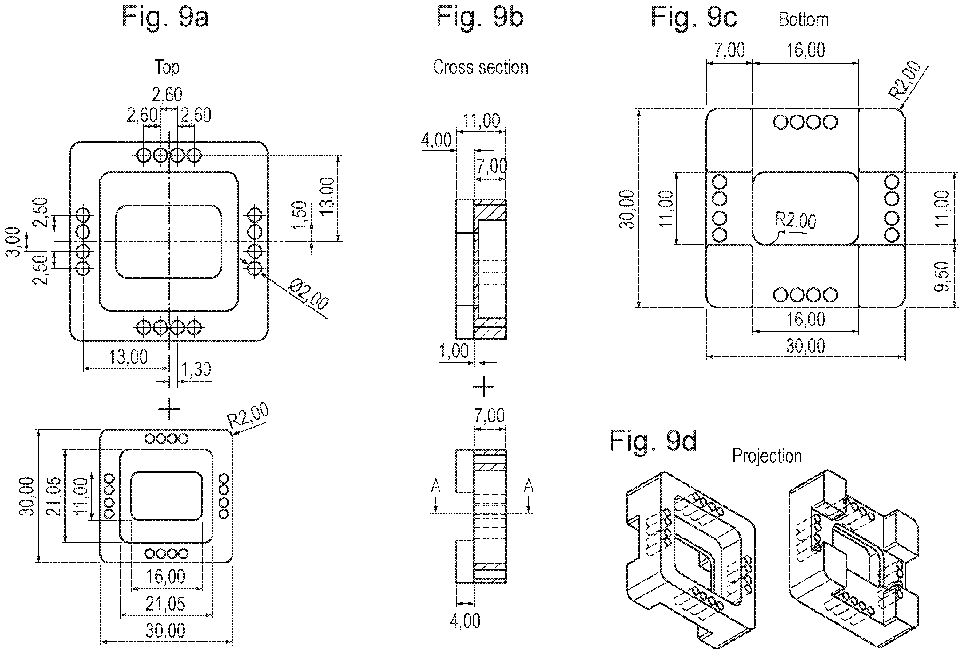

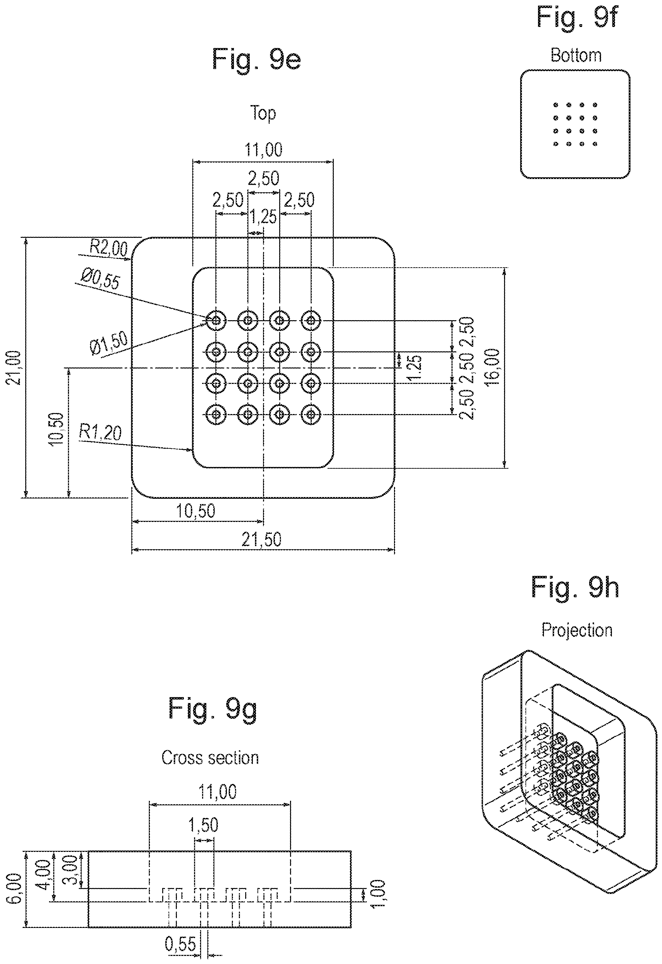

Figure 9 Parts of the 4x4 PMMA device
   **a**, Schematic top-view of part 1 of the PMMA device. It has four equally spaced holes on each of its sides and a central cavity with a rectangular cut-through, **b**, Schematic cross-sections of part 1, showing the internal cavity and the holes on each side. **c**, Schematic bottom-view of part 1 with four rectangular feet at the edges, **d**, Schematic projection-view of part 1 displaying the holes on each side, the internal cavity, the cut-through, and the feet. **e**, Schematic top-view of part 2 of the PMMA device. In the center there is a rectangular cavity with a 4x4 array of equally spaced hole-containing pillars, **f**, Schematic bottom-view of the part 2 exposing the 4x4 array of holes. **g**, Schematic cross-section of part 2, showing the rectangular cavity, the pillars and holes. **h**, Schematic projection-view of part 2.

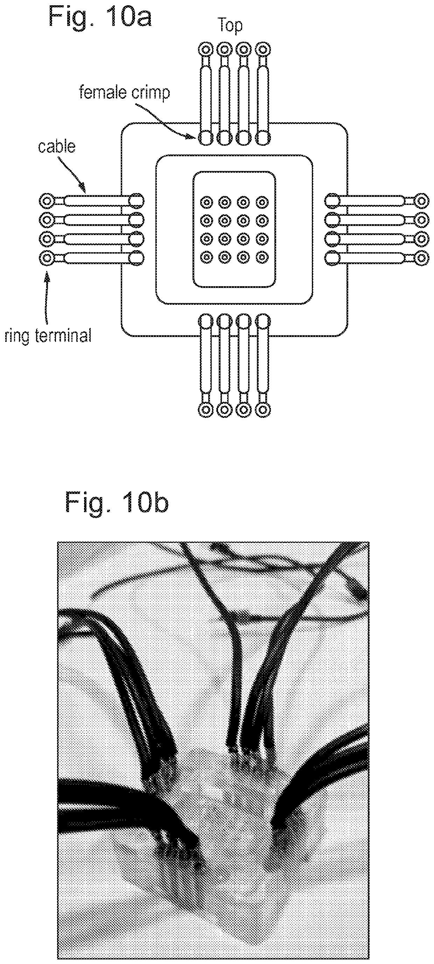

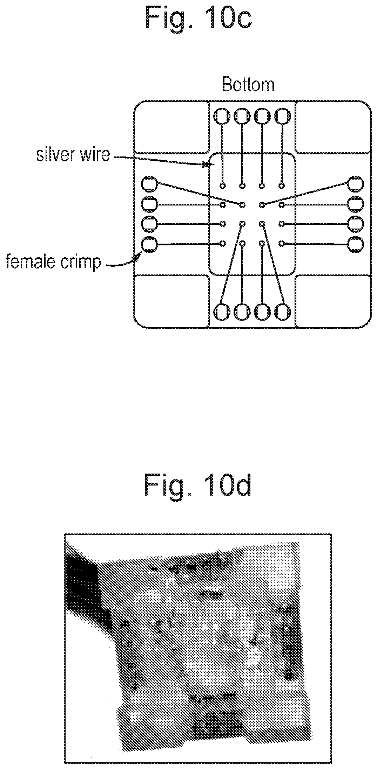

Figure 10 The 4x4 PMMA device with its electrical wiring
   **a**, Schematic top-view of the PMMA device formed from the assembly of part 1 and 2. A gold-plated female crimp is glued into all 16 outside holes of part 1, to allow cables with ring terminals to interface the PMMA device to the multichannel amplifier. **b**, Image (projection-view from the top) of the PMMA device. **c**, Schematic bottom-view of the PMMA device. The gold-plated crimps inserted in part 1 are soldered to separate silver wires that enter the 16 holes of part 2 and are glued in place, **d**, Image (projection-view from the bottom) of the PMMA device.

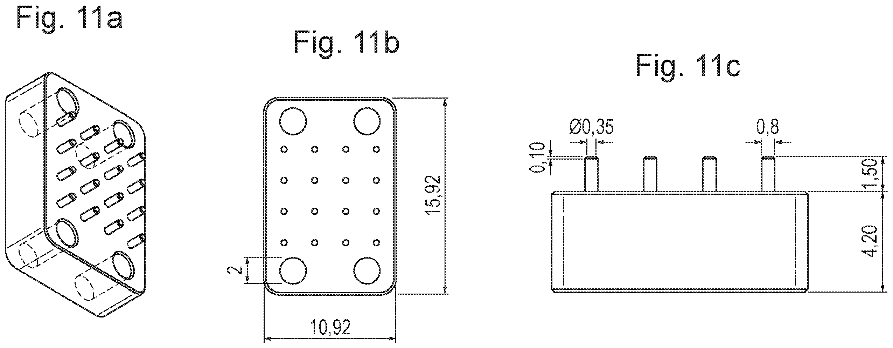

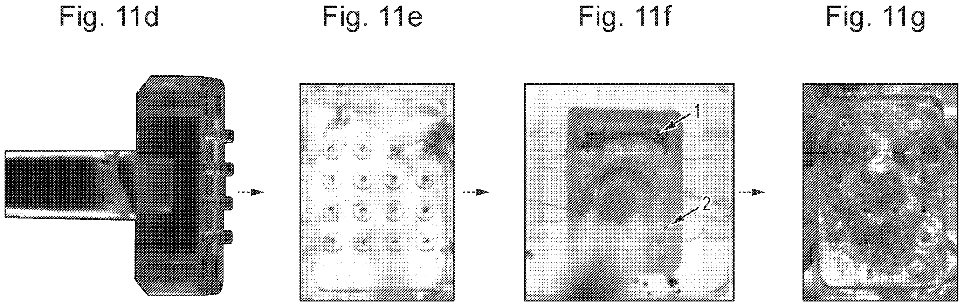

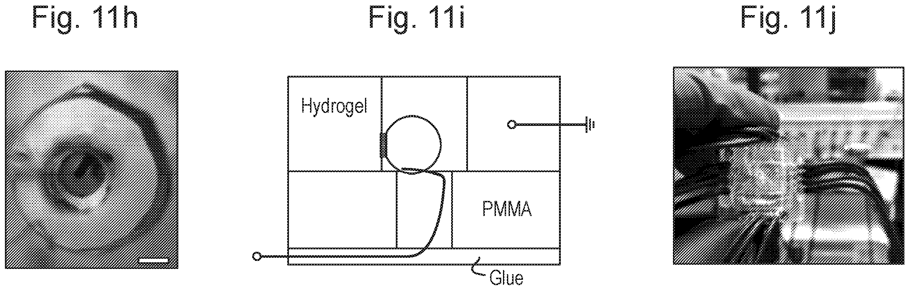

Figure 11 Formation of the synbio hydrogel retina
   **a**, Projection-view of the lid made of PMMA with pillars that aligns with the wells of the PMMA device. **b**, Top-view of the lid. **c**, Side-view of the lid. **d**, Image of the lid made of PMMA with holder glued to its back. **e**, PMMA device with electrodes present in each of the 16 wells, **f**, The lid fits inside the PMMA device and melted agarose can be added through the opening (1). A hydrogel-free cavity is formed above each of the 16 wells in the PMMA device (2). **g**, When the lid is removed an agarose hydrogel structure with sixteen cavities for bio-pixels is formated. **h**, A hydrogel bio-pixel cavity, with an electrode in the middle of the well. Scale bar: 330 µm. **i**, Schematic cross-section of bio-pixel formation in the hydrogel cavity, **j**, The synbio retina outside the Faraday cage.

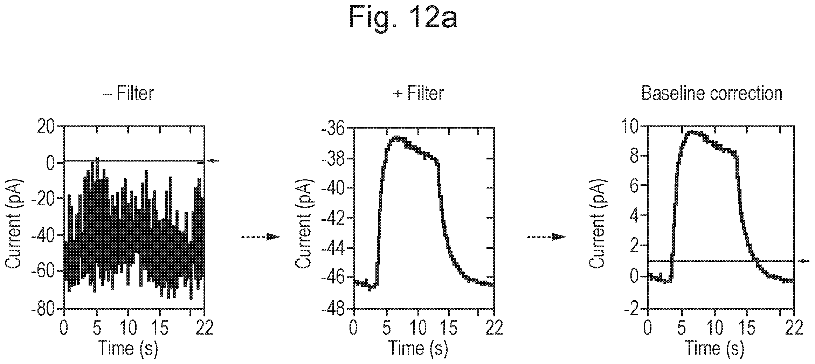

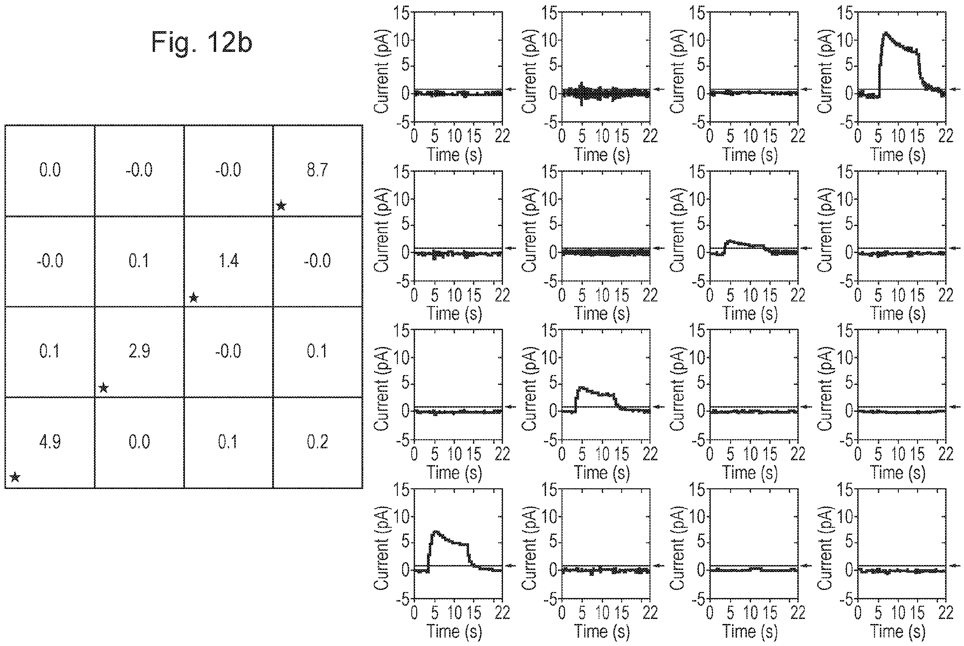

Figure 12 Electrical recording analysis and visualization software
   **a**, The custom software reads a raw current trace, applies an additional filter and corrects the baseline. The grey line (marked with an arrow) is the 1 pA cut-off. Baseline correction is required as the multichannel amplified does not balance the electrodes, **b**, The current at any time point is shown on a visualiser (left), which has a grey background and is marked with a star if the current goes above the cut-off. The current is also plotted against time (right) to show the current waveform for each bio-pixel.

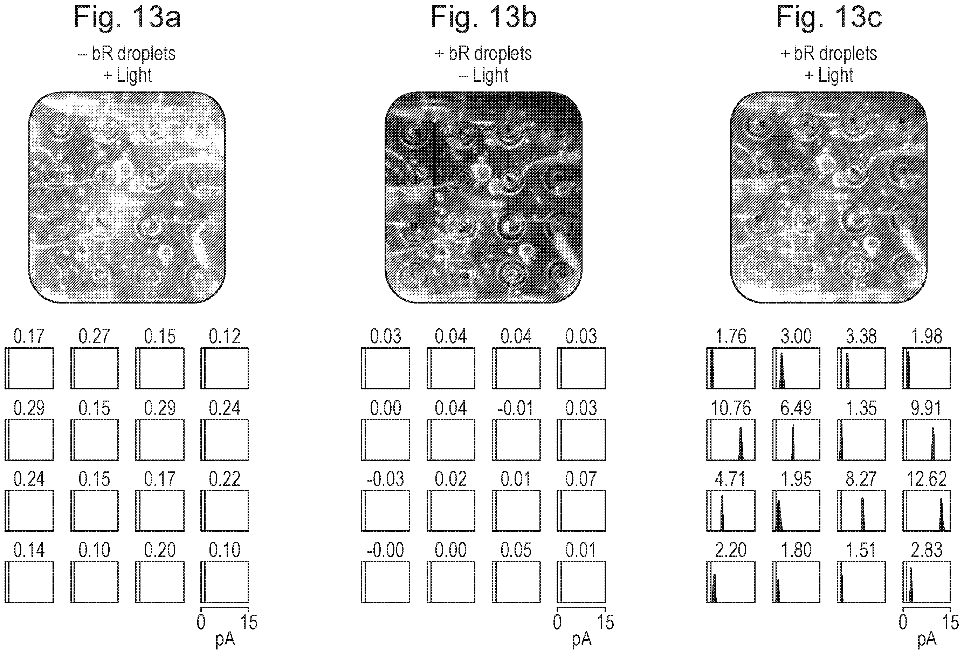

Figure 13 The 4x4 synbio retina only detects light when bR droplets are included
   **a**, The hydrogel was formed with the hollow cavities but without any bR droplets. Upon illumination, no current was detected from any electrodes, **b**, When bR droplets were included, no current was detected in the dark. **c**, When bR droplets were included and the device was illuminated all 16 bio-pixels detected the light.

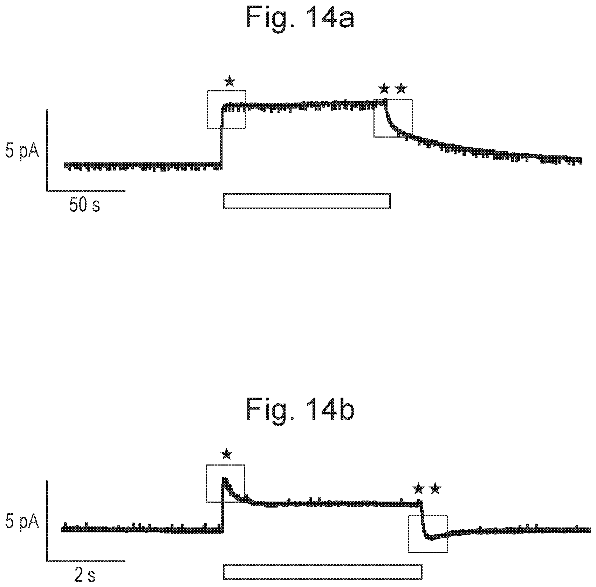

Figure 14 Capacitance modulates the current-profile of bR in DIBs
   Two examples of how the bR current profile is modulated by bilayer capacitance. A large bilayer area results in a high capacitance and a small bilayer area in a low capacitance. **a**, A capacitance of ~800 pF generated undershoot signals when the protein was turned ON (box marked with one star) and OFF (box marked with two stars). Observed as the transitional current not exceeding the steady state (box marked with one star) or the baseline (box marked with two stars) current. **b**, A capacitance of ~30 pF generated overshoot signals when the protein was turned ON (box marked with one star) and OFF (box marked with two stars). Observed as the transitional current exceeding the steady state (box marked with one star) and the baseline (box marked with two stars) current.
Figure 15 Photomasks printed in transparency foil
   **a**, Image of the photomasks used for static shape detection, **b**, Image of the Tetris-based photomasks used for moving shape detection, **c**, An image of a photomask on top of the PMMA device.
Figure 16 Static shape recognition with the synbio retina
   **a**, Current traces from the synbio retina in the dark. No currents are detected above the 1 pA cut-off (light grey line marked with an arrow). **b**, The whole synbio retina was illuminated and a current waveform was detected in every bio-pixel. A thickened border and star is present over each pixel where current is observed. **c**, The synbio retina was illuminated through a photomask with a diagonal line. Current waveforms are detected in bio-pixels that correspond to the pattern of illumination. **d**, Current waveforms generated with a photomask of the letter O. **e**, Current waveforms generated with a large triangular photomask. **f**, Current waveforms generated with a small triangular photomask.
Figure 17 Detecting moving images with the synbio retina
   Current responses of the bio-pixels as Tetris-based shapes are manually moved down the face of the device. Each bio-pixel shows a current waveform when illuminated, apart from those that are blocked by the shapes. A black border surrounds each bio-pixel in which the current does not cross the 1 pA cut-off. The first Tetris shape is given a star in each bio-pixel and the second shape is given a triangle in each bio-pixel.

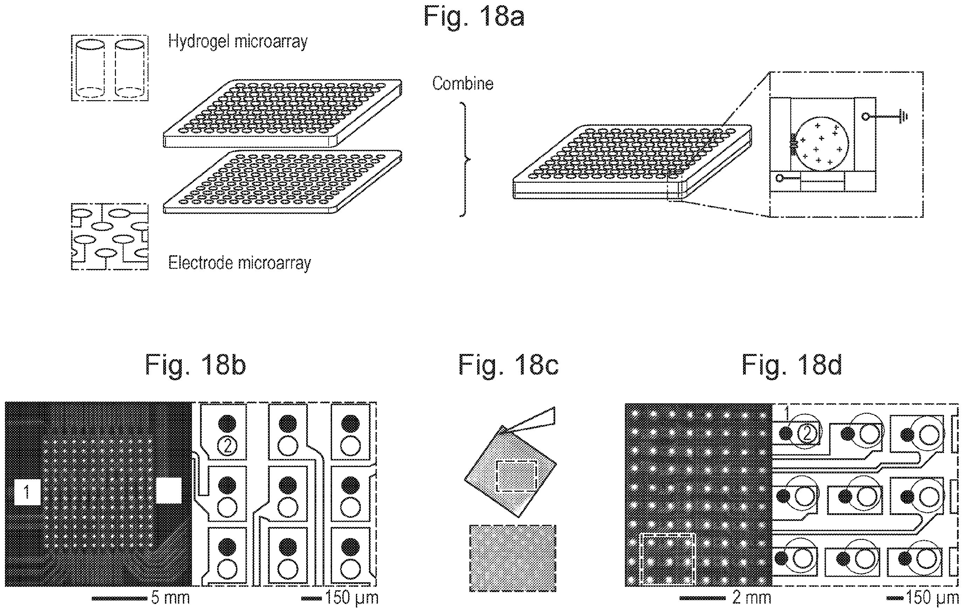

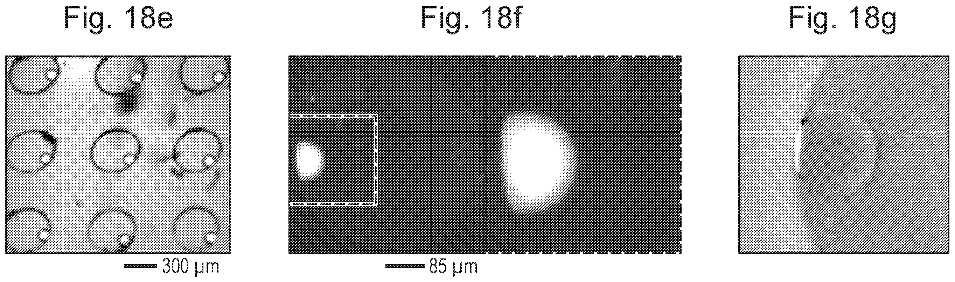

Figure 18 Formation of a 12 × 12 synbio retina
   (A) Schematic of a 12 × 12 synbio retina. One hundred and forty-four droplets were patterned within a hydrogel microarray structure. Each droplet and the hydrogel were connected to an external circuit with an Ag/AgCl electrode microarray patterned on a circuit board. (B) Image of the 12 × 12 electrode microarray (1. ground electrode, 2. recording electrode), according to the design in (a). (C) Image of the 12 × 12 hydrogel microarray according to the design in (a). (D) Image of the combined hydrogel microarray with the electrode microarray, according to the design in (a). (E) Image of the droplets forming droplet hydrogel bilayers with the 12 × 12 hydrogel microarray, according to the design in (a). (F) Image of a single droplet hydrogel bilayer, demonstrated by the retaining of the internal contents. (G) Image of a single droplet hydrogel bilayer, demonstrated by the labelling of the lipid bilayer.

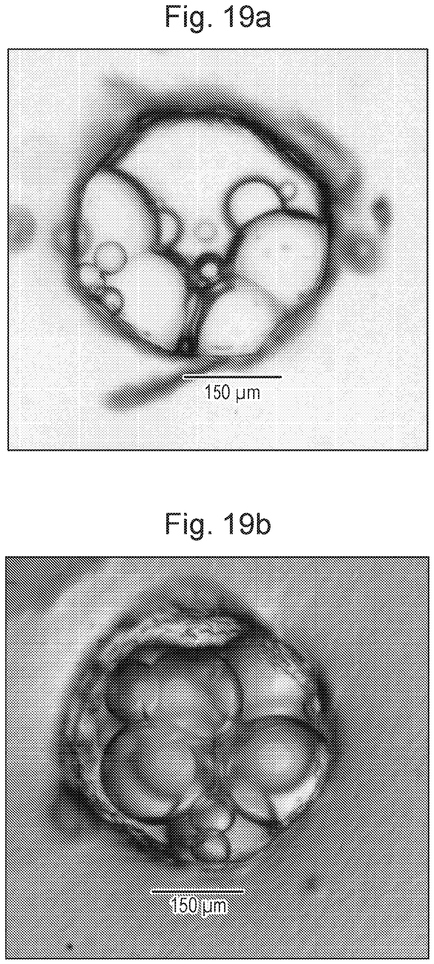

Figure 19 Formation of droplet networks inside of a hydrogel microcavity
   (A) Image of a single hydrogel microcavity (e.g. cavity in the scaffold, where the scaffold is also the second aqueous object) where multiple droplets (aqueous objects, e.g. first aqueous object and further aqueous objects) form bilayers with the hydrogel surface. Such a system allows a larger bilayer area for protein insertion. (B) Image of a single hydrogel microcavity where multiple droplets form bilayers with the hydrogel surface and/or with each other. Such a system allows the complex patterning of a tissue-like construct.

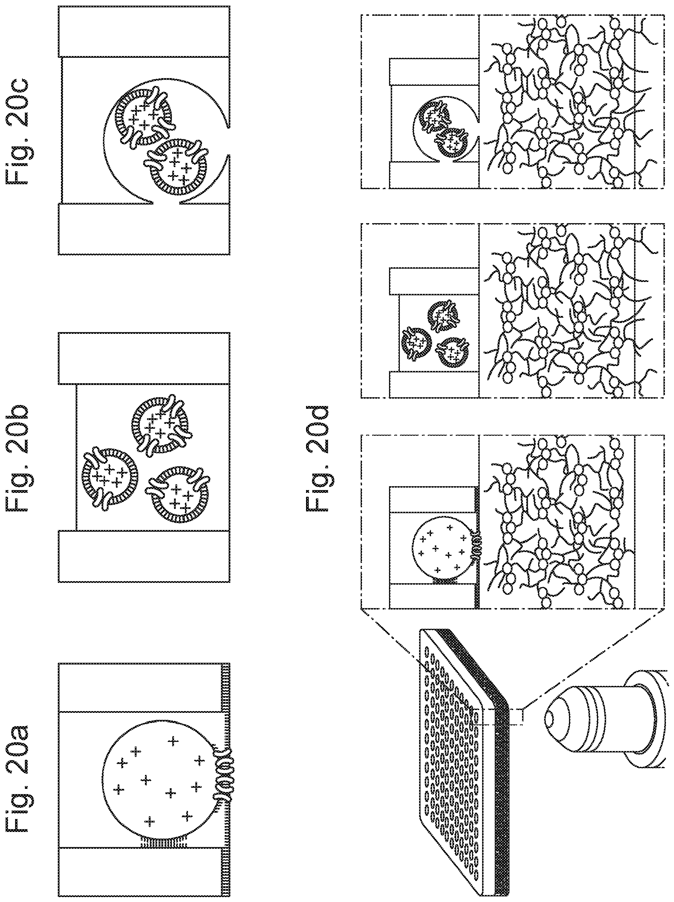

Figure 20 Some exemplary alternative embodiments for the formation of aqueous object(s) inside of the hydrogel microcavity, and interfacing with living cells
   (A) Schematic of a single droplet forming a bilayer with the hydrogel surface. (B) Schematic of a single and continuous aqueous object inside the hydrogel microcavity. (C) Schematic of a single droplet selectively fused with the hydrogel surface. (D) Schematic of each of (A), (B) and (C) interfaced with living cells.

### DETAILED DESCRIPTION OF THE INVENTION

It is to be understood that different applications of the disclosed products and methods may be tailored to the specific needs in the art. It is also to be understood that the terminology used herein is for the purpose of describing particular embodiments of the invention only, and is not intended to be limiting. The scope of the invention is defined by the appended claims.

In addition as used in this specification and the appended claims, the singular forms "a", "an", and "the" include plural referents unless the content clearly dictates otherwise. Thus, for example, reference to "an object" includes two or more instances or versions of such objects, or reference to "a phospholipid" includes two or more such phospholipids, or reference to "a communication means" includes two or more such communication means and the like.

Any numerical parameters as defined herein may be expressed as approximate numerical values, wherein the said numerical value may be plus or minus 10% of the said numerical value unless the context clearly dictates otherwise.

The present invention provides an array for passing an electrical current between a first aqueous object and a second aqueous object, and has the following features:
a) the array comprises a scaffold, two or more of the first aqueous objects and at least one of the second aqueous objects;
b) said first aqueous objects of (a) each comprise amphipathic molecules on at least part of the surface of the first aqueous objects;
c) said second aqueous objects of (a) each comprise amphipathic molecules on at least part of the surface of the second aqueous objects;
d) said first aqueous objects of (b) each form an interface with the second aqueous object of (c), wherein the second aqueous object is:
   (i) a single common second aqueous object, or
   (ii) a different individual second aqueous object;
e) said interface of (d) comprises a bilayer of said amphipathic molecules of (b) and (c); and
f) the scaffold isolates said first aqueous objects of (b) from each other.

The electrical current may be in the form of an ion flux, preferably, a flux of protons. The flux may be of chloride ions, sodium ions, calcium ions or potassium ions. The array is suitable for passing a current and/or generating a voltage between the first aqueous object and the second aqueous object. A protein (such as the light-sensitive membrane proteins described herein) is preferably dispersed in the bilayer which actively or passively allows the ion flux.

The array may be in contact with a first communication means as defined herein. The array may be in contact with a second communication means as defined herein. The array may be in contact with the first and the second communication means. The contact is preferably electrical. The contact may be physical. The contact may be electrical and physical. The array may comprise the first communication means. The array may comprise the second communication means. The array may comprise the first and the second communication means.

The array may be any shape. The array may be any regular or irregular shape, or any polygon. When the array is a polygon, it may be convex or non-convex.

Usually the array is a three-dimensional shape. It may thus be any three-dimensional shape. As the skilled person will appreciate, a three-dimensional shape may have three dimensions that are all the same order of magnitude, it may have one dimension that is at least an order of magnitude larger or smaller than the other two dimensions, or all three dimensions of the shape may be of different orders of magnitude.

The array shape may, for instance, be spherical or a shape comprising two or more sides. The array shape may comprise from 1 to 50 sides, for instance from 1 to 15 sides. The array shape may, for example, be a 2-sided shape such as a hemisphere; a 3-sided shape such as a cylinder, a bended cylinder; a 5-sided shape such as a triangular prism; a 6-sided shape such as a cuboid; or a 14-sided shape such as a cross-shape.

The array may be spherical, cross-shaped, cuboid, crescent-shaped, prism-shaped, cylindrical, wire-shaped or a shape which has a triangular, pentagonal, hexagonal, heptagonal, octagonal, nonagonal, decagonal, undecagonal, dodecagonal, square or rectangular face. Typically the array is cuboid with a square or rectangular face.

The array may have a planar or substantially planar arrangement. The components of the array may be situated on different planes.

The array and scaffold as defined herein are preferably planar in arrangement. The array preferably has equal numbers of first aqueous objects and cavities as defined herein. The array preferably has equal numbers of first aqueous objects, first communication means and cavities as defined herein. Preferably the first aqueous objects are aqueous droplets as defined herein. In some embodiments, each cavity in the scaffold preferably comprises a single one of the droplets. The cavity may be referred to as a microcavity. Each cavity is preferably placed over one first communication means so that each cavity is placed over a different first communication means. Thus the layout of the cavities is preferably in line with the layout of the first communication means. Preferably each droplet is in electrical contact with a different first communication means. The scaffold as defined herein is preferably the single common second aqueous object as defined herein and is preferably in electrical contact with the single common second communication means as defined herein. The scaffold preferably comprises a hydrogel object. Preferably there is a protein dispersed in the bilayer. The protein may be any protein described herein such as a light-sensitive membrane protein. In some embodiments, the array preferably has the following features:
a) the scaffold is the single common second aqueous object;
b) the scaffold comprises a hydrogel object and two or more cavities;
c) the cavities of (b) traverse the scaffold;
d) the scaffold is located on a surface comprising two or more first communication means;
e) the scaffold is in electrical contact with the single common second communication means;
f) the cavities of (b) are situated over the first communication means of (d);
g) each cavity of (b) is situated over a different individual one of the first communication means of (d);
h) each cavity of (b) contains a different individual one of the first aqueous objects;
i) each first aqueous object of (h) forms a different interface with the scaffold; and
j) each first aqueous object of (h) is in electrical contact with the first communication means of (g) which the said cavity is situated over.

The first communication means preferably each comprise a different first electrode and the single common second communication means preferably comprises a second electrode. The scaffold is preferably in physical contact with the single common second communication means and each first aqueous object is preferably in physical contact with the different individual first communication means which the cavity is situated over.

The assembly or production of the array may be controlled by any suitable methods.

The invention also provides methods and uses of the array. The invention provides a method for detecting electromagnetic radiation, such as light, comprising exposing electromagnetic radiation, such as light, to the array and measuring the ion flux generated as an electrical current. The electrical current can be measured as described herein. The terms 'current', `electrical current' and `current flow' are used interchangeably herein. Electromagnetic radiation, such as light, may be exposed to the array by any suitable method, such as any of those described herein.

Each first aqueous object can form a 'bio-pixel' which can detect electromagnetic radiation, such as light. Thus the electrical outputs from each first aqueous object can be combined to form images.

The array can generate electrical signals following an electromagnetic radiation, e.g. light, stimulus or exposure to electromagnetic radiation, e.g. light. The electrical signals (e.g. current flow) can be measured, for example as described herein. The array may be used for generating current and/or voltage, via an ion flux, following the stimulus (e.g. by exposure to light). By detecting electromagnetic radiation (e.g. light) and consequently generating ion flux, the array can generate electrical signals. These signals can be used to generate images or to provide a power source. The array may be used as a switch, sensor (e.g. light sensor) or power source. The array may be interfaced with living tissues or used to power or control synthetic tissues.

The current output from each first aqueous object can be individually and simultaneously measured, as described herein. A plurality of first aqueous objects (e.g. bio-pixels) can generate a pattern of currents, which may be used to generate images or to power or control (all or selected regions of) synthetic tissues. The array may be used to interface with living tissue. The array may be used to power or control physiological processes.

The array may be bio-compatible. A bio-compatible array can be used *in vivo.* For example, the array may be used as an implantable device, such as a synthetic retina or a device to power tissues. The implantable device may be useful for generating current and/or voltage, via an ion flux, following a light stimulus (e.g. by exposure to light). By detecting light and consequently generating ion flux, the array can generate electrical signals. These signals can be used to generate images. For example, the array can be used as a light sensor, synthetic retina or soft biological camera.

The electrical signals may be used to stimulate a cell such as those described herein. The cell may be a biological cell, a protocell or a synthetic cell. The second aqueous object or objects may be in contact, electrically or physically, with one or more cells, or may comprise one or more cells. One or more cells may be disposed in the second aqueous object or objects. In such embodiments, there may not be an interface formed between the scaffold and the first aqueous objects. Preferably, the second aqueous object(s) comprise hydrogel. The second aqueous object(s) may further comprise one or more stabilising agents as described herein. The second aqueous object(s) may further comprise an extracellular matrix protein as described herein. The second aqueous object(s) may further comprise culture medium as described herein. The cell(s) may comprise voltage-sensitive proteins as described herein, such as channels, pumps and/or pores. Stimulation may be achieved by an ion flux between the first aqueous object and second aqueous object. The ion flux may stimulate the membrane of the cells. The ion flux may stimulate the voltage-sensitive proteins in the cells. The cell may then in turn stimulate or power a tissue. The cell may be a neural cell. Therefore the cell, such as a neural cell, may be used to stimulate or power a tissue. Thus the array can be used to control a biological or synthetic tissue. The array may be in physical and/or electrical contact with a droplet assembly as described herein. The array may further comprise a droplet assembly as described herein. The droplet assembly may comprise the different individual second aqueous objects or the single common second aqueous object. The droplet assembly may comprise a plurality of second aqueous objections comprising cells. Alternatively, the droplet assembly may comprise the single common second aqueous object comprising cells. In such embodiments, the single common second aqueous object may not be the scaffold. Thus the array may have the following features:
a) the second aqueous object is the single common second aqueous object;
b) each of the first aqueous objects form an interface with the single common second aqueous object;
c) the droplet assembly comprises the single common second aqueous object; and
d) the scaffold is not the single common second aqueous object.

The array may be used to test the function or activity of a protein such as those described herein. As described herein, the protein (e.g. membrane protein) may be present at the interface(s) between the first and second aqueous objects. The protein may be dispersed in the bilayer. The function or activity of the protein can be tested by administering electromagnetic radiation (e.g. light) or providing an electromagnetic stimulus (e.g. by exposure to light) to the first aqueous objects and measuring the current output from the first aqueous objects. The current output from each first aqueous object can be individually and simultaneously measured, as described herein, so that multiple proteins can be tested simultaneously.

Any membrane protein can be tested. For example, the protein may be a light-sensitive ion channel, a light-sensitive ion pump, a light-sensitive protein pore, a light-sensitive receptor protein, and/ or light-sensitive transporter protein. Being light-sensitive, the application of light may stop or start an ion flux across the membrane or interface in which the membrane protein resides. For example, the application of light may cause a light-sensitive channel to open or close, a light-sensitive pore to open or close, or a light-sensitive pump to start or stop pumping (e.g. ions), or a light-sensitive transported to start to stop transporting (e.g. ions). Such a protein may also be referred to as light-gated or light-driven. The membrane protein may be a light-sensitive ion channel such as a chloride ion channel, sodium ion channel, calcium ion channel or a potassium ion channel. The protein may be a cation channel or an anion channel. The protein may be a light-sensitive proton pump. The protein may be a photoreceptor protein, such as a retinylidene protein, flavoprotein or biliprotein. The protein may be photopsin I, photopsin II, photopsin III or melanopsin. The protein may be a rhopdopsin, bacteriorhodopsin, halorhodopsin, archaerhodopsin or leptosphaeria. The protein may be bacteriorhopsin. The bacteriorhodopsin can be derived from *Halobacterium salinarum.* The protein may be an algal protein. The protein may be a light-gated cation channel, such as Channelrhodopsin-2. The protein may be light-gated proton channel, such as Channelrhodopsin-1. The protein may be the light-driven chloride pump, such as halorhodopsin from the archaebacterium *Natronomas pharaonis.* The protein may be a chromophore. As described herein, when the scaffold can provide predefined positions in the array, this means that the function or activity detected by the array can be more easily assigned to the particular protein being tested. Also, when the array is used, for example, as a power source or switch as described herein, having predefined positions enable more precise application of the power source or switch. There can be more precise control of a synthetic tissue or of physiological processes.

The array may comprise a dye. The dye may be used to detect an electrical current. The ion flux generated in the array can cause the dye to produce a colour, indicating the stimulation of a protein, such as any of those described herein. Thus the production of a colour can indicate stimulation of a protein by light. The dye may be stimulated by an ion, such as any of the ions described herein. Preferably the dye is stimulated by protons or calcium ions. The dye is preferably pyranine (8-hydroxy-1,3,6,-pyrenetrisulfonate; http://www.sigmaaldrich.com/catalog/product/aldrich/h1529?lang=en&region=US). The dye is preferably a green fluorescent indicator that utilizes a fluorescein core, such as Fluo-8 (https://www.aatbio.com/products/21081). The dye may be present in the scaffold. The dye may be present in the second aqueous object(s). The dye may be present in the droplet assembly.

The scaffold isolates two or more of the first aqueous objects from each other. Thus electrical signals or current flow can be detected as described herein between the isolated first aqueous objects and the second aqueous object or objects. This is also referred to herein as detecting electrical signals or current flow from the first aqueous objects. By 'isolates', the first aqueous objects are prevented from forming an interface with each other. By isolating the first aqueous objects, a current can be detected from each first aqueous object. If the first aqueous objects were not isolated from one another, interfaces may be formed between adjacent first aqueous objects. Electrical signals may then be passed between first aqueous objects rather than, or in addition to, electrical signals being passed between the first and second aqueous objects. This may prevent an electrical signal being detected from each first aqueous object.

The scaffold can also provide predefined positions within the array for the first aqueous objects so that an image can be detected or sensed. The image may be static or moving. The scaffold can provide predefined positions for all the first aqueous objects in the array. Previous droplet network printing do not provide pre-defined positions (for example see reference 11). By providing predefined positions, the image can be more easily reconstructed from the outputs (e.g. electrical signals detected) from the first aqueous objects. Also, when the array is used, for example, to test the function or activity of a protein as described herein, having predefined positions means that the function or activity detected by the array can be more easily assigned to the particular protein being tested. Also, when the array is used, for example, as a power source or switch as described herein, having predefined positions enable more precise application of the power source or switch.

The scaffold can isolate the two or more of the first aqueous objects from each other by spatially separating or segregating the two or more of the first aqueous objects from each other. The scaffold may isolate a plurality of first aqueous objects from each other. For example, at least two, three, four, five, six, seven, eight, nine, ten, 11, 12, 13, 14, 15, 16, 17, 18, 19, 20, 21, 22, 23, 24, 25, 26, 27, 28, 29, 30, 31, 32, 33, 34, 35, 36, 37, 38, 39, 40, 41, 42, 43, 44, 45, 46, 47, 48, 49, 50, 51, 52, 53, 54, 55, 56, 57, 58, 59, 60, 61, 62, 63, 64, 65, 66, 67, 68, 69, 70, 71, 72, 73, 74, 75, 76, 77, 78, 79, 80, 81, 82, 83, 84, 85, 86, 87, 88, 89, 90, 91, 92, 93, 94, 95, 96, 97, 98, 99, 100, 121, 144, 169, 196, 225, 500, 1000 or more first aqueous objects may be isolated from each other. Preferably there are 144 first aqueous objects. Preferably there are 144 isolated first aqueous objects. The array may comprise at least n isolated first aqueous objects, wherein n is equal to or greater than 2. The integer n may be equal to or greater than 3. n may be equal to or greater than 4. The integer n can in principle be high, for instance in the order of hundreds of thousands. This is because there is no upper limit on the size of the array. Such arrays, may, for instance, be useful for preparing prototissue such as a synthetic retina. n may be several hundred, for instance up to about 500 or 1000, or for instance up to about 400. The integer n may for instance be an integer of from 2 to 500, or an integer of from 3 to 500. n may be an integer of from 2 to 400. In other embodiments, n may be an integer of from 2 to 300, or an integer of from 3 to 200. n may be from 2 to 200. In other embodiments, however, n is an integer of from 2 to 50, or an integer of from 3 to 50. n may for instance be from 2 to 20. The first aqueous objects may be arranged in a grid. For example, the first aqueous objects may be in a 2x2, 2x3, 3x3, 3x4, 4x4, 2x4, 5x5, 6x6, 7x7, 8x8, 9x9, 10×10, 11×11, 12×12, 13×13, 14×14, 15x 15 or 20x20 arrangement.

The scaffold can prevent physical contact between the first aqueous objects. The scaffold may prevent physical contact between all or substantially all of the aqueous objects. The scaffold may isolate the first aqueous objects by preventing adjacent first aqueous objects from being in physical contact. The scaffold may isolate the first aqueous objects by extending between the first aqueous objects. The scaffold may isolate the first aqueous objects by comprising a barrier. There may be one or more barriers. The barrier or barriers may be continuous. The barrier or barriers may not be continuous. The barrier or barriers may comprise fence-like arrangements or strips. The scaffold may comprise a layer. The layer may comprise undulations and/or indentions in which the first aqueous objects can reside without physically contacting each other. The gradient of the layer may change to form troughs and peaks in order to prevent physical contact between the first aqueous objects. The change in gradient may be gradual or step-wise. The barrier or barriers may project or extend from the layer. The scaffold may comprise wells in which the first aqueous object reside. In such an embodiment, each aqueous object may reside in a different well. The scaffold may comprise cavities in which the first aqueous objects reside. In such embodiments, each aqueous object may reside in a different cavity. The cavities may be partially or completely enclosed within the scaffold. For example, the cavities may extend to one surface of the scaffold. The cavities preferably extend from one surface to another surface of the scaffold and therefore traverse the scaffold. The cavities may traverse from one surface to the opposite surface of the scaffold. The cavities may form open-ended tubular or substantially tubular holes. There may be two or more wells or cavities. There may be a plurality of wells or cavities. For example, there may be at least two, three, four, five, six, seven, eight, nine, ten, 11, 12, 13, 14, 15, 16, 17, 18, 19, 20, 21, 22, 23, 24, 25, 26, 27, 28, 29, 30, 31, 32, 33, 34, 35, 36, 37, 38, 39, 40, 41, 42, 43, 44, 45, 46, 47, 48, 49, 50, 51, 52, 53, 54, 55, 56, 57, 58, 59, 60, 61, 62, 63, 64, 65, 66, 67, 68, 69, 70, 71, 72, 73, 74, 75, 76, 77, 78, 79, 80, 81, 82, 83, 84, 85, 86, 87, 88, 89, 90, 91, 92, 93, 94, 95, 96, 97, 98, 99, 100, 121, 144, 169, 196, 225, 500, 1000 or more wells or cavities. There are preferably 144 wells or cavities. The scaffold may comprise at least n of said wells or cavities, wherein n is equal to or greater than 2. The integer n may be equal to or greater than 3. n may be equal to or greater than 4. The integer n can in principle be high, for instance in the order of hundreds of thousands. This is because there is no upper limit on the size of the scaffold. Such a scaffold, may, for instance, be useful for preparing prototissue such as a synthetic retina. n may be several hundred, for instance up to about 500 or 1000, or for instance up to about 400. The integer n may for instance be an integer of from 2 to 500, or an integer of from 3 to 500. n may be an integer of from 2 to 400. In other embodiments, n may be an integer of from 2 to 300, or an integer of from 3 to 200. n may be from 2 to 200. In other embodiments, however, n is an integer of from 2 to 50, or an integer of from 3 to 50. n may for instance be from 2 to 20.

The depth of the well or cavity may be equal to or less than 10 mm, for instance equal to or less than 5.0 mm. The depth of the well or cavity may be equal to or less than 2.0 mm, for instance, equal to or less than 1.0 mm. The depth of the well or cavity may be equal to or less than 0.5 mm, for instance, equal to or less than 0.1 mm. The depth of the well or cavity may be equal to or greater than 0.1 mm, for instance equal to or greater than 0.5 mm. The depth of the well or cavity may be from 0.1 to 20 mm, for instance, from 0.1 to 10 mm. The depth of the well or cavity may be from 0.1 to 5.0 mm, for instance, from 0.1 to 1.0 mm.

The distance between adjacent wells or cavities may be equal to or less than 5.0 mm, for instance equal to or less than 2.0 mm. The distance between adjacent wells or cavities may be equal to or less than 1.0 mm, for instance equal to or less than 0.5 mm. The distance between adjacent wells or cavities may be equal to or less than 0.1 mm.

The distance between adjacent wells or cavities may be equal to or greater than 0.1 mm, for instance equal to or greater than 0.5 mm. The distance between adjacent wells or cavities may be from 0.1 to 20 mm, for instance, from 0.1 to 10 mm. The distance between adjacent wells or cavities may be from 0.1 to 5.0 mm, for instance, from 0.5 to 5.0 mm. The distance between two wells or cavities is measured from the centre of one well to the centre of the other.

The scaffold may isolate the first aqueous objects by surrounding each first aqueous object. By surrounding, the scaffold is present around each first aqueous object along at least one plane. The scaffold can surround each first aqueous object using any of the features described herein for the scaffold which are suitable. For example, the barrier or barriers may surround each first aqueous object. The wells are able to surround the first aqueous object. The cavities are able to surround the first aqueous object.

The scaffold may comprise any suitable material. The scaffold is preferably bio-compatible. The scaffold is preferably soft or semi-solid and can maintain its shape. The scaffold is more preferably bio-compatible and soft or semi-solid. Even more preferably the scaffold is bio-compatible, can maintain its shape and is soft or semi-solid. The scaffold may comprise a polymer. The scaffold may be a gel. The gel can be a polymer hydrogel comprising a network of polymer chains. The polymer may optionally be cross-linked. The scaffold can comprise any of the materials described for the aqueous objects. The scaffold preferably comprises hydrogel and, even more preferably, the scaffold is hydrogel.

The scaffold may be any shape. The scaffold may be any regular or irregular shape, or any polygon. When the scaffold is a polygon, it may be convex or non-convex.

Usually the scaffold is a three-dimensional shape. It may thus be any three-dimensional shape. As the skilled person will appreciate, a three-dimensional shape may have three dimensions that are all the same order of magnitude, it may have one dimension that is at least an order of magnitude larger or smaller than the other two dimensions, or all three dimensions of the shape may be of different orders of magnitude.

The scaffold shape may, for instance, be spherical or a shape comprising two or more sides. The scaffold shape may comprise from 1 to 50 sides, for instance from 1 to 15 sides. The scaffold shape may, for example, be a 2-sided shape such as a hemisphere; a 3-sided shape such as a cylinder, a bended cylinder, or a 3-sided wire; a 5-sided shape such as a triangular prism; a 6-sided shape such as a cuboid; or a 14-sided shape such as a cross-shape.

The scaffold may be spherical, cross-shaped, cuboid, crescent-shaped, prism-shaped, cylindrical, wire-shaped or a shape which has a triangular, pentagonal, hexagonal, heptagonal, octagonal, nonagonal, decagonal, undecagonal, dodecagonal, square or rectangular face. Typically the scaffold is cuboid with a square or rectangular face.

The scaffold may have a planar or substantially planar arrangement.

The scaffold can provide the same isolation for the second aqueous object or objects as described herein for the first aqueous objects. Thus, for example, each cavity may comprise a single first aqueous object and a single second aqueous object.

The scaffold can comprise or be the single common second aqueous object as defined herein. Thus the scaffold can be the single common second aqueous object which forms interfaces described herein with each of the two or more first aqueous objects. For example, the scaffold can form interfaces with all or substantially all of the first aqueous objects.

The scaffold may be in contact with the aqueous objects. The scaffold may be in physical contact with the aqueous objects. If the scaffold is the single common second aqueous object, then the scaffold is in electrical contact with the first aqueous objects.

The scaffold may not be the single common second aqueous object as described herein. In such an embodiment, the scaffold may not be in electrical contact with the aqueous objects. The scaffold may be in physical contact with the aqueous objects but not in electrical contact with the aqueous objects. The scaffold may be in physical contact with the first aqueous objects but not in electrical contact with the first aqueous objects. The scaffold may be in physical contact with one or more of the second aqueous objects but not in electrical contact with the one or more of the second aqueous objects. The scaffold may be in physical contact with at least part of the droplet assembly described herein but not in electrical contact with the at least part of the droplet assembly.

If the scaffold and second aqueous object are not the same then the scaffold may not form an interface with the first or second aqueous objects. This can be achieved by the scaffold not being in physical contact with the first or second aqueous objects. For example, each aqueous object may be placed away from, for example, the edge of each well or cavity in the scaffold. If the scaffold is in physical contact with the first and/or second aqueous objects, then the scaffold does not comprise amphipathic molecules on at least the part of the surface of the scaffold which is in contact with the first and/or second aqueous objects. Thus the bilayer as described herein does not form. The scaffold may not comprise any or substantially any amphipathic molecules.

The first aqueous objects may be arranged on or in the scaffold to form any of the shapes described herein for the array. For example, the first aqueous objects could be arranged to form a square or a rectangle. The first aqueous objects may be arranged in a grid. For example, the first aqueous objects may be in a 2x2, 2x3, 3x3, 3x4, 4x4, 2x4, 5x5, 6x6, 7x7, 8x8, 9x9, 10×10, 11x11, 12x12, 13x13, 14x14, 15x15 or 20x20 arrangement.

Where the scaffold is arranged as a square or rectangle, the length of one, two, three or all four sides of the square or rectangle may be equal to or less than 10 cm, first instance equal to or less than 5.0 cm. The length of one, two, three or all four sides of the square or rectangle may be equal to or less than 1.0 cm, first instance equal to or less than 0.5 cm. The length of one, two, three or all four sides of the square or rectangle may be equal to or less than 0.2 cm, first instance equal to or less than 0.1 cm. For example, the scaffold may be arrange as a square with all sides being equal to or less than 1.0 cm in length. The length of one, two, three or all four sides of the square or rectangle may be equal to or greater than 0.1 cm, first instance equal to or greater than 0.5 cm. The length of one, two, three or all four sides of the square or rectangle may be equal to or greater than 1.0 cm.

The distance between adjacent first aqueous objects may be equal to or less than 5.0 mm, for instance equal to or less than 2.0 mm. The distance between adjacent first aqueous objects may be equal to or less than 1.0 mm, for instance equal to or less than 0.5 mm. The distance between first aqueous objects may be equal to or less than 0.1 mm.

The distance between adjacent first aqueous objects may be equal to or greater than 0.1 mm, for instance equal to or greater than 0.5 mm. The distance between adjacent first aqueous objects may be from 0.1 to 20 mm, for instance, from 0.1 to 10 mm. The distance between adjacent first aqueous objects may be from 0.1 to 5.0 mm, for instance, from 0.5 to 5.0 mm. The distance between two first aqueous objects is measured from the centre of one object to the centre of the other.

The array may comprise one or more further aqueous object(s) which are positioned adjacent to one or more of the first aqueous object(s) in the portion of the array isolated by the scaffold. Thus the one or more further aqueous object(s) positioned adjacent to one of the first aqueous objects may be isolated from another first aqueous object by the scaffold. The one or more further aqueous object(s) positioned adjacent to one of the first aqueous objects may be isolated by the scaffold from one or more further aqueous object(s) positioned adjacent to a different first aqueous object. One or more of the first aqueous object(s) may each be positioned adjacent to one or more further aqueous object(s). The one or more further aqueous object(s) adjacent to one first aqueous object may be different or the same as the one or more further aqueous object(s) adjacent to a different first aqueous object. The one or more further aqueous object(s) may be the same or different from the adjacent first aqueous object.

By being positioned adjacent, one or more further aqueous object(s) may be in contact with the adjacent first aqueous object. Additionally or alternatively, one or more of the further aqueous object(s) may be in contact with each other. The contact may be electrical. The contact may be physical. The contact may be electrical and physical. At the point of contact, interface(s) may form between one or more of the further aqueous object(s) and the adjacent first aqueous object. Interfaces may form between one or more of the one or more of the further aqueous object(s) and another one or more of the one or more of the further aqueous object(s).

The array may comprise one or more further aqueous object(s) which are positioned within one or more of the first aqueous object(s). One or more further aqueous object(s) may be surrounded or encapsulated by one of the first aqueous object.

The one or more of the further aqueous object(s) discussed herein may be independently defined in the same way as the first aqueous object discussed herein.

If the first aqueous object is in contact with the first communication means, as defined herein, then the one or more of the further aqueous object(s) may also be in contact with the same first communication means. The contact is preferably electrical. The contact may be physical. The contact may be electrical and physical.

The one or more of the further aqueous object(s) may be in contact with the second aqueous object as defined herein. The contact is preferably electrical. The contact may be physical. The contact may be electrical and physical. At the point of contact interface(s) may form between the one or more of further aqueous object(s) and the second aqueous object(s). The interface(s) may be independently defined in the same way as the interface between the first and second aqueous object(s) discussed herein. The presence of interface(s) between the further aqueous object(s) and the second aqueous object(s) increases the total interface area. The total interface area can be the sum of the area of the interface(s) between the first and second aqueous object(s) and the area of the interface(s) between the further aqueous object(s) and the second aqueous object(s). Thus the electrical signals which can pass across the interface is greater as more membrane proteins, such as those defined herein, can be present in the total interface area. Also, certain membrane proteins may result in a low electrical signal strength when a single first aqueous object is present. The presence of further interfaces may allow an enhanced electrical signal using such proteins. In particular, this facilitates miniaturisation.

The interface(s) described above may be independently defined in the same way as the interface between the first and second aqueous object(s) discussed herein. For example, the interface(s) may not comprise a bilayer.

A portion or all of the further aqueous objects, such as droplets, can form a single aqueous object together with the first aqueous object. For example the first aqueous object may be in direct contact with a plurality of further aqueous objects and wherein each aqueous object of the plurality is in direct contact with the first aqueous object, optionally wherein two or more of the plurality of further aqueous objects are in direct contact with each other. In an alternative embodiment, the first aqueous object is in direct contact with one or more further aqueous objects, wherein each further aqueous object is in direct contact with one or more yet further aqueous objects, wherein each one of the one or more yet further aqueous objects is not in direct contact with the first aqueous object, optionally wherein the one or more yet further aqueous objects are directly connected to further aqueous objects.

As will be apparent to a skilled person, the embodiments described herein provide for the formation of complex interconnecting networks of further aqueous objects.

For the aqueous objects to be in direct contact, there is fluid communication across each point of contact between the aqueous objects, and there are no bilayers between the adjacent objects at the point of contact.

The interface(s) may comprise a bilayer. Electrical signals may be passed between further aqueous objects and/or between the further aqueous object and the adjacent first aqueous object in addition to electrical signals being passed between the first and second aqueous object(s). The presence of a larger total interface area between the second aqueous object(s) and the first and further aqueous objects outweighs any additional electrical signals between the first and further aqueous objects. Therefore the electrical signal between the second aqueous object(s) and the first and further aqueous objects can be detected.

When the array comprises further aqueous objects, there may be a droplet assembly, as described herein, above and/or below the scaffold. The presence of further aqueous objects may allow contact, such as indirect contact, between the two droplet assemblies. Thus there may be communication, such as electrical communication between the two droplet assemblies.

The first aqueous object or objects and/or the further aqueous object or objects may be in contact, electrically or physically, with one or more cells. The first aqueous object or objects and/or the further aqueous object or objects may be in contact, electrically or physically, with one or more vesicles. The first aqueous object or objects and/or the further aqueous object or objects may comprise one or more cells. The first aqueous object or objects and/or the further aqueous object or objects may comprise one or more vesicles. As discussed herein, the cell may be a biological cell, a protocell or a synthetic cell. One or more cells and/or vesicles may be disposed in the first aqueous object or objects and/or the further aqueous object or objects. The first aqueous object(s) and/or the further aqueous object(s) may comprise hydrogel. The first aqueous object(s) and/or the further aqueous object(s) may further comprise one or more stabilising agents as described herein. The first aqueous object(s) and/or the further aqueous object(s) may further comprise an extracellular matrix protein as described herein. The first aqueous object(s) and/or the further aqueous object(s) may further comprise culture medium as described herein. The cell(s) may comprise voltage-sensitive proteins as described herein, such as channels, pumps and/or pores. Stimulation may be achieved by an ion flux between the first aqueous object and second aqueous object. The ion flux may stimulate the membrane of the cells. The ion flux may stimulate the voltage-sensitive proteins in the cells. The cell may then in turn stimulate or power a tissue. The cell may be a neural cell. Therefore the cell, such as a neural cell, may be used to stimulate or power a tissue. Thus the array can be used to control a biological or synthetic tissue. The cell(s) may comprise light-sensitive membrane proteins, such as channels, pumps and/or pores. Stimulation of the cells may be achieved by light stimulus (e.g. by exposure to light). The ion flux may cause ion flux between the first and second aqueous object(s).

In some embodiments, the second aqueous object or objects may comprise one or more vesicles. One or more vesicle may be disposed in the second aqueous object or objects.

The array may be in contact with a surface. The array may further comprise the surface. The surface may provide support to the aqueous objects in the array. For example, the scaffold may comprise cavities as described herein which can contain the aqueous objects. The cavities may traverse the scaffold from one surface to another surface of the scaffold. The surface which can provide support may be in contact with either of the surfaces of the scaffold which the cavities open out to. In such an embodiment, the aqueous objects are able to rest on the surface providing support and remain within the cavities.

The surface may be any suitable material. The surface may comprise the first communication means as defined herein. The surface may comprise the second communication means as defined herein. If the surface comprises the first and second communication means then the first and second communication means are insulated from one another and so are not in electrical contact. In such an arrangement the first and second communication means may not be in physical contact. The surface may comprise a printed circuit as described herein. The surface may comprise any suitable material on which a circuit can be printed as described herein. The surface may comprise a solid material, such as plastic or glass. The surface may comprise a polymer. The repeat unit of the polymer may, for instance, comprise a -C(=O)O- or a -Si(CH₃)₂O- group. The polymer may, for instance, be PMMA (poly(methyl methacrylate)) or PDMS (polydimethylsiloxane). The surface may be non-conducting.

The surface may be part of a solid support, such as a coverslip or Petri dish. The array may comprise the solid support. The surface is preferably flexible. The surface may be a patterned surface. The patterning of the surface may be achieved by any suitable method. For instance, the surface may be etched or milled. Alternatively, the surface may be formed using a template, which template is produced using a process comprising techniques such as etching or milling. Molds may, for instance, comprise a polymer such as PMMA (poly(methyl methacrylate)) or PDMS (polydimethylsiloxane).

The aqueous object, as referred to herein, may be any suitable structure comprising a volume of aqueous medium. The aqueous objects are able to electrically conduct. An aqueous object as described herein may be an aqueous droplet comprising an aqueous medium, as defined and described herein. The aqueous object may comprise the aqueous droplet. The aqueous object as described herein may comprise or be a hydrogel object as described herein.

The aqueous object, as described herein, such as an aqueous droplet or hydrogel object, may or may not contain promoters, expression systems or vectors.

The aqueous medium within the aqueous object may be any suitable aqueous medium. For instance, the aqueous medium may be pure water, or an aqueous buffer solution, or an aqueous solution of one or more salts. The aqueous medium preferably comprises the ions for the ion flux described herein to be generated.

The aqueous medium may comprise a hydrogel. When the aqueous medium may comprise a hydrogel, the aqueous medium may, for instance, comprise agarose and water. Specific hydrogel are described in more detail herein. The concentration of the agarose in water may be less than or equal to 10% w/v agarose. For instance, the concentration of the agarose in said water may be from 0.25 to 5% w/v agarose. Hydrogels other than agarose may also be used. For instance the aqueous medium may comprise methylcellulose, polyethylene glycol diacrylate, polyacrylamide, matrigel, hyaluronan, polyethylene oxide, polyAMPS (poly(2-acrylamido-2-methyl-1-propanesulfonic acid)), polyvinylpyrrolidone, polyvinyl alcohol, sodium polyacrylate, acrylate polymers or poly(N-isopropylacrylamide). Alternatively, the aqueous medium may comprise a silicone hydrogel or LB (Luria broth) agar.

The aqueous medium may comprise a combination of the above. For example the aqueous medium may comprise a solution and a hydrogel matrix. The solution may be as defined herein. In such an embodiment the solution may e.g. be disposed within a hydrogel matrix. For instance, the solution may be, e.g. pure water, or an aqueous buffer solution, or an aqueous solution of one or more salts.

The definitions of the aqueous object defined herein can apply independently to first aqueous objects described herein and the or each of the second aqueous object or objects described herein unless stated otherwise. One or more of the first aqueous objects may be the same as each another. One or more of the first aqueous objects may be different from each another. One or more of the second aqueous objects may be the same as each another. One or more of the second aqueous objects may be different from each another. One or more of the first aqueous objects may be different from one of more of the second aqueous objects. All or substantially all of the first aqueous objects may be the same as one another. All or substantially all of the second aqueous objects may be the same as one another. All or substantially all of the first aqueous objects may be different from the one or more second aqueous objects. All or substantially all of the first aqueous objects may be the same as each other and the single common second aqueous object, as described herein, may be different.

The aqueous object may comprise a hydrogel object. The aqueous object may not comprise a hydrogel object. In particular, the first aqueous object may not comprise a hydrogel object. The hydrogel object has a hydrogel body.

The first aqueous objects and the second aqueous object or objects may comprise hydrogel objects. The first aqueous objects may be droplets which do not comprise hydrogel and the second aqueous object or objects may comprise hydrogel objects. Preferably, the first aqueous objects are aqueous droplets. In such embodiments, the first aqueous droplets preferably each form an interface with the single common second aqueous object as described herein. In such embodiments, the single common second aqueous object preferably comprises hydrogel. The single common second aqueous object is preferably the scaffold. The single common second aqueous object may encapsulate one or more of the first aqueous object(s). The single common second aqueous object may encapsulate one or more of the further aqueous object(s). The single common second aqueous object may be the droplet assembly as described herein. In such an embodiment the scaffold may not be the single common second aqueous object. The droplet assembly preferably comprises hydrogel. The droplet assembly may comprise a hydrogel object.

The diameter of the aqueous droplet described herein may be equal to or less than 1000 µm, for instance equal to or less than 900 µm, 800 µm, 700 µm or 600 µm. The diameter of the droplet may be equal to or less than 500 µm, for instance equal to or less than 400 µm, 300 µm or 200 µm. The diameter may be equal to or less than 100 µm. The diameter of the droplet may be from 1 µm to 1000 µm, for instance from 10 µm to 500 µm. The diameter of the droplet may be equal to or greater than 1 µm, for instance equal to or greater than 10 µm. The diameter of the droplet may be equal to or greater than 50 µm, for instance equal to or greater than 100 µm. The smaller the size of the aqueous objects, such as droplets, the higher resolution possible for light sensing. For example, the smaller the size of the aqueous objects, such as droplets, the higher the resolution of a synthetic retina.

The aqueous droplet described herein may have a volume of less than or equal to 1500 nL, for example from 1.0 pL to 1500 nL. More typically, the droplet has a volume of less than or equal to 1000 nL, for instance equal to or less than 500 nL. The droplet may have a volume equal to or less than 200 nl, for instance a volume equal to or less than 50 nL. The droplet may have a volume equal to or less than 10 nL, for instance a volume equal to or less than 5.0 nL. The droplet may have a volume equal to or less than 1.0 nL, for instance a volume equal to or less than 0.5 nL, for example from 1.0 pL to 500 pL. The droplet may have a volume of from 1.0 nL to 500 nL. The droplet may have a volume of from 10 nL to 400 nL, for instance, from 100 nL to 300 nL. For instance, the droplet may have a volume of about 200 nL.

When the droplet is in contact with another droplet, the volume of the droplet and the other droplet may be the same or different. For instance, each droplet may have a volume of less than or equal to 1500 nL, for example from 1.0 pL to 1500 nL. Typically, each droplet has a volume of less than or equal to 1000 nL, for instance equal to or less than 500 nl. Each droplet may have a volume equal to or less than 200 nL, for instance a volume equal to or less than 50 nL. Each droplet may have a volume equal to or less than 10 nL, for instance a volume equal to or less than 5.0 nL. Each droplet may have a volume equal to or less than 1.0 nL, for instance a volume equal to or less than 0.5 nL, for example from 1.0 pL to 500 pL. Each droplet may have a volume of from 1.0 nL to 500 nL. Each droplet may have a volume of from 10 nL to 400 nL, for instance, from 100 nL to 300 nL. For instance, each droplet may have a volume of about 200 nL.

The body of the hydrogel object comprises a mass of hydrogel and may be any shape. Accordingly, the hydrogel body may be any regular or irregular shape, or any polygon. When the hydrogel body is a polygon, it may be convex or non-convex.

Usually the hydrogel body is a three-dimensional shape. It may thus be any three-dimensional shape. As the skilled person will appreciate, a three-dimensional shape may have three dimensions that are all the same order of magnitude, it may have one dimension that is at least an order of magnitude larger or smaller than the other two dimensions, or all three dimensions of the shape may be of different orders of magnitude.

The hydrogel body shape may, for instance, be spherical or a shape comprising two or more sides. In some embodiments, the hydrogel shape comprises from 1 to 50 sides, for instance from 1 to 15 sides. The hydrogel shape may, for example, be a 2-sided shape such as a hemisphere; a 3-sided shape such as a cylinder, a bended cylinder, or a 3-sided wire; a 5-sided shape such as a triangular prism; a 6-sided shape such as a cuboid; or a 14-sided shape such as a cross-shape.

The hydrogel body may be spherical, cross-shaped, cuboid, crescent-shaped, prism-shaped, cylindrical, wire-shaped or a shape which has a triangular, pentagonal, hexagonal, heptagonal, octagonal, nonagonal, decagonal, undecagonal, dodecagonal, square or rectangular face.

It follows that the hydrogel object may also be any shape.

The hydrogel objects may be all the same shape or may be a variety of different shapes.

The hydrogel of the hydrogel body may comprise any suitable hydrogel. The hydrogel typically comprises a high weight percent of water.

Usually, the hydrogel comprises agarose. Typically, the hydrogel comprises agarose and water. The concentration of the agarose in water is typically less than or equal to 10% w/v agarose. For instance, the concentration of the agarose in said water may be from 0.25 to 5% w/v agarose. More typically, the concentration of the agarose in said water is from 0.5 to 4% w/v, for instance, from about 1% w/v to 3% w/v. Usually, the concentration of the agarose in said water is about 1% w/v or 3% w/v.

Hydrogels other than agarose may also be used. For instance the hydrogel body may comprise methylcellulose, polyethylene glycol diacrylate, polyacrylamide, matrigel, hyaluronan, polyethylene oxide, polyAMPS (poly(2-acrylamido-2-methyl-1-propanesulfonic acid)), polyvinylpyrrolidone, polyvinyl alcohol, sodium polyacrylate, acrylate polymers or poly(N-isopropylacrylamide). Alternatively, the hydrogel body may comprise a silicone hydrogel or LB (Luria broth) agar.

The agarose may be a low melt-point agarose.

In some embodiments, hydrogel may be generated using 4-arm PEG acrylate

In some embodiments wherein the aqueous object comprises a hydrogel object, at least one hydrogel body comprises a hydrophilic material and a hydrophobic material. The hydrophilic material is typically agarose. The hydrogel body comprising a hydrophilic material and a hydrophobic material may, for example, be a spherical hydrogel body made up of a hemisphere of a hydrophilic material and a hemisphere of a hydrophobic material, and may therefore be considered to have two faces. A hydrogel object comprising a hydrogel body comprising a hydrophilic material and a hydrophobic material has therefore been termed a "Janus particle".

There are two or more first aqueous objects and at least one second aqueous object. There may be a plurality of first aqueous objects or second aqueous objects. For example, there may be at least two, three, four, five, six, seven, eight, nine, ten, 11, 12, 13, 14, 15, 16, 17, 18, 19, 20, 21, 22, 23, 24, 25, 26, 27, 28, 29, 30, 31, 32, 33, 34, 35, 36, 37, 38, 39, 40, 41, 42, 43, 44, 45, 46, 47, 48, 49, 50, 51, 52, 53, 54, 55, 56, 57, 58, 59, 60, 61, 62, 63, 64, 65, 66, 67, 68, 69, 70, 71, 72, 73, 74, 75, 76, 77, 78, 79, 80, 81, 82, 83, 84, 85, 86, 87, 88, 89, 90, 91, 92, 93, 94, 95, 96, 97, 98, 99, 100, 121, 144, 169, 196, 225, 500, 1000 or more first aqueous objects and/or second aqueous objects. There are preferably 144 first aqueous objects. Each first aqueous object may form an interface with a different individual second aqueous object. In such embodiments, there are at least two first aqueous objects and at least two second aqueous objects; and a first interface is formed between one of the first aqueous objects and one of the second aqueous objects and a second interface is formed between the other first aqueous object and the other second aqueous object. Two or more first aqueous objects may not each form an interface with the same second aqueous object.

In some embodiments, there is preferably a single second aqueous object which at least the two or more first aqueous objects each form an interface with. In such embodiments, the second aqueous object can be referred to herein as the 'single common second aqueous object'. The common second aqueous object preferably forms interfaces with all or substantially all of the first aqueous objects. The single common second aqueous object preferably comprises hydrogel. The single common second aqueous object may comprise a hydrogel object. In some embodiments, the single common second aqueous object is preferably the scaffold. In some embodiments, the single common second aqueous object may be a droplet assembly as described herein. In such embodiments, the single common second aqueous object may not be the scaffold.

The array may comprise at least n first aqueous objects and/or second aqueous objects, wherein n is equal to or greater than 2. The integer n may be equal to or greater than 3. n may be equal to or greater than 4. The integer n can in principle be high, for instance in the order of hundreds of thousands. This is because there is no upper limit on the size of the array. Such arrays, may, for instance, be useful for preparing prototissue such as a synthetic retina. n may be several hundred, for instance up to about 500 or 1000, or for instance up to about 400. The integer n may for instance be an integer of from 2 to 500, or an integer of from 3 to 500. n may be an integer of from 2 to 400. In other embodiments, n may be an integer of from 2 to 300, or an integer of from 3 to 200. n may be from 2 to 200. In other embodiments, however, n is an integer of from 2 to 50, or an integer of from 3 to 50. n may for instance be from 2 to 20.

The hydrogel body may be as herein defined.

The wire-shaped hydrogel object may, in some embodiments, have a diameter of less than or equal to 10 mm, for instance, less than or equal to 5 mm. For instance, the wire-shaped hydrogel object may have a diameter of from 0.005 mm to 2 mm, for instance from 0.5 mm to 2mm. For instance, the wire-shaped hydrogel object may have a diameter of about 0.5 mm. Alternatively, it may have a diameter of from about 1 mm to about 2 mm.

In some embodiments, the wire-shaped hydrogel object will have a length of equal to or greater than 0.5 mm, for instance, equal to or greater than 2 mm. The length of the wire-shaped hydrogel object is usually its largest dimension.

The diameter of a wire shaped hydrogel object will usually be less than the length of that hydrogel object. Typically, of course, it will be substantially less, for instance, less than a quarter of the length of the hydrogel object, or less than a tenth of the length of the hydrogel object.

As mentioned above, a hydrogel body may be any shape. A hydrogel body may also be any suitable size.

When the hydrogel object is a sphere, the diameter of the hydrogel object is the diameter of the sphere. When the hydrogel object is a cylindrical, the diameter is equal to the diameter of either of the circular faces of the cylinder. When the hydrogel object is a wire-shape, the diameter is equal to the diameter of the cross-section of the wire-shape, wherein the cross-section is taken at right angles to the length of the wire-shape. When the hydrogel object is a shape other than a sphere, cylinder or wire-shape the diameter of the hydrogel object is the diameter of a sphere that has the same volume as the hydrogel object.

The hydrophilic material of the Janus particle may, for instance, comprise agarose. For example, hydrophilic material of the Janus particle may comprise agarose and water. The concentration of the agarose in the water may be less than or equal to 10% w/v agarose. For instance, the concentration of the agarose may be less than or equal to 5% w/v agarose. The concentration of the agarose in the water may, for instance, be about 1% w/v agarose.

The Janus particle may be any shape. The hydrogel body of the Janus particle may, for instance, be any regular or irregular shape, or any polygon. When the hydrogel body is a polygon, it may be convex or non-convex. The hydrogel body of the Janus particle may, for instance, be a molded three-dimensional hydrogel shape. Typically, the three-dimensional shape is spherical, cross-shaped, cuboid, crescent-shaped, prism-shaped, cylindrical, wire-shaped or a shape which has a triangular, pentagonal, hexagonal, square or rectangular face.

The hydrogel body comprising a hydrophilic material and a hydrophobic material may, for example, be a spherical hydrogel body made up of a hemisphere of a hydrophilic material and a hemisphere of a hydrophobic material. Alternatively, the hydrophobic material may be in the centre of the Janus particle, and surrounded by the hydrophilic material. However, any suitable arrangement of at least one hydrophilic material and at least one hydrophobic material may be used. The Janus particle may, for instance, comprise a first hydrophilic material, a hydrophobic material and a second hydrophilic material, wherein (i) the first and second hydrophilic materials may be the same or different; and (ii) the first and second hydrophilic materials are not in contact with each other. Similarly, the Janus particle may, for instance, comprise a first hydrophobic material, a hydrophilic material and a second hydrophobic material, wherein (i) the first and second hydrophobic materials may be the same or different; and (ii) the first and second hydrophobic materials are not in contact with each other.

The Janus particle thus allows compartments to be formed within the hydrogel body. Individual compartments may, for instance, be used as a store for a small molecule, such as a dye or a magnet, a sensor molecule, a therapeutic agent or a diagnostic agent. This may, for example, permit a concentration gradient to form within the hydrogel body. If a concentration gradient were to form, this may lead to the diffusion of small molecules, such as dyes or magnets, sensor molecules, therapeutic agents or diagnostic agents to diffuse from one compartment within the Janus particle to another compartment within the Janus particle.

As mentioned above, the hydrogel body may comprise agarose. In some embodiments, the agarose may, for instance, be dissolved in a buffer solution. One important property is pH and this can be varied over a wide range. For instance, the pH of the aqueous medium within the hydrogel objects may be in the range of from 3 to 9 (or for instance in the range of from 5 to 9) although higher and lower pHs are also possible. The pH of the aqueous medium within the hydrogel objects may be in the range of from 6 to 8. The hydrogel body may therefore comprise an aqueous buffer solution. Any suitable buffer can be employed, depending on the desired pH. The buffer solution may for instance comprise Tris HCl, with KCl. The pH of the aqueous buffer solution may be from 3 to 9, or for instance from 5 to 9. The pH of the aqueous buffer solution may be from 6 to 8. The nature and concentration of the solutes can be varied to vary the properties of the solution. As noted previously, where the hydrogel body may support the promoters, expression systems and/or vectors described herein, the skilled person will readily adjust the pH accordingly.

The boundary that is shared between contacting first and second aqueous objects, at the point of contact between the objects, is referred to herein as an interface. The interface comprises a bilayer of amphipathic molecules.

When one hydrogel object and one aqueous droplet form a bilayer, it can be referred to as a droplet hydrogel bilayer (DHB). When two aqueous droplets form a bilayer, it can be referred to as a droplet interface bilayer (DIB).

As the skilled person will appreciate, two aqueous objects may share a single interface, or two or more interfaces. For instance, the second aqueous object may be in contact with two first aqueous objects to form two separate interfaces.

At least two of the first aqueous objects can form an interface with the single common second aqueous object as described herein. Thus the at least two first aqueous objects can each form an interface with the same second aqueous object (e.g. the single common second aqueous object). All or substantially all of the first aqueous objects can form an interface with the same second aqueous object (e.g. the single common second aqueous object). There may be the same number of interfaces as first aqueous objects. There may be a plurality of interfaces. For example, there may be at least two, three, four, five, six, seven, eight, nine, ten, 11, 12, 13, 14, 15, 16, 17, 18, 19, 20, 21, 22, 23, 24, 25, 26, 27, 28, 29, 30, 31, 32, 33, 34, 35, 36, 37, 38, 39, 40, 41, 42, 43, 44, 45, 46, 47, 48, 49, 50, 51, 52, 53, 54, 55, 56, 57, 58, 59, 60, 61, 62, 63, 64, 65, 66, 67, 68, 69, 70, 71, 72, 73, 74, 75, 76, 77, 78, 79, 80, 81, 82, 83, 84, 85, 86, 87, 88, 89, 90, 91, 92, 93, 94, 95, 96, 97, 98, 99, 100, 121, 144, 169, 196, 225, 500, 1000 or more interfaces. The array may comprise at least n of said interfaces, wherein n is equal to or greater than 2. The integer n may be equal to or greater than 3. n may be equal to or greater than 4. The integer n can in principle be high, for instance in the order of hundreds of thousands. This is because there is no upper limit on the size of the array. Such arrays, may, for instance, be useful for preparing prototissue such as a synthetic retina. n may be several hundred, for instance up to about 500 or 1000, or for instance up to about 400. The integer n may for instance be an integer of from 2 to 500, or an integer of from 3 to 500. n may be an integer of from 2 to 400. In other embodiments, n may be an integer of from 2 to 300, or an integer of from 3 to 200. n may be from 2 to 200. In other embodiments, however, n is an integer of from 2 to 50, or an integer of from 3 to 50. n may for instance be from 2 to 20.

When two aqueous objects comprising a monolayer of amphipathic molecules are brought together, a bilayer of amphipathic molecules will quickly form at the interface between the two aqueous objects. The bilayer forms as it is an energetically more favourable configuration for the amphipathic molecules to adopt. The shape of the bilayer formed will be the shape with the lowest free surface energy. As discussed herein, the size of the bilayer can be adjusted by pushing the aqueous objects together or pulling the aqueous objects apart. Further, the bilayer can be removed, for example, by pushing the aqueous objects together and effectively squeezing out the bilayer. Thus a bilayer may be formed when two aqueous objects come together. The aqueous objects may, for instance, be brought together using a micromanipulator. Each aqueous object comprises amphipathic molecules on at least part of the surface of the aqueous object. Providing that the concentration of amphipathic molecules is high enough, when the two aqueous objects come together, the amphipathic molecules at the interface spontaneously form a bilayer. The presence or absence of a bilayer between any two aqueous objects may be controlled, for example, by pushing two aqueous objects together or pulling them apart and/or by increasing or decreasing the concentration of amphipathic molecules surrounding the aqueous bodies. Likewise, the area of the bilayer can be controlled, for example, by pushing two aqueous objects together or pulling them apart and/or by increasing or decreasing the concentration of amphipathic molecules surrounding the aqueous objects. The aqueous objects, such as aqueous droplets or hydrogel objects may be disposed in a hydrophobic medium and thus the concentration of amphipathic molecules will typically be the concentration of amphipathic molecules in the hydrophobic medium.

For a Janus particle, only the amphipathic molecules in contact with the hydrophilic material of the Janus particle are able to form a bilayer of amphipathic molecules with a neighbouring hydrogel object. This is because of the orientation of the amphipathic molecules around the surface of the hydrogel body of the Janus particle. The amphipathic molecules attracted to the hydrophilic material of the Janus particle will be orientated with their head groups nearest the hydrophilic surface. The amphipathic molecules attracted to the hydrophobic material of the Janus particle will be orientated with their head groups away from the hydrophilic surface. Thus, the amphipathic molecules attracted to the hydrophobic material of the Janus particle are not able to form a bilayer of amphipathic molecules with a neighbouring hydrogel object.

It is possible to detect the formation of a bilayer by measuring the specific capacitance at the interface. A standard voltage protocol may be used.

The array may comprise two or more interfaces. Any of the interfaces in the array may comprise a bilayer of amphipathic molecules. The bilayers may be formed as discussed above. The interface between the first aqueous object(s) and the second aqueous object(s) may not comprise a bilayer of amphipathic molecules. Bilayers will not be formed, for instance, when the two aqueous objects at the interface are pushed together with enough force to effectively squeeze out the amphipathic molecules at the interface, or when the concentration of amphipathic molecules is too low to form a bilayer. Thus, there may be interfaces present in the array of the present invention which do not comprise a bilayer of amphipathic molecules. For example, such interfaces which do not comprise a bilayer of amphipathic molecules may be present between the scaffold and the first aqueous object and/or the second aqueous object. Such interfaces which do not comprise a bilayer of amphipathic molecules may be present between the droplet assembly and the scaffold. Such interfaces which do not comprise a bilayer of amphipathic molecules may be present between the scaffold and the first aqueous objects and/or second aqueous objects. Such interfaces which do not comprise a bilayer of amphipathic molecules may be present between the droplet assembly and the scaffold, and between the first aqueous objects and the scaffold.

When there is no bilayer of amphipathic molecules at an interface between two aqueous objects, the two objects may, or may not, be in direct contact with each other at the interface. The interface may for instance comprise a layer of a material, such a polymer, or a compound other than a bilayer of amphipathic molecules. There may, for instance, be a thin layer of a hydrophilic material, e.g. aqueous medium (e.g. a thin layer of water, or a thin layer of an aqueous solution), or a hydrophobic material, such as a hydrophobic medium or oil (as described herein), between the two objects.

Wherein the aqueous object is a hydrogel object, typically the surface of the hydrogel object at the molecular level is not completely smooth. The agarose polymer chains of an agarose hydrogel object, for instance, usually do not lie flat along the edge of the hydrogel body, but rather create a "fuzzy edge" to the hydrogel body.

The array may comprise at least n of said first aqueous objects, and at least n of said interfaces between said first and second aqueous objects, wherein n is equal to or greater than 2. The integer n may be equal to or greater than 3. n may be equal to or greater than 4. The integer n can in principle be high, for instance in the order of hundreds of thousands. This is because there is no upper limit on the size of the array. Such arrays, may, for instance, be useful for preparing prototissue such as a synthetic retina. n may be several hundred, for instance up to about 500 or 1000, or for instance up to about 400. The integer n may for instance be an integer of from 2 to 500, or an integer of from 3 to 500. n may be an integer of from 2 to 400. In other embodiments, n may be an integer of from 2 to 300, or an integer of from 3 to 200. n may be from 2 to 200. In other embodiments, however, n is an integer of from 2 to 50, or an integer of from 3 to 50. n may for instance be from 2 to 20. Techniques such as soft lithography can be used to produce aqueous objects such as droplets and hydrogel objects having particularly small dimensions.

Very small aqueous objects may, for instance, be produced by disposing, for example, aqueous fluids, or liquid or melted hydrogel, from a syringe or needle, for instance a steel needle. The aqueous object or objects may be produced by manual manipulation or by automated manipulation. The aqueous object or objects may be produced by manual pipetting or by automated pipetting. The aqueous object or objects may be produced by 3D printing.

Droplet 3D Printer Overview: A description of an example of an apparatus for generating droplets (e.g. a 3D-printer of droplet networks) can be found in Villar et al, Science 340, 48-52 (2013). In brief, the droplet generator (which may be referred to as "piezo") comprises a piezoelectric disc which seals the back of an aqueous chamber with a protruding tapered capillary nozzle. The piezo can eject droplets from the nozzle upon application of a square-wave voltage pulse when the tip is submerged in a hydrophobic medium such as a lipid-in-oil solution. An electronic micromanipulator moves the printing stage, e.g. an oil container, in three dimensions. This in combination with lab-designed printing software that interprets "printing maps" and automates droplet ejection, allows the construction of 3D droplet networks by successive layering of spatially assigned droplets.

The aqueous object or objects can be formed by disposing or dropping, e.g. by pipetting, the aqueous medium to form the aqueous object into a hydrophobic medium such as those described herein. The array may further comprise the hydrophobic medium.
The aqueous medium may be a suspension comprising membrane protein (such as those described herein). The suspension may be obtained from the semi-solubilising method of the invention. Amphipathic molecules in the hydrophobic medium typically form a monolayer on the surface of the aqueous object. The aqueous object or objects may be formed and then transferred into the array. The aqueous object or objects, such as droplets, may be transferred by pipetting. Alternatively, if the array comprises a hydrophobic medium, the aqueous objector objects may be formed within the array by, for example, pipetting the medium for the aqueous object directly into the hydrophobic medium in the array. Each aqueous object, e.g. droplet, which is in contact with an electrode may be pipetted onto the electrode. The scaffold may be disposed in a hydrophobic medium to form a monolayer of amphipathic molecules on at least a part of its surface. The droplet assembly may be disposed in a hydrophobic medium to form a monolayer of amphipathic molecules on at least a part of its surface.

In some embodiments, the droplet is produced using a microfluidic device. Techniques such as soft-lithography may be used to produce a droplet. A droplet may, for instance, be molded. In some embodiments PMMA molds may be used to produce a droplet. Soft-lithography may, for instance, be used to produce a droplet comprising a hydrogel. Alternatively, a droplet may be produced using photolithograph. A photomask may, for instance, be used to define a pattern through which the light (such as UV light) can pass. Photolithography may, for instance, be used to produce a droplet comprising a photocurable polymer. For instance, photolithography may be used to produce a droplet comprising a hydrogel.

The skilled person will appreciate that methods such as described herein are widely applicable and may be used in the manufacture of aqueous objects that are different in form to droplets.

If the first aqueous object comprises a hydrogel object, to get the protein, such as the membrane protein, into the bilayer interface between the first and second aqueous objects, the protein can be coated onto the hydrogel, e.g. by microfluidics or by pipetting an aqueous droplet onto the hydrogel object.

The hydrogel body of the hydrogel objects can be molded. The hydrogel body of the hydrogel objects can be a molded three-dimensional hydrogel shape. The scaffold can be molded. In such embodiments the scaffold may also be the single common second aqueous object. Any suitable method may be used for the molding. Typically, a template will be used to produce the molded object, e.g. the scaffold. For instance, a PMMA (poly(methyl methacrylate)) mold may be used.

For instance, PMMA molds of the desired shape may be used to produce the hydrogel bodies. Typically, the hydrogel is melted and poured into the mold. After gelling, the hydrogel is usually removed from the mold and immersed in a hydrophobic medium. To form a wire-shaped hydrogel body, warm hydrogel is typically drawn into a tube by capillary action. The warm hydrogel is then usually allowed to gel. The wire-shapes hydrogel bodies produced are typically wires as herein defined.

Alternatively, the hydrogel body may be shaped using light (such as UV light) from a light source and a photomask. The photomask is typically used to define a pattern through which the light can pass. Usually, the hydrogel body is shaped by shining light (such as UV light) through a photomask onto a photocurable polymer. The photocurable polymer is polymerised by the light. In this embodiment, the hydrogel comprises a photocurable polymer.

The present invention provides a method for producing the array of the present invention, which comprises molding the scaffold and assembling the array. The scaffold can be molded by any suitable method and any method described herein. In some embodiments, preferably the scaffold is the second common aqueous object and is exposed to a lipid in oil solution as described herein so that at least a part of the surface comprises amphipathic molecules. In such embodiments, preferably a monolayer of amphipathic molecules is formed. In some embodiments, preferably the first aqueous objects are placed in the scaffold, for example each first aqueous object is placed in a cavity, preferably a different cavity. The interface can then form between each first aqueous object and the scaffold.

If the scaffold is not the second aqueous object then the first and second aqueous objects can be placed in the scaffold, such as in the cavities.

The method may further comprise generating or forming a droplet assembly as described herein. The array may be assembled by placing the scaffold on the droplet assembly and placing the aqueous objects in the scaffold. For example, each first aqueous object may be placed in a cavity, preferably a different cavity. A further droplet assembly may be placed on the scaffold. Therefore the scaffold may be sandwiched between two droplet assemblies. The droplet assemblies may be the same or different. The first aqueous object(s) may allow contact, such as indirect contact, between the two droplet assemblies. Thus there may be communication, such as electrical communication between the two droplet assemblies.

The droplet assembly of the invention is a collection of droplets, which is typically arranged in a three dimensional array. The disclosure of GB patent application no. 1603564.4 is is cited herein as a reference. Typically in a droplet assembly, each droplet is in contact with at least one other droplet in the assembly. A "droplet assembly" may also be referred to as an "assembly of volumes [of the material comprised in the droplets]". The droplet assembly may be of any size. For instance, the largest external dimension of a droplet assembly may be from 0.01 mm to 100.0 mm. The largest external dimension of the droplet assembly may, in some cases, be less than or equal to 10.0 mm, for instance less than or equal to 5.0 mm. The droplet assembly may be any of the sizes herein described for the scaffold.

The droplet assembly comprises a plurality of droplets. The droplets may be any of the aqueous droplets described herein and preferably comprise hydrogel. The droplets may each comprise a hydrogel object. The droplet assembly preferably comprises hydrogel. The droplet assembly may comprise one or more hydrogel objects. The second aqueous object or objects may form the droplet assembly. The plurality of droplets may be a plurality of second aqueous objects. Preferably, the single common second aqueous object comprises the plurality of droplets. The plurality of droplets may be the single common second aqueous object. The plurality of droplets can form the single common second aqueous object by each droplet being in direct contact with at least one other droplet in the assembly, so that each droplet is connected to all the other droplets either by direct contact or indirectly via other droplets. In such embodiments all the contacts between the droplets are direct. For the droplets to be in direct contact in the droplet assembly, there is no material between the droplets at (part of or all of) each point of contact between the droplets and there are no bilayers between the droplets. Thus a single common second aqueous object can be formed.

One or more of the droplets in the droplet assembly preferably comprise one or more cells disposed in the aqueous medium. The droplet assembly can comprise one or more cells. The cells may be any described herein, such as a biological cell, a protocell or a synthetic cell.

Typically, the aqueous medium further comprises one or more stabilising agents. The stabilising agents are usually dissolved in the aqueous medium. A stabilising agent is an agent (e.g. a compound) which increases the stability of the droplet assembly and/or improves the distribution of cells in the droplets in the droplet assembly. The one or more stabilising agents are typically selected from compounds comprising a dipeptide. Preferably, the one or more stabilising agents are selected from dipeptides protected with an FMOC group. The FMOC group is the fluorenylmethyloxycarbonyl group. Thus, a dipeptide protected with an FMOC group is a compound of formula FMOC-X-X where each X is independently an amino acid and each dash is a peptide bond. This may be represented by the formula below, wherein R' and R" are the variable groups in the amino acids. 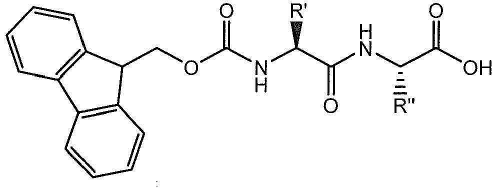 For instance, R' and R" may be independently selected from H, CH₃, CH(CH₃)₂, CH₂CH(CH₃)₂, CH(CH₃)(CH₂CH₃) and CH₂Ph. Preferably, R' and R" are independently selected from H, CH₃, CH(CH₃)(CH₂CH₃) and CH₂Ph. More preferably, the one or more stabilising agents are FMOC-isoleucine-glycine (FMOC-IG) and/or FMOC-phenylalanine-phenylalanine (FMOC-FF).

The concentration of the stabilising agent in the aqueous medium is typically from 0.01 to 100.0 mmol/L. For instance, the concentration of the one or more stabilizing agents may be from 0.1 to 10.0 mmol/L or from 0.5 to 2.0 mmol/L.

Typically, the aqueous medium further comprises an extracellular matrix protein (ECM). Examples of ECMs include collagen, elastin, fibronectin and laminin. The extracellular matrix protein preferably comprises collagen, fibronectin or laminin. The collagen may be any one of collagen types from I to XIV and is typically collagen Type I. The concentration of the ECM in the aqueous medium is typically from 0.001 mg/L to 100.0 mg/L. For instance, the concentration of the ECM in the aqueous medium may be from 0.01 mg/L to 10.0 mg/L, or from 0.1 mg/L to 1.0 mg/L.

The aqueous medium often further comprises a culture medium. A culture medium is any aqueous medium suitable for culturing cells, such as biological cells, and culture media are well known to the skilled person. The culture medium is typically an aqueous solution of one or more amino acids (for instance glutamine or a source thereof), one or more salts (for instance sodium chloride or sodium pyruvate), glucose, and one or more vitamins (for instance vitamins A, B, C or D). The culture medium may further comprise one or more antibiotics. Examples of antibiotics include penicillin and streptomycin.

In some embodiments the aqueous medium comprises: (a) a hydrogel at a concentration of from 0.5 to 30.0 mg/mL; (b) a culture medium at a concentration of from 60.0 to 90.0 volume%; and (c) a compound comprising a dipeptide at a concentration of from 0.1 to 10.0 mmol/L. The aqueous medium may optionally further comprise (d) an extracellular matrix protein at a concentration of from 0.001 to 1.0 mg/mL. The osmolarity of the culture medium at pH 7.0 is typically from 200 to 400 mOsm, for instance from 300 to 350 mOsm.

The term "biological cell", as used herein, is well known and refers to a cell comprising a cytoplasm (typically comprising organelles such as a nucleus or a ribosome) enclosed within a membrane. The biological cells may be prokaryotic or eukaryotic. The biological cells are typically eukaryotic. The biological cells may be naturally occurring or genetically (or otherwise) modified. Often, the biological cells are mammalian cells derived from mammalian tissue, for instance mouse, rat, sheep or human tissue. For instance, the biological cells may be derived from primate tissue such as human or chimpanzee tissue.

In some embodiments, the one or more biological cells are selected from two or more different types of biological cells.

A type of a biological cell refers to the cell type of a biological cell taken from a particular species. For instance, typical examples of mammalian biological cell types include human embryonic kidney (HEK) cells, osteoblast cells, chrondrocyte cells and mesenchymal stem cells. The biological cell is preferably a neural cell.

Typically, if two or more cell types are present, one or more of the droplets each comprises two or more biological cells disposed in the aqueous medium, and the two or more biological cells are selected from two or more different types of biological cells. Thus, individual droplets may comprise two or more types of cell. Alternatively, different droplets may comprise different cell types allowing structural features containing different cell types to be incorporated into the droplet assembly. Thus, in some cases, the droplet assembly may comprise a first plurality of droplets, each of which droplets comprises one or more of a first type of biological cells disposed in the aqueous medium, and a second plurality of droplets, each of which droplets comprises one or more of a second type of biological cells disposed in the aqueous medium.

The one or more biological cells are typically mammalian cells.

One or more biological cells may be disposed in the aqueous medium at a concentration of from 10⁵ to 10⁹ cells per mL of aqueous medium. For instance, the concentration of the biological cells disposed in the aqueous medium may be from 10⁵ to 10⁸ cells per mL or from 10⁶ to 10⁹ cells per mL. The concentration of biological cells in the aqueous medium may be greater than or equal to 10⁷ cells per mL.

Generating the plurality of droplets typically comprises: (i) a plurality of dispensing steps, each of which dispensing steps comprises injecting into a hydrophobic medium a volume of the aqueous medium with the one or more biological cells disposed therein. The volume of the aqueous medium with the one or more biological cells disposed therein is typically from 0.001 to 1000 nL. For instance, the volume of the.aqueous medium may be from 0.1 nL to 500 nL or from 1.0 nL to 300 nL. Often, the volume of the aqueous medium injected is from 50 nL to 250 nL.

Generating the plurality of droplets typically comprises 10 or more of the dispensing steps, for instance 100 or more of the dispensing steps. In some cases there may be a large number of dispensing steps, for instance 10,000 or more of the dispensing steps.

Typically, generating the plurality of droplets comprises using an apparatus for generating droplets, which apparatus comprises (a) at least one droplet generator; (b) a container which is movable relative to the at least one droplet generator; and (c) a control unit which is adapted to control the dispensing of droplets from the at least one droplet generator and to control the movement of the container relative to the at least one droplet generator. The (or each) droplet generator may for instance comprise: a chamber for holding the aqueous medium with the one or more biological cells disposed therein; an outlet; and a component for displacing through said outlet a volume of the aqueous medium with the one or more biological cells disposed therein and thereby dispensing said volume as a droplet. Examples of droplet generators and apparatuses for generating droplets suitable for use in the process of making a droplet assembly are described in WO 2014/087175. The component for displacing through said outlet a volume of the aqueous medium with the one or more biological cells disposed therein is often a piezoelectric transducer. The container which is movable relative to the at least one droplet generator usually comprises a hydrophobic medium.

The control unit is typically adapted to coordinate (a) the movement of the container relative to the or each droplet generator and (b) the dispensing of the droplets, to create said droplet assembly. The control unit may comprise a computer or dedicated electronic hardware. The apparatus often further comprises a micromanipulator for moving the container, and wherein the control unit is adapted to control movement of the container using the micromanipulator. The apparatus may further comprise a micromanipulator for moving the or each droplet generator and, when the apparatus comprises more than one said droplet generator, for coordinating the relative displacement of the droplet generators. Each droplet generator typically comprises: a chamber for holding a droplet medium, which is an aqueous medium; an outlet; and a component for displacing a volume of said droplet medium through said outlet and thereby dispensing said volume as a droplet. The outlet typically has a diameter of less than 200 µm. In some cases, the or each droplet generator is adapted to dispense droplets having a diameter of equal to or less than 1 mm, for instance from 10 µm to 200 µm. The or each droplet generator is typically adapted to dispense droplets having a volume of from 0.001 nL to 100 nL. The control unit is typically adapted to control the dispensing of droplets at a rate of from 0.01 to 10 s⁻¹. The apparatus in some cases may comprise a plurality of said droplet generators, for instance a first droplet generator comprises a first aqueous medium and wherein a second droplet generator comprises a second aqueous medium, wherein the first and second aqueous media are different (typically because they comprise different types of biological cells).

Often, the process further comprises, before the step of generating a plurality of droplets, a step of preparing the aqueous medium with one or more biological cells disposed therein, which preparation step comprises providing an aqueous medium and suspending a plurality of biological cells in the aqueous medium.

The process may further comprise a gelling step, which gelling step comprises allowing the aqueous medium comprising the hydrogel compound to form a gel. Typically, the gelling step comprises cooling the droplet assembly to a temperature of less than or equal to 10.0°C and allowing the aqueous medium comprising the hydrogel compound to form a gel. Alternative gelling methods (for instance exposure to UV light) may be used.

The process may further comprise culturing the plurality of biological cells to produce a celluralised droplet assembly. Culturing the plurality of cells typically comprises allowing the density of the biological cells to increase. The droplet assembly may be transferred to a culture medium prior to culturing. Often, the process further comprises isolating the droplet assembly from the hydrophobic medium. This may be done by physically removing the droplet assembly from the hydrophobic medium or alternatively by removing the hydrophobic medium (e.g. by allowing it to drain). The amphipathic molecules are usually as herein defined.

The droplet assembly may further comprise a hydrogel layer disposed on the surface of the plurality of droplets. The disclosure of GB patent application no. 1603560.2 is cited as a reference. The hydrogel layer may be in direct contact with the plurality of droplets. Thus the hydrogel layer and plurality of droplets may form the single common second aqueous object. The hydrogel layer may cover greater than or equal to 80 % of the surface area of the plurality of droplets. The hydrogel layer may for instance coat all of the surface of the plurality of droplets. The thickness of the layer of hydrogel may be greater than or equal to 0.01 mm, for instance greater than or equal to 0.1 mm. Typically, the thickness of the layer of hydrogel is from 1.0 to 200 µm, for instance from 45 to 85 µm.

Formation of the hydrogel layer around the plurality of droplets typically comprises first forming a volume of an aqueous composition comprising a hydrogel compound around the plurality of droplets which can then be gelled to form the layer of hydrogel. The volume of an aqueous composition comprising a hydrogel compound around the plurality of droplets can be formed by a droplet of the aqueous composition spontaneously wetting the plurality of droplets. Once the droplet of the aqueous composition contacts the plurality of droplets it will typically spontaneously wet and coat the plurality of droplets. The aqueous composition may be any liquid medium comprising water. Typically, the aqueous composition is a composition comprising greater than or equal to 80 wt% water or greater than or equal to 90 wt% by water. The aqueous composition comprising a hydrogel compound typically comprises the hydrogel compound dissolved in water. The total volume of the aqueous composition and the volume of first hydrogel is typically greater than or equal to 100 nL. Preferably, the total volume is greater than or equal to 1000 nL.

Allowing the aqueous composition comprising the hydrogel compound to form a gel typically comprises cooling the aqueous composition or exposing the aqueous composition to a compound or electromagnetic radiation (for instance UV light) which causes gelling. Allowing the aqueous composition comprising the hydrogel compound to form a gel typically comprises cooling the volume of the aqueous composition comprising the hydrogel compound to a temperature of less than or equal to 20.0°C, for instance less than or equal to 10.0°C.

The aqueous object comprises amphipathic molecules on at least part of the surface of the aqueous object. The aqueous object may comprise an outer layer of amphipathic molecules on at least part of the surface of the aqueous object. The outer layer of amphipathic molecules may cover at least 25%, such as at least 50%, of the area of the surface of the aqueous object. The outer layer of amphipathic molecules may cover the whole surface of the aqueous object. The amphipathic molecules may encapsulate the aqueous objects. The amphipathic molecules may be any suitable amphipathic molecule. Usually, the amphipathic molecules will be ones which are capable, when present in a high enough concentration, of forming a bilayer at any one of said interfaces as defined herein. The type of amphipathic molecule that is capable of forming a bilayer may, for instance, depend on additional components of the contacting aqueous objects. The type of amphipathic molecule that is capable of forming a bilayer may, for instance, depend on the composition of the aqueous object, such as whether the aqueous object comprises hydrogel. The type of amphipathic molecule that is capable of forming a bilayer may, for instance, depend on the presence and nature of any additional components of the array. For example, if the aqueous objects are disposed in a hydrophobic medium, the amphipathic molecules may be, for instance, any suitable amphipathic molecules capable of forming a bilayer between contacting aqueous structures, within a hydrophobic medium. The type of amphipathic molecules capable of forming a bilayer within the hydrophobic medium would typically depend on the nature of the hydrophobic medium and the aqueous medium of the aqueous objects, but a wide range of amphipathic molecules is possible. Similarly, if the array further comprises a hydrophobic medium, the amphipathic molecules may be, for instance, any suitable amphipathic molecules capable of forming a bilayer within the hydrophobic medium. The type of amphipathic molecules capable of forming a bilayer within the hydrophobic medium would typically depend on the nature of the hydrophobic medium and the hydrogel of the hydrogel bodies, but a wide range of amphipathic molecules are possible.

Amphipathic molecules are molecules which have both hydrophobic and hydrophilic groups. The outer layer of amphipathic molecules formed on at least part of the surface of the aqueous object usually comprises a monolayer of amphipathic molecules on said at least part of the surface of the aqueous object. The monolayer is typically formed and maintained naturally by the interaction of the hydrophobic and hydrophilic groups with the aqueous medium so that the molecules align on the surface of the aqueous object with the hydrophilic groups facing inwards towards the aqueous medium and the hydrophobic groups facing outwards, for instance towards a hydrophobic medium. Likewise, the layer of amphipathic molecules that may surround the plurality of aqueous objects usually comprises a monolayer of amphipathic molecules which is formed and maintained spontaneously by the interaction of the hydrophobic and hydrophilic groups.

The amphipathic molecules may, for instance, be non-polymeric amphipathic molecules. Alternatively, the amphipathic molecules may be polymeric amphipathic molecules.

An important class of amphipathic molecules which can be used in an aqueous object is lipid molecules. The lipid molecules may be any of the major classes of lipid, including phospholipids, fatty acids, fatty acyls, glycerolipids, glycerophospholipids, sphingolipids, sterol lipids, prenol lipids, saccharolipids and polyketides. Some important examples include phospholipids and fatty acids, for instance phospholipids. The lipid molecules may be naturally occurring or synthetic. Whilst the formation of a bilayer from lipid molecules has been demonstrated the method is expected to be appropriate for any amphipathic molecules.

A common class of hydrophobic group that may be present in an amphipathic molecule is a hydrocarbon group, as for instance in most lipids. However, another suitable kind of hydrophobic group that may be employed is a fluorocarbon group. Thus, a further important class of amphipathic molecule is an amphipathic molecule that comprises at least one fluorocarbon group. An example of such a molecule would be a lipid-like molecule which comprises a hydrophobic fluorocarbon tail and a hydrophilic head group.

The amphipathic molecules of the aqueous object need not be all of the same type. Rather, the amphipathic molecules may in some embodiments be a mixture of two or more different kinds of amphipathic molecule. Another example is that the amphipathic molecules in the respective outer layers of different aqueous objects may be of different types so that, if bilayers are formed, the bilayer(s) formed between the different aqueous objects may be asymmetric.

Typically, therefore, the amphipathic molecules comprise lipid molecules. The lipid molecules need not be all of the same type. Thus, the amphipathic molecules may comprise a single type of lipid or a mixture of two or more different lipid molecules. Likewise, when the aqueous object is in contact with another aqueous objects, the lipid compositions of the surface or outer layers of the individual aqueous objects may be the same as or different from one another. Lipid molecules are particularly advantageous because lipid bilayers, or more generally bilayers of amphipathic molecules, are models of cell membranes and the array may therefore serve as an excellent platform for a range of experimental studies, including for instance as novel platforms for the fundamental study of membrane proteins, or as multicompartment protocellular chassis for "bottom-up" synthetic biology.

Phospholipids are particularly preferred for reasons outlined above and also because they are a major component of all cell membranes, making aqueous objects comprising phospholipids particularly suitable for synthetic biology applications. The phospholipids described below may be non-PEGylated phospholipids.

Accordingly, the amphipathic molecules on at least part of the surface of the aqueous medium of the aqueous object typically comprise phospholipid molecules. The phospholipid molecules may be cross-linked. Cross-linking can increase the stability of the bilayer. The phospholipid molecules may be block copolymers. Block copolymers comprise two or more homopolymer subunits linked by covalent bonds. The phospholipid molecules may be cross-linked to form block copolymers. The phospholipid molecules may be the same or different, i.e. the amphipathic molecules comprise a single kind of phospholipid, or a mixture of two or more different phospholipids. Phospholipids are well known to the skilled person and many are commercially available, from suppliers such as Avanti Polar Lipids. The phospholipid molecules may be glycerophospholipids or phosphosphingolipids or a mixture of the two. The phospholipid molecules may comprise anionic phospholipids, phospholipids comprising primary amines, choline-containing phospholipids and/or glycosphingolipids. Usually, the amphipathic molecules comprise one or more glycerophospholipids. As the skilled person will appreciate, glycerophospholipids include, but are not limited to, glycerophospholipids having a structure as defined in the following formula (I): 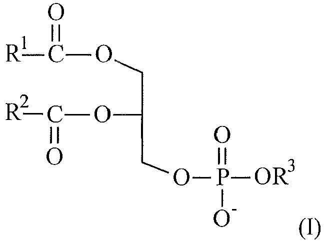 wherein:
R¹ and R², which are the same or different, are selected from C₁₀-C₂₅ alkyl groups and C₁₀-C₂₅ alkenyl groups;
either R³ is absent such that OR³ is O⁻, or R³ is present and is H, CH₂CH₂N(R⁴)₃⁺, a sugar group, or an amino acid group; and
each R⁴, which is the same or different, is independently selected from H and unsubstituted C₁-C₄ alkyl.

Typically, when R³ is CH₂CH₂N(R⁴)₃⁺, each R⁴, which is the same or different, is selected from H and methyl. As the skilled person will appreciate, when each and every R⁴ is methyl, the R³ group is a choline group, and when each and every R⁴ is H, the R³ group is an ethanolamine group.

When R³ is an amino acid group it may for instance be a serine group, i.e. -CH₂CH(NH₂)(COOH). When R³ is a sugar group, it may for instance be glycerol, i.e. -CH₂CHOHCH₂OH, or for instance inositol, i.e. -CH(CHOH)₅.

Typical examples of R¹ and R² groups are C₁₀-C₂₅ alkyl groups, including, but not limited to linear C₁₀-C₂₅ alkyl groups such as, for instance, CH₃(CH₂)₁₀-, CH₃(CH₂)₁₂-, CH₃(CH₂)₁₄-, CH₃(CH₂)₁₆-, CH₃(CH₂)₁₈-, CH₃(CH₂)₂₂- and branched C₁₀-C₂₅ alkyl groups such as for instance -CH₂-CH(CH₃)-(CH₂)₃-CH(CH₃)-(CH₂)₃-CH(CH₃)-(CH₂)₃-CH(CH₃)₂.

Further typical examples of R¹ and R² groups are unsubstituted C₁₀-C₂₅ alkenyl groups, including, but not limited to, CH₃(CH₂)₅CH=CH(CH₂)₇-, CH₃(CH₂)₇CH=CH(CH₂)₇-, CH₃(CH₂)₄CH=CHCH₂CH=CH(CH₂)₇-, CH₃(CH₂)₄(CH=CHCH₂)₃CH=CH(CH₂)₃-, and CH₃CH₂CH=CHCH₂CH=CHCH₂CH=CH(CH₂)₇-.

As the skilled person will appreciate, the O⁻ group in the phosphate group adjacent the OR³ group may in some embodiments be protonated, or associated with a suitable cation, for instance a metal cation such as Na⁺.

Thus, the amphipathic molecules may comprise one or more glycerophospholipids having the structure of formula (I) as defined above.

For instance, the amphipathic molecules may comprise any one or more of the following glycerophospholipids: diphytanoylphosphatidylcholine, diphytanoyl-sn-glycero-3-phosphacholine (DPhPC), diphytanoylphosphatidylethanolamine, 1,2-didecanoyl-sn-glycero-3-phosphocholine, 1,2-dierucoyl-sn-glycero-3-phosphate, 1,2-dierucoyl-sn-glycero-3-phosphocholine, 1,2-dierucoyl-sn-glycero-3-phosphoethanolamine, 1,2-dilinoleoyl-sn-glycero-3-phosphocholine, 1,2-dilauroyl-sn-glycero-3-phosphate, 1,2-dilauroyl-sn-glycero-3-phosphocholine, 1,2-dilauroyl-sn-glycero-3-phosphoethanolamine, 1,2-dilauroyl-sn-glycero-3-phosphoserine, l,2-dimyristoyl-sn-glycero-3-phosphate, 1,2-dimyristoyl-sn-glycero-3-phosphocholine, 1,2-dimyristoyl-sn-glycero-3-phosphoethanolamine, 1,2-dimyristoyl-sn-glycero-3-phosphoserine, 1,2-dioleoyl-sn-glycero-3-phosphate, 1,2-dioleoyl-sn-glycero-3-phosphocholine, 1,2-dioleoyl-sn-glycero-3-phosphoethanolamine, 1,2-dioleoyl-sn-glycero-3-phosphoserine, 1,2-dipalmitoyl-sn-glycero-3-phosphate, 1,2-dipalmitoyl-sn-glycero-3-phosphocholine, 1,2-dipalmitoyl-sn-glycero-3-phosphoethanolamine (DPPE), 1,2-dipalmitoyl-sn-glycero-3-phosphoserine, 1,2-distearoyl-sn-glycero-3-phosphate, 1,2-distearoyl-sn-glycero-3-phosphocholine, 1,2-distearoyl-sn-glycero-3-phosphoethanolamine, 1,2-distearoyl-sn-glycero-3-phosphoserine, egg-PC, hydrogenated egg PC, hydrogenated soy PC, 1-myristoyl-sn-glycero-3-phosphocholine, 1-palmitoyl-sn-glycero-3-phosphocholine, 1-stearoyl-sn-glycero-3-phosphocholine, 1-myristoyl-2-palmitoyl-sn-glycero 3-phosphocholine, 1-myristoyl-2-stearoyl-sn-glycero-3-phosphocholine, 1-palmitoyl-2-myristoyl-sn-glycero-3-phosphocholine, 1-palmitoyl-2-oleoyl-sn-glycero-3-phosphocholine, 1-palmitoyl-2-oleoyl-sn-glycero-3-phosphoethanolamine, 1-palmitoyl-2-stearoyl-sn-glycero-3-phosphocholine, 1-stearoyl-2-myristoyl-sn-glycero-3-phosphocholine, 1-stearoyl-2-oleoyl-sn-glycero-3-phosphocholine and 1-stearoyl-2-palmitoyl-sn-glycero-3-phosphocholine, 1,2-diphytanoyl-*sn-*glycero-3-phosphocholine (DPhPC), 1,2-distearoyl-*sn*-glycero-3-phosphocholine (DSPC), 1,2-dipalmitoyl-*sn*-glycero-3-phosphocholine (DPPC), or 1,2-dipalmitoyl-*sn*-glycero-3-[phospho-*rac*-(1-glycerol)] (DPPG), can be employed as the amphiphilic molecules in the aqueous object or objects, or a mixture of one or more thereof. The glycerophospholipid 1,2-dioleoyl-*sn*-glycero-3-phosphoethanolamine (DOPE) may also be used, and may be used in combination with a pH-sensitive lipid, for instance a fatty acid.

Additionally or alternatively, the amphipathic molecules may comprise a steroid, which steroid comprises an alkyl side-chain. The amphipathic molecules may, for instance, comprise cholesterol, β-sitosterot and lanosterol.

In some embodiments, the amphipathic molecules comprise derivatives of phospholipids. For instance, the amphipathic molecules may comprise a phosphatidylcholine, such as POPC (1-Palmitoyl-2-oleoyl-*sn*-glycero-3-phosphocholine) or DPPC (1,2-Dipalmitoyl-sn-glycero-3-phosphocholine), or a phosphatidylglycerol, such as POPG (1-palmitoyl-2-oleoyl-*sn*-glycero-3-phosphoglycerol).

Preferably, the amphipathic molecules comprise DPhPC.

The amphipathic molecules may, for instance, comprise one or more fatty acids, e.g. oleic acid. Fatty acids are of course well known to the skilled person and a wide range of these are commercially available.

The amphipathic molecules may for instance comprise a mixture comprising: (a) one or more phospholipids, and (b) one or more fatty acids.

An alkenyl group is a linear or branched chain hydrocarbon radical comprising one or more double bonds. An alkenyl group may be a C₁₀₋₂₅ alkenyl group. Examples of C₁₀₋₂₅ alkenyl groups include those related to C₁₀₋₂₅ alkyl groups by the insertion of one or more double bonds. Alkenyl groups typically comprise one, two, three or four double bonds. In some cases, an alkenyl group may be a linear alkenyl group.

A phospholipid comprising a PEG group may also be referred to herein as a PEGylated phospholipid. The PEGylated phospholipids may be phospholipids derived from the non-PEGylated phospholipids described above by derivatisation of the non-PEGylated phospholipid with a group comprising a PEG group, for instance a R⁵ group.

In addition to the amphipathic molecules, the aqueous object or objects may further comprise a PEGylated lipid. The term "PEGylated lipid", as used herein, refers to a lipid which has been derivatised with poly(ethylene glycol). For instance, when the aqueous object or objects is surrounded by a layer of amphipathic molecules, the layer may further comprise a PEGylated lipid.

The inclusion of one or more PEGylated lipids in the aqueous object or objects typically provides stabilisation *in vivo,* and in particular prolongs the plasma half-life of the aqueous object or objects. Any suitable PEGylated lipid may be employed, including, but not limited to, PEG-phospholipids, diacylglycerol-PEG, cholesterol-PEG derivatives, and mixtures thereof.

In some embodiments, the layer surrounding the aqueous object or objects, such as aqueous droplets or hydrogel objects, further comprises a PEGylated lipid. The peripheral layer may include one or more PEGylated lipids in addition to the amphipathic molecules, for instance multiple copies of the same PEGylated lipid, or a mixture of two or more different classes of PEGylated lipids. Suitable PEGylated lipids include, but are not limited to PEG-phospholipids, diacylglycerol-PEG, cholesterol-PEG derivatives and mixtures thereof.

The poly(ethylene glycol) (PEG) component of the PEGylated lipid may have any one of several different geometries. Thus, it could be substantially linear PEG or branched PEG. The branched PEG may for instance have from three to ten PEG chains emanating from a central core group. Alternatively, the branched PEG could be a star PEG, having from 10 to 100 PEG chains emanating from a central core group. Alternatively, the PEG may be a comb PEG, having multiple PEG chains grafted to a polymer backbone.

The one or more PEGylated lipids employed may for instance comprise a PEG-phospholipid of the following formula (II) 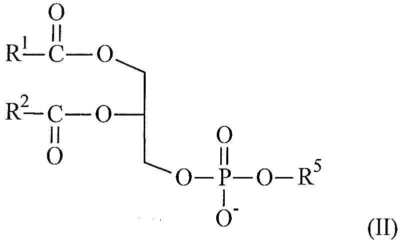 wherein R¹ and R² are as defined above for the glycerophospholipids of formula (I), and R⁵ is a group which comprises polyethylene glycol).

Preferably, R⁵ is a group of formula -Y-PEG, wherein:
- Y is selected from -alk-, -alk-N(R^{N})-, -C(O)-alk-, -alk-C(O)-, -alk-N(R^{N})-C(O)-, - C(O)-O-alk-, -alk-O-C(O)-;
- -alk- is straight chain C₁ to C₆ alkenyl, preferably ethenyl;
- R^{N} is H or methyl; and
- PEG is a poly(ethyleneglycol) group.

Y is preferably -CH₂CH₂-NH-C(O)-.

The group which comprises poly(ethylene glycol) may for instance have the formula - CH₂CH₂NHC(O)-X, or for instance -CH₂CH₂NHC(O)(CH₂)₃C(O)-X wherein X comprises said poly(ethylene glycol). The group X may for instance comprise substantially linear PEG, or for instance a branched PEG, having, for instance, from three to ten PEG chains emanating from a central core group. Alternatively, it can be a star PEG, having, for instance, from 10 to 100 PEG chains emanating from a central core group. Or for instance it may be a comb PEG, having multiple PEG chains grafted to a polymer backbone.

Thus, R⁵ may for instance be -CH₂CH₂NHC(O)-(OCH₂CH₂)_{q}OCH₃, -CH₂CH₂NHC(O)(CH₂)₃C(O)-(OCH₂CH₂)_{q}OCH₃, -CH₂CH₂NHC(O)-(OCH₂CH₂)_{q}OH, or -CH₂CH₂NHC(O)(CH₂)₃C(O)-(OCH₂CH₂)_{q}OH, wherein q is a positive integer. The integer q may for instance be from 5 to 10,000, or for instance from 10 to 1,000. Typically, q is from 10 to 1,000, preferably from 30 to 60.

Alternatively, R⁵ may be -(CH₂CH₂O)_{q}CH₃ or -(CH₂CH₂O)_{q}H, wherein q is a positive integer. The integer q may for instance be from 5 to 10,000, or for instance from 10 to 1,000, preferably from 10 to 1,000, more preferably from 30 to 60.

The PEGylated phospholipids may comprise a PEG group, and the PEG group may have the formula a -(O-CH₂CH₂)_{q}-O-R group, wherein R is H or methyl and q is a positive integer. The integer q may for instance be from 5 to 10,000, or for instance from 10 to 1,000, preferably from 10 to 1,000, more preferably from 30 to 60. The PEG group is typically an mPEG group. In an mPEG group, R is methyl.

Typically, references to molecular weights of PEG groups are references to the number average molecular weight in the phospholipids comprising a PEG group as a whole. For instance, the number average molecular weight of the PEG groups in the phospholipids is from 1500 to 5000 g/mol, preferably from 1800 to 2200 g/mol, for instance about 2000 g/mol.

Typically, R¹ and R² are each independently groups such that compounds of formula R¹COOH and R²COOH would be fatty acids selected from caprylic acid (C8), pelargonic acid (C9), capric acid (C10), undecylic acid (C11), lauric acid (C12), tridecylic acid (C13), myristic acid (C14), pentadecanoic acid (C15), palmitic acid (C16), margaric acid (C17), stearic acid (C18), nonadecylic acid (C19), arachidic acid (C20), heneicosylic acid (C21), behenic acid (C22), tricosylic acid (C23), lignoceric acid (C24), pentacosylic acid (C25), α-linolenic acid (C18:3), stearidonic acid (C18:4), eicosapentaenoic acid (C20:5), docosahexaenoic acid (C22:6), linoleic acid (C18:2), γ-linolenic acid (C18:3), dihomo-γ-linolenic acid (C20:3), arachidonic acid (C20:4), adrenic acid (C22:4), palmitoleic acid (C16:1), vaccenic acid (C18:1), paullinic acid (C20:1), oleic acid (C18:1), elaidic acid (Ctrans-18:1), gondoic acid (C20:1), erucic acid (C22:1), nervonic acid (C24:1), mead acid (20:3), phytanic acid (3,7,11,15-tetramethyl hexadecanoic acid).

Additionally or alternatively, the one or more PEGylated lipids may comprise a diacylglycerol-PEG of formula (III) 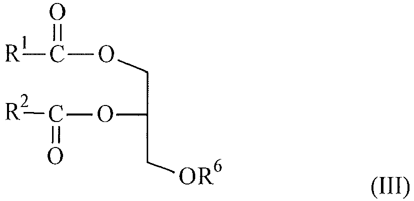 wherein R¹ and R² are as defined above for the glycerophospholipids of formula (I), and R⁶ is a group which comprises poly(ethylene glycol).

The poly(ethylene glycol) may for instance comprise substantially linear PEG, or for instance a branched PEG, having, for instance, from three to ten PEG chains emanating from a central core group. Alternatively, it can be a star PEG, having, for instance, from 10 to 100 PEG chains emanating from a central core group. Or for instance it may be a comb PEG, having multiple PEG chains grafted to a polymer backbone.

R⁶ may for instance be -(CH₂CH₂O)_{q}CH₃, -(CH₂CH₂O)_{q}H, -CH₂CH₂NHC(O)-(OCH₂CH₂)_{q}OCH₃, -CH₂CH₂NHC(O)-(OCH₂CH₂)_{q}OH, -CH₂CH₂NHC(O)(CH₂)₃C(O)-(OCH₂CH₂)_{q}OCH₃ or -CH₂CH₂NHC(O)(CH₂)₃C(O)-(OCH₂CH₂)_{q}OH wherein q is a positive integer. The integer q may for instance be from 5 to 10,000, or for instance from 10 to 1,000.

Additionally or alternatively, the one or more PEGylated lipids may comprise a cholesterol-PEG derivative of formula (IV) 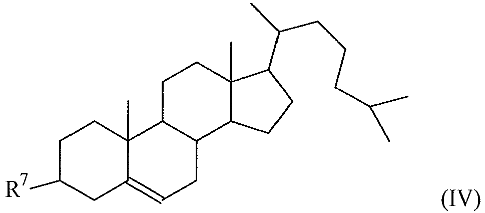 wherein R⁷ is a group which comprises poly(ethylene glycol).

Again, the poly(ethylene glycol) may comprise substantially linear PEG, or for instance a branched PEG, having, for instance, from three to ten PEG chains emanating from a central core group. Alternatively, it can be a star PEG, having, for instance, from 10 to 100 PEG chains emanating from a central core group. Or for instance it may be a comb PEG, having multiple PEG chains grafted to a polymer backbone.

R⁷ may for instance be -(OCH₂CH₂)_{q}OH or -(OCH₂CH₂)_{q}OCH₃ wherein q is a positive integer. The integer q may for instance be from 5 to 10,000, or for instance from 10 to 1,000.

Polyglycerine may be used instead of poly(ethylene glycol).

In certain embodiments the amphipathic molecules may comprise a mixture of non-PEGylated phospholipids and PEGylated phospholipids. The non-PEGylated phospholipids and PEGylated phospholipids may be any of the non-PEGylated phospholipids and PEGylated phospholipids described herein.

Such a mixture may comprise phospholipids comprising non-PEGylated phospholipids and PEGylated phospholipids, and wherein from 2.5 to 15 mol% of the phospholipids are PEGylated phospholipids. Preferably, from 5 to 15 mol% of the phospholipids may be PEGylated phospholipids. More preferably, from 7.5 to 15 mol% of the phospholipids may be PEGylated phospholipids. Even more preferably, from 10 to 15 mol% of the phospholipids may be PEGylated phospholipids.

In such mixtures the PEGylated phospholipids may comprise a PEG group which has a molecular weight of from 1500 to 5000 g/mol, optionally a molecular weight of from 1800 to 2200 g/mol.

In such mixtures the non-PEGylated phospholipids may be glycerophospholipids and/or the PEGylated phospholipids may be glycerophospholipids.

In such mixtures the non-PEGylated phospholipids are phospholipids of formula (I): 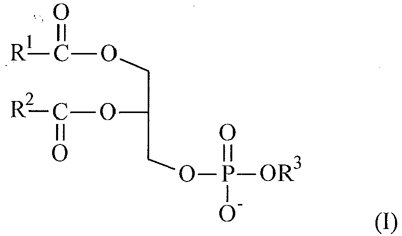 wherein:
R¹ and R², which are the same or different, are selected from C₁₀-C₂₅ alkyl groups and C₁₀-C₂₅ alkenyl groups;
R³ is absent such that OR³ is O⁻, or R³ is present and is H, CH₂CH₂N(R⁴)₃⁺, a sugar group, or an amino acid group; and
each R⁴, which is the same or different, is independently selected from H and unsubstituted C₁-C₄ alkyl.

In such mixtures the PEGylated phospholipids may be phospholipids of the following formula (II) 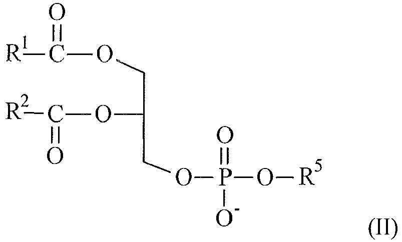 wherein:
R¹ and R² are as defined above for the phospholipids of formula (I), and R⁵ is a group which comprises poly(ethylene glycol).
R⁵ may be -CH₂CH₂NHC(O)-(OCH₂CH₂)_{q}OCH₃, -CH₂CH₂NHC(O)(CH₂)₃C(O)-(OCH₂CH₂)_{q}OCH₃, -CH₂CH₂NHC(O)-(OCH₂CH₂)_{q}OH, or -CH₂CH₂NHC(O)(CH₂)₃C(O)-(OCH₂CH₂)_{q}OH, wherein q is an integer from 5 to 10,000.

The PEGylated phospholipids may comprise a PEG group, and the PEG group may have the formula a -(O-CH₂CH₂)_{q}-O-R group, wherein R is H or methyl and q is a positive integer. The integer q may for instance be from 5 to 10,000, or for instance from 10 to 1,000, preferably from 10 to 1,000, more preferably from 30 to 60.

In any such mixtures, the non-PEGylated phospholipids may comprise DPhPC.

In any such mixtures, the PEGylated phospholipids may comprise DPPE-mPEG2000.

In any such mixtures, the phospholipids may comprise DPhPC and DPPE-mPEG2000, and wherein the phospholipids comprise from 2.5 to 15 mol% of DPPE-mPEG2000. Preferably, from 5 to 15 mol% of the phospholipids may be DPPE-mPEG2000. More preferably, from 7.5 to 15 mol% of the phospholipids may be DPPE-mPEG2000. Even more preferably, from 10 to 15 mol% of the phospholipids may be DPPE-mPEG2000, for instance 10 or 15 mol% of the phospholipids may be DPPE-mPEG2000.

Aqueous objects as defined herein comprising an aqueous medium may further comprise a mixture of phosholipid molecules on at least part of the surface of the aqueous object, wherein the mixture of phosholipid molecules is a mixture of non-PEGylated phospholipids and PEGylated phospholipids as defined above. The phosholipid molecules may encapsulate the aqueous object. The aqueous object, may be any aqueous droplet defined herein or any hydrogel object as defined herein.

The aqueous object or objects may be disposed in a hydrophobic medium in order for at least part of the surface of the aqueous object or objects to comprise amphipathic molecules. The aqueous object or objects may be then transferred to the array. Alternatively or additionally, the array may further comprise a hydrophobic medium. In such embodiments the first aqueous objects may be disposed in the medium and/or the second aqueous objects may be disposed in the hydrophobic medium. The scaffold may be partially or completely disposed in the hydrophobic medium. The droplet assembly may be partially or completely disposed in the hydrophobic medium. The hydrophobic medium may comprise an oil. The oil may comprise a silicone oil, a hydrocarbon, or a fluorocarbon, or a mixture of two or more thereof. The hydrophobic medium may comprise a mixture of a hydrocarbon and silicone oil. The hydrophobic medium may comprise a mixture of a hydrocarbon and silicone oil comprising a ratio of hydrocarbon:silicone oil of from 80:20 to 20:80 by volume, or from 70:30 to 30:70 by volume. The ratio of hydrocarbon: silicone oil is preferably in a ratio of from 60:40 to 40:60 by volume, for instance 50:50 to 40:60. The ratio is preferably 50:50, 40:60 or 45:55 by volume. The hydrocarbon may be a C₁₀-C₂₀ alkane, preferably a hexadecane.

In some embodiments, the hydrophobic medium comprises a mixture of undecane and silicone oil. The undecane and silicone oil may be present at a ratio of35:65. In some embodiments, the non-PEGylated phospholipids may comprise DPhPC and in a mixture of undecane and silicone oil at a ratio of 35:65, optionally, wherein DPhPC is at a concentration of 10 mg/ml.

The concentration of amphipathic molecules may be any suitable concentration.

Typically, the concentration of amphipathic molecules is less than or equal to 15 mg mL⁻¹. For instance, the concentration of amphipathic molecules may be from greater than 0 to 10 mg mL⁻¹. The concentration of amphipathic molecules may be from 0.25 mg mL⁻¹ to 10 mg mL⁻¹, for instance, from 0.25 mg mL⁻¹ to 5 mg mL⁻¹. The concentration of amphipathic molecules may be from 0.25 mg mL⁻¹ to 2.5 mg mL⁻¹, for instance, from 0.25 mg mL⁻¹ to 1.5 mg mL⁻¹.

In some embodiments, the concentration of amphipathic molecules is about 10 mg mL⁻¹.

The concentration of amphipathic molecules can be changed in order to control whether or not an interface between aqueous objects comprises a bilayer of amphipathic molecules. High concentrations ensure an interface will comprise a bilayer of amphipathic molecules. Increases in the concentration of amphipathic molecules may therefore be used to increase the number of interfaces comprising a bilayer of amphipathic molecules and decrease the number of interfaces that do not comprise a bilayer of amphipathic molecules. Decreasing the concentration of amphipathic molecules may be used to decrease the number of interfaces comprising a bilayer of amphipathic molecules. For example, increasing the concentration of amphipathic molecules may be used to increase the number of interfaces at which two aqueous objects are in physical contact.

As the skilled person will appreciate, the concentration of amphipathic molecules required for the formation of a bilayer at an interface may depend upon the size and shape of the aqueous object or objects.

Further, changing the concentration of amphipathic molecules is not the only way to control whether or not an interface comprises a bilayer of amphipathic molecules. For example, a bilayer of amphipathic molecules between two aqueous objects may be removed by pushing together the two objects, in order to "squeeze out" the bilayer from between the two objects and/or prevent a bilayer from being formed between the objects. Thus, the concentration of amphipathic molecules may not be the only factor that dictates whether a bilayer is formed.

Typically, the concentration of amphipathic molecules is less than or equal to 15 mg mL⁻¹. For instance, the concentration of amphipathic molecules may be from 0 to 10 mg mL⁻¹.

In some embodiments, the concentration of amphipathic molecules is usually equal to or greater than 0.5 mg mL⁻¹. For instance, the concentration of amphipathic molecules may be equal to or greater than 5 mg mL⁻¹. Usually, the concentration of amphipathic molecules is from 0.5 mg mL⁻¹ to 15 mg mL⁻¹, for instance, from 5 mg mL⁻¹ to 15 mg mL⁻¹. In order for a bilayer to form at an interface, the concentration of amphipathic molecules usually needs to be equal to or greater than 1 mg mL⁻¹, for instance equal to or greater than 5 mg mL⁻¹.

The concentrations of amphipathic molecules referred to in the previous paragraphs are typically the concentrations of the amphipathic molecules in the hydrophobic medium, i.e. in the hydrophobic medium in which the aqueous objects are disposed.

When a hydrophilic material is placed in a medium comprising amphipathic molecules, the hydrophilic component of the amphipathic molecules will be attracted to the hydrophilic material. Thus a layer of amphipathic molecules will form on at least part of the surface of the hydrophilic material. Typically, the medium is a hydrophobic medium. When the concentration of amphipathic molecules in the medium is high enough, the layer will usually be a monolayer that covers the entire surface of the hydrophilic material. The concentration of amphipathic molecules required to form a monolayer will depend on factors such as the surface area of the hydrophilic material and whether or not there are other hydrophilic materials in the same medium. There may be other factors that influence whether a monolayer of amphipathic molecules is formed. For instance, if the hydrophilic material has a particularly intricate shape, it may only be possible for a layer to form on part of the surface of the hydrophilic material.

In the present invention, the individual aqueous objects such as aqueous droplets and hydrogel objects comprise a hydrophilic material. As discussed herein, the aqueous objects may be disposed in a hydrophobic medium and this hydrophobic medium typically comprises amphipathic molecules. If so, at least part of the surface of the aqueous object or objects comprise amphipathic molecules from the hydrophobic phase form. An outer layer of amphipathic molecules may form on the aqueous object or objects. The entire of the aqueous object may comprise an outer layer of amphipathic molecules. The scaffold may comprise no outer layer of amphipathic molecules. Typically, when the aqueous object comprises an aqueous droplet the entire surface of aqueous droplet may comprise an outer layer of amphipathic molecules.

Typically, the concentration of amphipathic molecules is the concentration of amphipathic molecules in the hydrophobic medium.

Additionally or alternatively, when the aqueous object or objects are formed, the aqueous medium of the aqueous object or objects may comprise amphipathic molecules. The concentration of amphipathic molecules may therefore be the concentration of amphipathic molecules in the aqueous medium.

The hydrophobic medium may be selected from a wide range of materials. The hydrophobic medium may comprise a single hydrophobic compound. Alternatively, it may comprise a mixture of two or more different hydrophobic compounds. The hydrophobic medium may, for instance, be selected to affect the buoyancy of the aqueous object or objects and the speed of formation of the layer of amphipathic molecules around at least part of the aqueous object or objects after the aqueous object or objects are first introduced into the hydrophobic medium.

The hydrophobic medium is typically an oil. The oil may be a single, pure, compound, or the oil may comprise a mixture of two or more compounds. It is usually desirable that the oil does not significantly destabilize any bilayers formed.

The oil may for instance comprise silicone oil (for instance poly phenyl methyl siloxane). The oil may consist of a single silicone oil, for instance poly phenyl methyl siloxane. Alternatively, the oil may comprise a mixture of two or more different silicone oils.

Any suitable silicone oil may be used. For instance, the oil may comprise silicon oil DC200 (a polymer comprising monomer units of -O-Si(CH₃)₂-), poly(dimethylsiloxane) (PDMS), hydroxy terminated, or PDMS 200.

Additionally or alternatively, the oil may comprise a hydrocarbon. When the oil comprises a hydrocarbon it may comprise a single hydrocarbon compound, or a mixture of two or more hydrocarbons.

In some embodiments, the oil is a mixture comprising: (a) one or more hydrocarbons, and (b) one or more silicone oils. The hydrocarbon may, for instance, be any suitable liquid hydrocarbon. Whether a particular hydrocarbon is liquid will depend upon the temperature of the hydrophobic medium. Thus the term liquid hydrocarbon refers to a hydrocarbon that is a liquid at the temperature that the hydrophobic medium is at. Typically, the hydrophobic medium will be at room temperature. However, in some embodiments, the hydrophobic medium may be above or below room temperature.

The oil may comprise a solid. A solid hydrocarbon may, for instance, be used in combination with a silicone oil. The oil may, for instance, be a mixture of solids that dissolve to form a liquid.

When the oil comprises a hydrocarbon, the hydrocarbon may be branched or unbranched, for example a hydrocarbon having from 5 to 40 carbon atoms, or from 5 to 30 carbon atoms (although hydrocarbons of lower molecular weight would require control of evaporation). Preferably, the hydrocarbon is a liquid at the operating temperature of the array of the invention. Suitable examples include alkanes or alkenes, such as hexadecane, decane, pentane or squalene. Usually, the oil comprises a hydrocarbon.

Typically the hydrocarbon is an unsubstituted C₁₀-C₂₀ alkane, for instance hexadecane.

Shorter alkanes may be suitable, for instance, in arrays for which buoyancy effects are less important and whose outer layer of amphipathic molecules, on at least part of the surface of the aqueous object or objects, may form more quickly.

In some embodiments the hydrocarbon is a longer-chain hydrocarbon, such as an unsubstituted C₁₅-C₄₀ alkane. For instance, an unsubstituted C₁₆-C₃₀ alkane chain, such as squalene.

In one embodiment, the hydrophobic medium comprises an unsubstituted C₁₀-C₂₀ alkane and the amphipathic molecules comprise one or more glycerophospholipids. For instance, the hydrophobic medium may comprise hexadecane and the outer layer of amphipathic molecules may comprise DPhPC.

Other types of oil are possible. For example the oil may be a fluorocarbon. This might be useful for the study of some systems, for example to minimise loss of a particular membrane protein or analyte from the aqueous object or objects or to control gas content such as oxygen. Because fluorocarbons can be both hydrophobic and lipophobic, an oil phase that comprises fluorocarbons can usefully prevent the adhesion of aqueous object or objects to surfaces.

In another embodiment, the hydrocarbon is a bromo-substituted C₁₀-C₃₀ alkane, or for instance a bromo-substituted C₁₀-C₂₀ alkane, e.g. bromododecane. Although bromododecane was found to require long incubation times for the formation of an outer layer of amphipathic molecules, on at least part of the surface of the aqueous object this oil should be more suitable for other aqueous objects whose outer layer of amphipathic molecules, on at least part of the surface of the aqueous object, may incubate more quickly.

Typically, the oil comprises silicone oil or a hydrocarbon. Any suitable silicone oil may be employed. Usually, the silicone oil is as herein defined.

Silicone oil is advantageous on account of its density being close to that of water, which ensures that an aqueous object, such as a droplet, is approximately neutrally buoyant in water. The silicone oil may for instance be poly phenyl methyl siloxane, which has a density of about 1 g.cm⁻³.

The hydrocarbon typically has from 5 to 30 carbon atoms (a C₅-C₃₀ hydrocarbon), more typically from 10 to 30 carbon atoms (a C₁₀-C₃₀ hydrocarbon). Typically, it is an alkane or an alkene. Thus, the hydrocarbon may be a C₅-C₃₀ alkane, or a C₁₀-C₂₀ alkane. In another embodiment, the hydrocarbon may be a C₅-C₂₀ alkene, or a C₁₀-C₂₀ alkene. The hydrocarbon is typically unsubstituted. In one embodiment it is squalene. In a preferred embodiment, the hydrocarbon is an unsubstituted C₅-C₂₀ alkane, preferably an unsubstituted C₁₀-C₂₀ alkane. The hydrocarbon may for instance be squalene, hexadecane or decane. However, in some embodiments the hydrocarbon may be substituted with a halogen atom, for instance bromine.

In some embodiments, the hydrophobic medium comprises a mixture of silicone oil and a hydrocarbon. Such mixtures have been found to provide advantageously low incubation times for stable objects, such as droplets, to be formed. The silicone oil and hydrocarbon in the mixture may be as further defined above. Typically, the hydrocarbon is an unsubstituted C₁₀-C₂₀ alkane, preferably hexadecane. The silicone oil and hydrocarbon mixture typically has a density close to that of water, to ensure an aqueous object, such as a droplet, has approximately neutral buoyancy in aqueous media; it may for instance be poly phenyl methyl siloxane. Usually, the volume ratio of the silicone oil to the hydrocarbon is equal or greater than 0.5:1. The volume ratio of the silicone oil to the hydrocarbon may for instance be from 0.5:1 to 5:1, preferably about 1:1. In some embodiments, the volume ratio of the silicone oil to the hydrocarbon is equal or greater than 5:1.

The hydrophobic medium employed may, for instance, have a density close to that of water, for instance a density of about 1 g.cm⁻³, such that an aqueous object, such as a droplet, is approximately neutrally buoyant in water.

In one embodiment, the hydrophobic medium comprises both silicone oil and hexadecane. Typically the silicone oil is poly phenyl methyl siloxane. The volume ratio of the silicone oil to the hexadecane is typically equal or greater than 0.5:1, for instance from 0.5:1 to 5:1. It may for instance be preferably about 1:1. In some embodiments, the volume ratio of the silicone oil to the hydrocarbon is equal or greater than 5:1.

Preferably, the hydrophobic medium comprises hexadecane. In some embodiments, the hydrophobic medium further comprises silicone oil.

Typically, the hydrophobic medium comprises hexadecane and the amphipathic molecules comprise DPhPC. More typically, the hydrophobic medium comprises hexadecane, the amphipathic molecules comprise DPhPC and the aqueous medium comprises an aqueous buffer solution.

The interface(s) between first and second aqueous objects, such as aqueous droplets or hydrogel objects, may further comprise a protein, preferably a membrane protein. The protein may be dispersed in the interface, preferably in the bilayer. The membrane protein may be of any type. The use of integral membrane proteins has been demonstrated, but it is equally expected that peripheral membrane proteins could be used. The membrane protein can allow electrical communication, for example, by allowing electrical current between the first and second aqueous object. The membrane protein may allow an ion flux between the first and second aqueous object. The membrane protein may be a protein which can passively or actively transport ions across an interface such as a bilayer. The membrane protein may for instance be a membrane pump, channel, pore, receptor and/or transporter to allow for precise control over the exchange of material, and electrical communication, between the aqueous objects.

Aqueous objects can exchange chemical species, such as ions, with each other through membrane proteins incorporated in the bilayer between the objects. The ions may be protons, chloride ions, sodium ions, calcium ions or potassium ions. Suitable membrane proteins include, but are not limited to, pumps, channels, pores, receptor proteins, and/or transporter proteins, for instance an α-hemolysin (αHL) pore.

Suitable membrane proteins which allow for exchange of materials and electrical communication are known and readily available to the skilled person; many such proteins are either commercially available or can be prepared by known methods. For instance, WT αHL monomers can be prepared by in vitro transcription-translation (IVTT), and heptamerised by incubation with rabbit red blood cell membranes. The heptamers are typically purified by sodium dodecyl sulphate polyacrylamide gel electrophoresis (SDS-PAGE) (Maglia, G. et al. Method. Enzymol. 475, 591-623, 2010). Also, Bayley, H. et al. Droplet interface bilayers. Mol. BioSyst. 4, 1191-1208 (2008) lists several proteins that were tested for insertion into droplet interface bilayers made in bulk oil.

Preferably all or substantially all of the membrane proteins are in the same orientation in the bilayer so that the ions flow in the same direction across the bilayer.

The membrane protein is preferably a protein which is sensitive to electromagnetic radiation such as light. The protein is preferably light-sensitive protein. A light-sensitive protein may be a protein that can be stimulated or activated by light. The wavelength of light which stimulates the protein will be protein dependent. The wavelength of light may be inside or outside the human visible spectrum. The light may be in the UV-visible range or in the near infrared window. The wavelength may be from 10 to 900 nm, 100 to 800 nm, 200 to 800 nm, 300 to 700 nm or 390 to 700 nm, for example about 560nm. By being sensitive to a particular wavelength or range of wavelengths, the protein may be sensitive to a particular colour in the human visible spectrum.

The membrane protein is preferably a light-sensitive ion channel, a light-sensitive ion pump, a light-sensitive protein pore, a light-sensitive receptor protein, and/or light-sensitive transporter protein. Being light-sensitive, the application of light may stop or start an ion flux across the membrane or interface in which the membrane protein resides. For example, the application of light may cause a light-sensitive channel to open or close, a light-sensitive pore to open or close, or a light-sensitive pump to start or stop pumping (e.g. ions), or a light-sensitive transported to start to stop transporting (e.g. ions). Such a protein may also be referred to as light-gated or light-driven. The membrane protein may be a light-sensitive ion channel such as a chloride ion channel, sodium ion channel, calcium ion channel or a potassium ion channel. The protein may be a cation channel or an anion channel. The protein is preferably a light-sensitive proton pump. The protein may be a photoreceptor protein, such as a retinylidene protein, flavoprotein or biliprotein. The protein may be photopsin I, photopsin II, photopsin III or melanopsin. The protein is preferably a rhopdopsin, bacteriorhodopsin, halorhodopsin, archaerhodopsin or leptosphaeria. The protein is more preferably bacteriorhopsin. The bacteriorhodopsin can be derived from *Halobacterium salinarum.* The protein may be an algal protein. The protein may be a light-gated cation channel, such as Channelrhodopsin-2. The protein may be light-gated proton channel, such as Channelrhodopsin-1. The protein may be the light-driven chloride pump, such as halorhodopsin from the archaebacterium *Natronomas pharaonis.* The protein may be a chromophore.

The protein may also be any of the light-sensitive proteins described herein which has undergone mutagenesis. In such an embodiment the protein may be sensitive to a different wavelength of light. The protein may be a variant of any of the proteins described herein. The protein may have at least 60% sequence identity to the corresponding sequence of protein described herein. More preferably, the identity is at least 65%, at least 70%, at least 75%, at least 80%, at least 85%, at least 90%, at least 95%, at least 97%, at least 98% or at least 99%. The protein may be a codon-optimised form of any of the suitable proteins described herein.

Preferably the membrane protein in the interface is derived from the first aqueous objects. In such an embodiment, when the bilayer forms between the first and second aqueous objects, the proteins are all or substantially all inserted in the same orientation. Thus any ion flow will be in the same, or substantially same, direction across the bilayer.

When forming the array, the membrane protein is preferably comprised in the first aqueous objects and not the second aqueous object or objects.

Since the protein is present in the bilayer interface, it can adopt its natural conformation. Prior devices use light sensitive proteins (e.g. references 16 to 20) which are dried or only temporarily hydrated. The lifespan of the prior devices is therefore short as the protein is prone to stop functioning. The present array allows the protein to be fully hydrated and in its natural conformation. Thus the protein is stable and the lifespan of the array can be much longer.

The cells, as described herein, may comprise a voltage-sensitive membrane protein. In such embodiments, if there is an ion flux between the first and second aqueous objects, for example following exposure to light, this will generate a current which can stimulate the voltage-sensitive membrane protein. Therefore the array may be used to stimulate voltage-sensitive membrane proteins. Stimulating the voltage-sensitive membrane protein may activate or inactive the voltage-sensitive membrane protein. The stimulation may, for example, open or close the voltage-sensitive membrane protein. The stimulation may, for example, start or stop the voltage-sensitive membrane protein. The voltage-sensitive membrane protein may be a protein which can passively or actively transport ions across a cell membrane. The voltage-sensitive membrane protein may be an ion channel, ion pump, ion pore or ion transporter. The stimulation may stop or start an ion flux across the membrane of the cell, as described herein, such as a neural cell. The stimulation may increase or decrease an ion flux. The ions may be any suitable ions, such as protons, calcium ions, potassium ions, chloride ions or sodium ions. As described herein, the ion flux between the first and second aqueous objects may stimulate the cell as described herein, such as a neural cell. The protein may be a variant of any of the voltage-sensitive membrane proteins described herein. The voltage-sensitive membrane protein may have at least 60% sequence identity to the corresponding sequence of protein described herein. More preferably, the identity is at least 65%, at least 70%, at least 75%, at least 80%, at least 85%, at least 90%, at least 95%, at least 97%, at least 98% or at least 99%. The voltage-sensitive membrane protein may be a codon-optimised form of any of the suitable proteins described herein.

The bilayer at an interface between contacting aqueous objects, may comprise more than one membrane protein. The cells may comprise more than one membrane protein. For instance, a particular bilayer may contain multiple copies of the same membrane protein, or two or more different classes of membrane proteins. Where more than one class is present, the bilayer may contain multiple copies of each different class.

When a bilayer comprises a membrane protein, said bilayer might comprise two or more membrane proteins. The membrane proteins may be the same or different. The number of membrane proteins in a bilayer may be determined by analysing the conductivity.

When there are two or more bilayers, each bilayer may further comprise a membrane protein, wherein each of said membrane proteins is as herein defined. For instance, each bilayer may further comprise a membrane protein, wherein each of said membrane proteins is as herein defined.

Usually, the concentration of membrane proteins, such as the proteins that allow electrical communication (e.g. light-sensitive proteins), is equal to or greater than 10 ng mL⁻¹. For instance, the concentration of membrane proteins may be equal to or greater than 50 ng mL⁻¹. The concentration of membrane proteins may be from 10 ng mL⁻¹ to 3000 µg mL⁻¹, for instance from 50 ng mL⁻¹ to 2000 µg mL⁻¹. In some embodiments, the concentration of membrane proteins is about 2000 µg mL⁻¹. The concentration of membrane proteins may be from 75 ng mL⁻¹ to 1000 µg mL⁻¹, for instance from 80 ng mL⁻¹ to 85 µg mL⁻¹. In some embodiments, the concentration of membrane proteins is about 83 µg mL⁻¹. In other embodiments, the concentration of membrane proteins is about 830 ng mL⁻¹. In a further embodiment, the concentration of membrane proteins is about 83 ng mL⁻¹. The concentration of membrane proteins may be from 1000 µg mL⁻¹ to 3000 µg mL⁻¹, for instance from 1500 µg mL⁻¹ to 2500 µg mL⁻¹. The concentration of membrane proteins may be from 1800 µg mL⁻¹ to 2200 µg mL⁻¹, for instance from 1900 µg mL⁻¹ to 2100 µg mL⁻¹. In some embodiments, the concentration of membrane proteins is about 2 mg mL⁻¹.

Typically, the concentration of membrane proteins is the concentration of membrane proteins in the aqueous medium of the aqueous object, when the aqueous object is formed. The aqueous object may be an aqueous droplet. Thus the aqueous droplet may have any of the membrane concentrations described herein. For example, the concentration may be from 10 ng mL⁻¹ to 3000 µg mL⁻¹, for instance from 50 ng mL⁻¹ to 2000 µg mL⁻¹. The concentration of may be from 1000 µg mL⁻¹ to 3000 µg mL⁻¹, for instance from 1500 µg mL⁻¹ to 2500 µg mL⁻¹. The concentration of may be from 1800 µg mL⁻¹ to 2200 µg mL⁻¹, for instance from 1900 µg mL⁻¹ to 2100 µg mL⁻¹. The concentration is preferably about 2 mg mL⁻¹. When an aqueous object, such as a droplet comprising a membrane protein is contacted with another droplet (which may or may not comprise a membrane protein), a bilayer of amphipathic molecules if formed at the interface. That bilayer typically comprises a membrane protein. Therefore a membrane protein initially in the aqueous medium may move to the bilayer. Preferably the membrane protein is present in the first aqueous objects and not the second aqueous object or objects before the interface is formed so that the proteins all or substantially all of the proteins in the bilayer are in the same orientation.

The array may be in contact with a first and/or a second communication means. The array may comprise the first and/or the second communication means. The definitions of the communication means defined herein can apply independently to each of the first communication means described herein and the second communication means described herein, unless stated otherwise. The first and second communication means may be insulated from each other. In such an embodiment the first and second communication means are not in electrical contact and may not be in physical contact.

The communication means can be conductive. As described herein, the communication means may be in electrical and/or physical contact with the aqueous object. The first communication means may be in electrical contact with the first aqueous object. The second communication means may be in electrical contact with the second aqueous object. The first communication means may be in physical contact with the first aqueous object. The second communication means may be in physical contact with the second aqueous object.

By being in 'electrical contact', the communication means can detect current flow between the first and second aqueous objects. The current flow can be due to ion flux. Preferably a membrane protein is present in the interface between each first and second aqueous object. Any of the suitable membrane proteins described herein can be present. Appropriate membrane proteins can actively (e.g. by pumping) or passively allow ions to pass between the aqueous objects, creating the ion flux. When enough ion flux is generated, an electrical signal can be detected by the communication means.

There may be a plurality of first communication means and/or second communication means. There may be at least two, three, four, five, six, seven, eight, nine, ten, 11, 12, 13, 14, 15, 16, 17, 18, 19, 20, 21, 22, 23, 24, 25, 26, 27, 28, 29, 30, 31, 32, 33, 34, 35, 36, 37, 38, 39, 40, 41, 42, 43, 44, 45, 46, 47, 48, 49, 50, 51, 52, 53, 54, 55, 56, 57, 58, 59, 60, 61, 62, 63, 64, 65, 66, 67, 68, 69, 70, 71, 72, 73, 74, 75, 76, 77, 78, 79, 80, 81, 82, 83, 84, 85, 86, 87, 88, 89, 90, 91, 92, 93, 94, 95, 96, 97, 98, 99, 100, 121, 144, 169, 196, 225, 500, 1000 or more first communication means and/or second communication means. The array may comprise or be in contact with at least n of said first communication means. n is equal to or greater than 2. The integer n may be equal to or greater than 3. n may be equal to or greater than 4. The integer n can in principle be high, for instance in the order of hundreds of thousands. This is because there is no upper limit on the size of the array. Such arrays, may, for instance, be useful for preparing prototissue such as a synthetic retina. n may be several hundred, for instance up to about 500 or 1000, or for instance up to about 400. The integer n may for instance be an integer of from 2 to 500, or an integer of from 3 to 500. n may be an integer of from 2 to 400. In other embodiments, n may be an integer of from 2 to 300, or an integer of from 3 to 200. n may be from 2 to 200. In other embodiments, however, n is an integer of from 2 to 50, or an integer of from 3 to 50. n may for instance be from 2 to 20. The array may comprise or be in contact with at least n of said second communication means.

In some embodiments, preferably there is a single common second communication means. Preferably the single common second communication means is in electrical contact with the single common second aqueous object as defined herein. In some embodiments, preferably the single common second aqueous object is a scaffold. The single common second communication means may be in physical contact with the single common second aqueous object. In some embodiments, preferably there are a plurality of first communication means and a plurality of first aqueous objects. There may be an equal number of first communication means and first aqueous objects. Preferably each first aqueous object is in electrical contact with a single different first communication means. Each first aqueous object may be in physical contact with a single different first communication means. The first communication means may be inserted into the first aqueous object, for example, a single different first communication means may be inserted into each first aqueous object. The second communication means may be inserted into the second aqueous object, for example, a single communication means may be inserted into the or each second aqueous object. Preferably the single common second communication means is inserted in the single common second aqueous object.

By the single common second communication means being in electrical contact with the single common second aqueous object, for each first aqueous object which each form an interface with the single common second aqueous object, the single common second communication means together with each first communication means can detect current flow between each first aqueous object and the single common second aqueous object. This embodiment means that only one second communication means is required to detect the current flow between each first aqueous object and the single common second aqueous object. The current output from each first aqueous object can be detected individually and simultaneously without the need for individual second communication means and individual second aqueous objects. Such an arrangement is more straight forward to manufacture.

The current flow between the first and second aqueous object can be measured. When measuring the current flow, a 1 pA cut-off can be applied. Current above 1 pA can be considered 'ON' and below 1 pA can be considered 'OFF', providing a binary system. Thus, when determining whether, for example, the membrane protein has been stimulated, a current flow of above 1 pA can be used as an indicator that the membrane protein has been stimulated.

The communication means are preferably electrodes. The first communication means may be a first electrode and the second communication means may be a second electrode. The electrodes may be connected to a circuit. The electrodes may be connected to an amplifier, for example a multichannel amplifier. The electrodes can record current.

The circuit may be a printed circuit. The circuit may be printed on, for example, hydrogel, glass or plastic. For a biologically compatible array, the circuit is preferably printed on a biologically compatible material, such as hydrogel.

The electrodes can detect the ion flux generated by the appropriate membrane proteins as described herein. The electrodes may comprise an inert material such as silver, platinum, palladium, gold or carbon. The electrodes may comprise Ag/AgCl or Cu-CuSO₄. The electrodes are typically electrochemically reversible electrodes. Usually, the first electrode and/or the second electrode comprises an electrochemically active electrode such as a Ag/AgCl electrode.

The electrodes may comprise a high work function metal (for instance gold, silver, nickel, palladium or platinum) used in conjunction with an electrochemically active mediator such as ferrocyanide. For instance, a redox couple, or a member of a redox couple which may be partially oxidised or reduced to provide the redox couple, may be used. Suitable redox couples include those known in the art such as Fe²⁺/Fe³⁺, ferrocene/ferrocium or Ru²⁺/Ru³⁺. Examples of such are ferro/ferricyanide, ruthenium hexamine and ferrocene carboxylic acid.

The electrodes may be of any convenient diameter. The electrode diameter may typically be any diameter in the range of 50 µm to 500 µm.

The electrodes can be used to measure current. Each current output from each first aqueous object can be detected individually and simultaneously. Current outputs can be combined from each first aqueous object. Combining the output currents can determine the shape of the light beam on the array. When the array comprises the single common second aqueous object which is in electrical contact with the single common second electrode, the current output from each first aqueous object can be detected individually and simultaneously without the need for individual second electrodes. In such an embodiment, by interfacing all the first aqueous objects with the single common second aqueous object the current output from each first aqueous object can still be measured individually and simultaneously. Such an arrangement is much more straight-forward to manufacture than having a corresponding second aqueous object and second electrode for each first aqueous object.

The communication means may be the cells as described herein. For example, the second communication means may be the cells as described herein. As described herein, the cell may be a biological cell, such as a neural cell, a synthetic cell or a protocell.

The communication means may not be the aqueous object as defined herein. The first and/or second communication means may not be the aqueous object as defined herein.

The electrochemical circuit of the invention comprises the array of the invention and, in the electrochemical circuit, current may be carried through the array by ions.

The electrochemical circuit of the invention may comprise two or more first communication means which are in, at least, electrical contact with the first aqueous objects, and one or more second communication means which are in, at least, electrical contact with the second aqueous object or objects. The communication means and aqueous objects may be any as defined herein and may be in any arrangement as defined herein. For example, each first aqueous object may be in electrical communication with a different individual first communication means and preferably the single common second communication means is in electrical contact with the single common second aqueous object.

The electrochemical circuit of the invention may comprise electrodes such as those described herein. The electrochemical circuit may comprise two or more first electrodes which are in, at least, electrical contact with the first aqueous objects, and one or more second electrodes which are in, at least, electrical contact with the second aqueous object or objects. Each first aqueous object may be in electrical contact with a different individual first electrode and, preferably, the second common aqueous object is in electrical contact with the second electrode. The electrodes are typically in contact with different objects.

The electrochemical circuit of the invention may comprise further aqueous objects as described herein.

In some embodiments, in the electrochemical circuit of the invention, at least one of said aqueous objects is a hydrogel body comprising a hydrogel wire. The hydrogel wire, or wire-shaped hydrogel body, is typically as herein defined. In some embodiments, at least two of said hydrogel objects is a hydrogel wire.

The electrochemical circuit may comprise many such wires that link together in the circuit. In this way complete circuits can be built up. Thus, for instance, all of the hydrogel bodies in the electrochemical circuit may be hydrogel wires.

The electrochemical circuit of the invention may further comprise a hydrophobic medium, wherein part or all of the array is in contact with the hydrophobic medium.

In some embodiments, the array may be on the surface, as described herein, which the array can be placed on and can be used to support the aqueous objects as defined herein. The surface can be non-conducting. Alternatively the surface may comprise a printed circuit such as those described herein.

The present invention also provides a method for semi-solubilising a membrane fraction comprising a membrane protein, wherein the method comprises:
- sonicating a first suspension comprising the membrane fraction in the presence of a detergent;
- centrifuging the sonicated first suspension to form a first pellet comprising the membrane protein;
- disposing of the supernatant;
- re-suspending the first pellet to form a second suspension; and
- centrifuging the second suspension to form a second pellet comprising the membrane protein.
The method may further comprise disposing of the supernatant following centrifugation to form the second pellet. The method may then further comprise re-suspending the second pellet to form a third suspension comprising the membrane protein.

By 'semi-solubilising', the membrane fraction is partly solubilised. In such an embodiment the membrane fragments do not completely dissolve in solution. The membrane fragments are broken down to smaller fragments.

The methods of the invention enable smaller membrane fragments to be obtained which comprise the membrane protein. The membrane fragments can be smaller than those which have been obtained previously (Reference 12). The smaller membrane fragments can be inserted more easily into the lipid bilayer. Therefore a higher concentration of membrane protein can be present in the lipid bilayer. Thus a single aqueous object, such as an aqueous droplet, can be used to generate enough ion flux to create a detectable electrical signal. At least three droplets have been required previously (Reference 12).

The invention further provides a method for preparing the aqueous droplet, as defined herein, comprising a membrane protein, wherein the method comprises:
- sonicating a first suspension comprising a membrane fraction, comprising the membrane protein, in the presence of a detergent;
- centrifuging the sonicated first suspension to form a first pellet comprising the membrane protein;
- disposing of the supernatant;
- re-suspending the first pellet to form a second suspension;
- centrifuging the second suspension to form a second pellet comprising the membrane protein;
- re-suspending the second pellet to form a third suspension comprising the membrane protein; and
- dropping the third suspension into a hydrophobic medium to form the aqueous object.

The aqueous droplet may be any aqueous droplet described herein. The hydrophobic medium may be any of the hydrophobic mediums described herein, such as a lipid-in-oil solution.

The method may further comprise disposing the supernatant after centrifuging the second suspension to form a second pellet and before re-suspending the second pellet to form a third suspension.

For the methods of the invention, the membrane fraction is a fraction of a cellular or subcellular membrane that comprises a protein of interest. The membrane fraction may be derived from a cell line. The membrane is preferably a purple membrane (PM). The PM may comprise bacteriorhodopsin. The PM may be derived from, for example, *Halobacterium salinarum.*

For the methods of the invention, the protein of interest may be any membrane protein. The membrane protein may comprise a single type of membrane protein. The membrane protein may be any protein described herein, for example, bacteriorhodopsin such as that from *Halobacterium salinarum.*

For the methods of the invention, a skilled person will readily know how to obtain a suspension comprising a membrane fraction. For example, lyophilized membrane can be suspended in an appropriate buffer. The detergent may be added prior to sonication. The detergent may be added subsequently to sonication and therefore detergent may not be present during the sonication. A skilled person will know the machinery and settings which can sonicate the first or second suspension. A skilled person will know the machinery and settings which can centrifuge the first or second suspension to form the first and second pellet, respectively. Preferably the first pellet and/or second pellet is re-suspended in a medium or buffer which does not comprise detergent. By 'disposing of the supernatant, the supernatant may be completely disposed of or as much supernatant as possible is disposed of before the pellet is disturbed. Thus when the pellet is re-suspended, a part of the supernatant may be present. The invention also provides an aqueous droplet made by the method of preparing an aqueous droplet of the invention.

The aqueous object or objects may comprise a promoter. A promoter refers to a stretch of polynucleotide sequences which comprise nucleotide sequences that promote transcription. Such nucleotide sequences may for example comprise one or more binding sites for one or more proteins which are required for transcription. The promoter can be any type of promoter. The promoter may be provided in isolated or purified form. The promoter comprises polynucleotide sequences, typically DNA, which initiates and regulates transcription. The promoter can be an inducible promoter where transcription is induced by, for example, an analyte, cofactor, regulatory protein, a repressible promoter where transcription is repressed by, for example, an analyte, cofactor, regulatory protein, or a constitutive promoter.

The promoter may be an activatable promoter which comprises one or more transcription inhibition moieties coupled to one or more components of the promoter. The one or more transcription inhibition moieties can inhibit transcription from the promoter. Therefore when the one or more transcription inhibition moieties are uncoupled from the promoter, transcription can be initiated from the promoter. The initiation of transcription may occur promptly after the uncoupling if the required transcriptional machinery is present. Alternatively, if one or more components of the transcriptional machinery are not present when the one or more transcription inhibition moieties are uncoupled, then transcription may be initiated at a later time once the further transcriptional components are provided. For example, the activatable promoter may comprise one or more inducible elements and may thus be an inducible promoter, and the promoter may not have been induced when the one or more transcription inhibition moieties are uncoupled.

As defined herein, an "activatable promoter" refers to a stretch of polynucleotide sequences which comprises nucleotide promoter sequences that promote transcription. Such nucleotide promoter sequences may for example comprise one or more binding sites for one or more proteins which are required for transcription. Thus, the activatable promoter can comprise polynucleotide sequences in addition to the nucleotide promoter sequences that promote transcription. Alternatively, the activatable promoter can consist of nucleotide promoter sequences that promote transcription. Consequently, transcription inhibition moieties may be coupled directly to components of nucleotide promoter sequences which comprise one or more binding sites for one or more proteins which are required for transcription. Alternatively, transcription inhibition moieties may be coupled to components of nucleotide sequences which are outside of a binding site for a protein which is required for transcription but nevertheless such coupling will inhibit transcription e.g. by sterically interfering with the binding of one or more proteins which are required for transcription. The activatable promoter can be a functional segment of a promoter.

The promoter can comprise or consist of promoter sequences derived from a prokaryote or eukaryote or other organism. For example, the promoter may comprise or consist of promoter sequences from, or derived from, bacteria, archaea, fungi e.g. yeast, a virus e.g. a bacteriophage, an animal e.g. a mammal, or a plant, or from related systems. The promoter can comprise or consist of a T7, *trc, lac, ara* or λ_{L} promoter. The promoter may comprise T7 promoter sequences, e.g. a T7 promoter. The promoter can, for example, comprise or consist of promoter sequences from cytomegalovirus (CMV) immediate early, herpes simplex virus (HSV) thymidine kinase, early and late SV40, long terminal repeats (LTRs) from retrovirus, or mouse metallothionein-I. The promoter can comprise or consist of pol I, pol II or pol II promoter sequences. Examples of suitable pol III promoter sequences include, but are not limited to, U6 and H1 promoters. Examples of suitable pol II promoter sequences include, but are not limited to, the retroviral Rous sarcoma virus (RSV) LTR promoter, the cytomegalovirus (CMV) promoter [see, e.g., Boshart et al, Cell, 41 :521-530 (1985)], the SV40 promoter, the dihydrofolate reductase promoter, the β-actin promoter, the phosphoglycerol kinase (PGK) promoter, and the EF1α promoter.

A polynucleotide, such as a nucleic acid, is a polymer comprising two or more nucleotides. The nucleotides can be naturally occurring or artificial or analogues thereof. A nucleotide typically contains a nucleobase, a sugar and at least one linking group, such as a phosphate, 2'O-methyl, 2' methoxy-ethyl, phosphoramidate, methylphosphonate or phosphorothioate group. The nucleobase is typically heterocyclic. Nucleobases include, but are not limited to, purines and pyrimidines and more specifically adenine (A), guanine (G), thymine (T), uracil (U) and cytosine (C). Nucleobases also include, but are not limited to, other natural and non-natural bases. The terms "nucleotide base" and "nucleobase" are used interchangeably herein. The sugar is typically a pentose sugar. Nucleotide sugars include, but are not limited to, ribose and deoxyribose. The nucleotide is typically a ribonucleotide or deoxyribonucleotide. The nucleotide typically contains a monophosphate, diphosphate or triphosphate and can be referred to herein as nucleotide phosphates. Phosphates may be attached on the 5' or 3' side of a nucleotide.

Nucleotides include, but are not limited to, adenosine monophosphate (AMP), adenosine diphosphate (ADP), adenosine triphosphate (ATP), guanosine monophosphate (GMP), guanosine diphosphate (GDP), guanosine triphosphate (GTP), thymidine monophosphate (TMP), thymidine diphosphate (TDP), thymidine triphosphate (TTP), uridine monophosphate (UMP), uridine diphosphate (UDP), uridine triphosphate (UTP), cytidine monophosphate (CMP), cytidine diphosphate (CDP), cytidine triphosphate (CTP), 5-methylcytidine monophosphate, 5-methylcytidine diphosphate, 5-methylcytidine triphosphate, 5-hydroxymethylcytidine monophosphate, 5-hydroxymethylcytidine diphosphate, 5-hydroxymethylcytidine triphosphate, cyclic adenosine monophosphate (cAMP), cyclic guanosine monophosphate (cGMP), deoxyadenosine monophosphate (dAMP), deoxyadenosine diphosphate (dADP), deoxyadenosine triphosphate (dATP), deoxyguanosine monophosphate (dGMP), deoxyguanosine diphosphate (dGDP), deoxyguanosine triphosphate (dGTP), deoxythymidine monophosphate (dTMP), deoxythymidine diphosphate (dTDP), deoxythymidine triphosphate (dTTP), deoxyuridine monophosphate (dUMP), deoxyuridine diphosphate (dUDP), deoxyuridine triphosphate (dUTP), deoxycytidine monophosphate (dCMP), deoxycytidine diphosphate (dCDP) and deoxycytidine triphosphate (dCTP), 5-methyl-2'-deoxycytidine monophosphate, 5-methyl-2'-deoxycytidine diphosphate, 5-methyl-2'-deoxycytidine triphosphate, 5-hydroxymethyl-2'-deoxycytidine monophosphate, 5-hydroxymethyl-2'-deoxycytidine diphosphate and 5-hydroxymethyl-2'-deoxycytidine triphosphate. The nucleotides may be selected from AMP, TMP, GMP, UMP, dAMP, dTMP, dGMP or dCMP.

The nucleotides may contain additional modifications. The modifications may be made to the nucleobase to form nucleotide base analogues. The modifications may be chemical or biochemical, or the nucleotide or nucleobase may be derivatized. In particular, modified nucleotides include, but are not limited to, 2'amino pyrimidines (such as 2'-amino cytidine and 2'-amino uridine), 2'-hyrdroxyl purines (such as , 2'-fluoro pyrimidines (such as 2'-fluorocytidine and 2'fluoro uridine), hydroxyl pyrimidines (such as 5'-α-P-borano uridine), 2'-O-methyl nucleotides (such as 2'-O-methyl adenosine, 2'-O-methyl guanosine, 2'-O-methyl cytidine and 2'-O-methyl uridine), 4'-thio pyrimidines (such as 4'-thio uridine and 4'-thio cytidine). Modified nucleotides also include, but are not limited to 5-pentynyl-2'-deoxy uridine, 5-(3-aminopropyl)-uridine and 1,6-diaminohexyl-N-5-carbamoylmethyl uridine.

The nucleotides in the polynucleotide may be attached to each other in any manner. The nucleotides may be linked by phosphate, 2'O-methyl, 2' methoxy-ethyl, phosphoramidate, methylphosphonate or phosphorothioate linkages. The nucleotides are typically attached by their sugar and phosphate groups as in nucleic acids. The nucleotides may be connected via their nucleobases as in pyrimidine dimers.

The polynucleotide can comprise a nucleic acid, such as deoxyribonucleic acid (DNA) or a ribonucleic acid (RNA). The polynucleotide may comprise any synthetic nucleic acid known in the art, such as peptide nucleic acid (PNA), glycerol nucleic acid (GNA), threose nucleic acid (TNA), locked nucleic acid (LNA), morpholino nucleic acid or other synthetic polymers with nucleotide side chains. The polynucleotide may comprise one or more singlestranded, double-stranded and/or multi-stranded region(s). The polynucleotide may be singlestranded, double-stranded or multi-stranded. The polynucleotide may comprise a gene, a gene fragment, an exon, an intron, genomic DNA, DNA-RNA hybrids, messenger RNA (mRNA), cDNA, recombinant polynucleotides, plasmids, vectors, isolated DNA of any sequence, isolated RNA of any sequence, nucleic acid probes, and primers. The polynucleotide sequence may comprise an open reading frame.

Polynucleotides can be synthesised according to methods well known in the art, as described by way of example in Sambrook et al (1989, Molecular Cloning - a laboratory manual; Cold Spring Harbor Press).

The activatable promoter comprises one or more transcription inhibition moieties coupled to one or more components of the promoter. The one or more components of the promoter may be any of the features of the promoter described herein. For example, the one or more components can be a nucleotide, nucleobase, phosphate or sugar such as those described herein. Preferably the one or more components of the promoter are bases of nucleotides. There is preferably a plurality of promoter components coupled to a plurality of transcription inhibition moieties.

There may be more than one, i.e. a plurality, of components of the promoter which are coupled to the transcription inhibition moieties. For example, there may be from 2 to 500, 2 to 250, 2 to 150, 2 to 50 or 2 to 10. There may be 2, 3, 4, 5, 6, 7, 8, 9 or 10. There may be one component of the promoter coupled to a transcription inhibition moiety.

The one or more transcription inhibition moieties are capable of inhibiting transcription from the promoter. They may decrease or completely prevent transcription. When coupled to one or more components of the promoter, the transcription inhibition moieties inhibit transcription, for example, by preventing one or more components of the transcriptional machinery from binding and/or performing its function. The binding may be directly or indirectly to the promoter or may be directly or indirectly to a region upstream or downstream of the promoter. The transcription inhibition moieties may inhibit transcription by sterically hindering one or more components of the transcriptional machinery. For example, the transcription inhibition moieties may prevent a protein binding to the promoter or a region upstream or downstream of the promoter. Alternatively or additionally, for example, the transcription inhibition moieties may prevent a protein-protein interaction.

There may be more than one, i.e. a plurality, of transcription inhibiting moieties present in the promoter. For example, there may be from 2 to 500, 2 to 250, 2 to 150, 2 to 50 or 2 to 10. There may be 2, 3, 4, 5, 6, 7, 8, 9 or 10. There may be one transcription inhibiting moiety present in the promoter.

If there is a plurality of transcription inhibition moieties, then there may also be a plurality of the components of the promoter coupled to the transcription inhibition moieties. There may be equal numbers of transcription inhibition moieties and components of the promoter coupled to the transcription inhibition moieties.

Any suitable molecule, or complex of molecules, may act as a transcription inhibition moiety. Suitably, a transcription inhibition moiety should readily be coupled to a component of the promoter using standard techniques known to the skilled person. Suitably, a transcription inhibition moiety should be sufficiently large to be able to interfere with one or more components of the transcription machinery so as to inhibit transcription. The moiety may typically comprise a protein or a complex of a protein and small molecule. However, the moiety could, for example, comprise any suitable molecule or combination of molecules provided that the molecules (or one of said combination) may be coupled to a component of the promoter using standard techniques and that the molecule or combination of molecules may interfere with one or more components of the transcription machinery so as to inhibit transcription. The transcription inhibition moieties preferably comprise a biotin:streptavidin complex. The streptavidin may be monovalent. The biotin is preferably coupled to the one or more components of the promoter. The transcription inhibition moieties may comprise an upconverting nanoparticle (UCNP). The transcription inhibition moieties may comprise digoxigenin (DIG) in complex with a DIG antibody. The transcription inhibition moieties may comprise both a biotin:streptavidin complex and digoxigenin (DIG) in complex with a DIG antibody.

By the one or more transcription inhibition moieties being "coupled" to one or more transcription inhibition moieties, this means the one or more transcription inhibition moieties are attached to the one or more transcription inhibition moieties in some manner. This attachment may be by covalent or non-covalent bonds. The attachment results in inhibition of the promoter. Conversely, when the one or more transcription inhibition moieties are "uncoupled" from the one or more transcription inhibition moieties, this means the one or more transcription inhibition moieties are sufficiently detached from the one or more transcription inhibition moieties so that the inhibition of transcription is reduced or removed.

The promoter being "configured to be activated" when the one or more transcription inhibition moieties are uncoupled from the promoter means that transciption from the promoter can be enhanced, begin or increase, compared to the inhibited state, once the one or more transcription inhibition moieties are uncoupled. Transcription may thus be increased by over 130 fold, for example up to 200 fold. Transcription may increase by, for instance, from 2 to 200 fold, from 10 to 180 fold, from 50 to 150 fold, or from 100 to 150 fold.

The uncoupling can be as a result of cleavage such as photocleavage. Thus the transcription inhibition moieties are preferably coupled to the one or more components of the promoter via one or more cleavable moieties. The one or more cleavable moieties may preferably be photocleavable. There may be more than one, i.e. a plurality, of cleavable moieties present in the activatable promoter. For example, there may be from 2 to 500, 2 to 250, 2 to 150, 2 to 50 or 2 to 10. There may be 2, 3, 4, 5, 6, 7, 8, 9 or 10. There may be one cleavable moiety present in the promoter. If there is a plurality of transcription inhibition moieties, then there may also be a plurality of cleavable moieties. There may be equal numbers of transcription inhibition moieties and cleavable moieties. There can be equal numbers of components of the promoter coupled to the transcription inhibition moieties, transcription inhibition moieties and cleavable moieties.

Cleavage of the cleavable moieties removes or reduces the inhibition of the promoter and therefore transcription can begin or increase from the promoter. Photocleavage occurs upon contacting the photocleavable moiety with or administration of or provision of electromagnetic radiation such as light, e.g. infra red, ultraviolet etc. Thus the term "light-activated DNA promoter" (LA-DNA promoter) refers to a promoter described herein which comprises any photocleavable moiety.

Any of the activatable promoters defined or described herein may comprise any suitable photocleavable moiety. For example, the photocleavable moiety may comprise a nitroaryl group. The photocleavable moiety may comprise a nitrobenzyl group, preferably a 2-nitrobenzyl. The photocleavable moiety may comprise a 4-methoxyphenacyl group, a 4,5-dimethoxy-2-nitrobenzyl group or a 3,5-dimethoxy-benzoin group such as those described in Stanton-Humphreys et al., 2012; "Wavelength-orthogonal photolysis of neurotransmitters in vitro"; Chem. Commun.; 48; 657-659.

The photocleavable moiety may comprise a C4'-dialkyl-amine-substituted heptamethine cyanine (as described in Gorka et al. 2014; "A Near-IR Uncaging Strategy Based on Cyanine Photochemistry"; Journal of the American Chemical Society; 136; 14153-14159), for example (modified from Gorka *et al.* 2014): 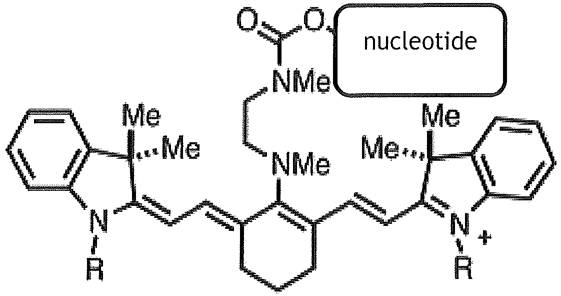 R is n-propyl (-CH₂CH₂CH₃) or -(CH₂)₄SO₃⁻. The transcription inhibition moieties may be attached to any suitable group on the C4'-dialkyl-amine-substituted heptamethine cyanine moiety.

The light administration or stimulation may directly or indirectly result in cleavage. For example, if the photocleavable moieties comprise a nitrobenzyl group and are treated with UV light, the UV light can act on the nitrobenzyl group resulting in cleavage of the photocleavable moieties. Alternatively, the light administration or stimulation may cause a component which may or may not be part of the photocleavable moieties to release light in the UV-visible light wavelength range. A suitable component is an upconverting nanoparticle (UCNP). The light in the UV-visible light wavelength range can then trigger cleavage of the photocleavable moieties, for example of a nitrobenzyl group. UCNPs take in infrared light to photocleave 2-nitrobenzene.

The wavelength of the electromagnetic radiation will be determined by the moiety being photocleaved and whether or not the moiety is being photocleaved directly or indirectly following electromagnetic radiation administration or stimulation. The electromagnetic radiation can be in the UV-visible light wavelength range, preferably UV light. The wavelength can be from 10 to 400 nm, 100 to 400 nm, 200 to 400 nm, 300 to 400 nm or 350 to 380 nm. Preferably the wavelength is 365 nm. The light can also be in the near infrared window. The wavelength can be from 650 to 900 nm, 650 to 800 nm, 650 to 750 nm, or 680 to 720 nm.

In any of the activatable promoters defined or described herein the cleavable moieties may further comprise a linker. The linker may couple the one or more transcription inhibition moieties and the one or more cleavable moieties to the one or more components of the promoter. Typically the one or more transcription inhibition moieties will be coupled to a cleavable moiety, the cleavable moiety will further comprise a linker and the linker may be coupled to the one or more components of the promoter, either directly or indirectly. Direct coupling may be for example by bonding the linker to the ring of a purine or pyrimidine base of a nucleotide, as described herein.

The linker may be a diamine linker. The diamine linker may be an alkyl-diamine linker selected from linkers of formula -N(H)(CH₂)ₙN(H)-, wherein n is a positive integer, for instance from 1 to 20 or from 1 to 12, preferably from to 8. The diamine linker is preferably 1,6-diaminohexane (-N(H)(CH₂)₆N(H)-). For example, when attached to a thymine, the linker and thymine forms a C6-amino-dT or a C6-amino-T. The linker may be an alkylene group - (CH₂)ₙ-, wherein n is a positive integer, for instance from 1 to 20 or from 1 to 12, preferably from to 8. The linker may be a -C(H)=C(H)C(O)N(H)(CH₂)ₙN(H)-, wherein n is a positive integer, for instance from to 20 or from to 12, preferably from 1 to 8.

The linker may be formed using a N-Hydroxysulfosuccinimide (NHS) ester such as a biotin NHS-ester. The linker may be formed using isocyanate, malimide, disulfite, hydrazine or hydrazine.

There may be more than one, i.e. a plurality, of linkers present in the promoter. For example, there may be from 2 to 500, 2 to 250, 2 to 150, 2 to 50 or 2 to 10. There may be 2, 3, 4, 5, 6, 7, 8, 9 or 10. There may be one linker present in the promoter. There are typically the same number of linkers present as transcription inhibition moieties and cleavable moieties. Thus there can be equal numbers of transcription inhibition moieties, cleavable moieties and linkers. There can be equal numbers of components of the promoter coupled to the transcription inhibition moieties, transcription inhibition moieties, cleavable moieties and linkers.

The one or more transcription inhibition moieties coupled to one or more components of the activatable promoter may have the formula COMP-L-PC-X, wherein COMP is the one or more components of the activatable promoter coupled to the one or more transcription inhibition moieties, L is the linker, PC is the one or more cleavable moieties (preferably photocleavable moieties) and X is the one or more transcription inhibition moieties.

Typically the linker is bonded to one of the ring positions in the base. If the base is a purine base, the linker is typically bonded to the 8 position on the purine ring. If the base is a pyrimidine base, the linker is typically bonded to the 5 position on the pyrimidine ring.

The aqueous object may comprise an expression system comprising the promoter defined herein. The expression system comprises the promoter which is operably linked to a transcribable open reading frame. The promoter may be operably linked to a gene or gene fragment (e.g. exon or cDNA). The polynucleotide can encode, for example, a peptide, an oligopeptide, a polypeptide, a protein, or an RNA which is not translated, for example non-coding RNA, tRNA, rRNA, snoRNA, microRNA, siRNA, snRNA, exRNA, piRNA, shRNA, scaRNAs or the long ncRNA. The polynucleotide may encode a plurality of, for example, a peptide, protein, non-coding RNA, tRNA, rRNA, snoRNA, microRNA, siRNA, snRNA, exRNA, piRNA, shRNA, scaRNAs and/or the long ncRNA.

The open reading frame or gene or gene fragment (e.g. cDNA) may encode for any protein. For example, any of the proteins described herein which may be present at the interface. The protein is preferably a membrane protein, such as those described herein. The protein may comprise a pump, a channel, a pore, a receptor protein, a transporter protein, or a protein which effects cell recognition or a cell-to-cell interaction. The membrane protein may allow electrical communication, for example, by allowing electrical current between the first and second aqueous object. The membrane protein may allow an ion flux between the first and second aqueous object. The membrane protein may be a protein which can passively or actively transport ions across an interface such as a bilayer. The membrane protein may for instance be a membrane pump, channel, pore, receptor and/or transporter to allow for precise control over the exchange of material, and electrical communication, between the aqueous objects. The protein may comprise an ion pump, such as a proton pump, an ion channel or an ion transporter. The protein may be light-sensitive, for example, the protein may comprise a light-sensitive pump, a light-sensitive channel, a light-sensitive pore or a light-sensitive transporter. The protein may comprise a light-sensitive ion pump, such as a proton pump, a light-sensitive ion channel, a light-sensitive ion channel or a light-sensitive ion transporter.

"Operably linked" refers to an arrangement of elements wherein the components so described are configured so as to perform their usual function. Thus, a given regulatory element, such as a promoter, operably linked to a polynucleotide is capable of effecting the expression of that polynucleotide when the appropriate enzymes are present. The promoter need not be contiguous with the sequence, so long as it functions to direct the expression thereof. Thus, for example, intervening untranslated yet transcribed sequences can be present between the promoter sequence and the nucleic acid sequence and the promoter sequence can still be considered "operably linked" to the coding sequence.

The expression system may include further transcriptional regulatory elements which control expression from the promoter. Regulatory elements include, but are not limited to, additional promoters, enhancers, initiation sites, internal ribosomal entry sites (IRES), and transcription termination signals, such as polyadenylation signals and poly-U sequences. Such regulatory elements are described, for example, in Goeddel, GENE EXPRESSION TECHNOLOGY: METHODS IN ENZYMOLOGY 185, Academic Press, San Diego, Calif. (1990). Examples of enhancers include WPRE, CMV enhancer, RSV enhancer, the R-U5' segment in LTR of HTLV-I (Mol. Cell. Biol., Vol. 8(1), p. 466-472, 1988), SV40 enhancer, and the intron sequence between exons 2 and 3 of rabbit β-globin (Proc. Natl. Acad. Sci. USA., Vol. 78(3), p. 1527-31, 1981). The regulatory elements may direct expression of a transcript from the promoter in, for example, any reaction vessel, such as a host cell, or may direct expression in certain reaction vessels, such as a certain host cell (e.g., tissue-specific regulatory sequences).

The transcriptional machinery include components which enable and/or enhance transcription from a promoter. Transcriptional components are well known to a person skilled in the art. The promoter, expression system and/or vector described herein may be operably configured for use with transcription components. By the expression system being "operably configured for use" with transcriptional components, the expression system can be expressed using the transcriptional components well known to a person skilled in the art such as those described herein.

The transcriptional components may be eukaryotic or prokaryotic transcription components. For example, the transcription components may be from, or derived from, bacteria, archaea, fungi e.g. yeast, a virus e.g. a bacteriophage, an animal e.g. a mammal, or a plant, or from related systems. Transcription components include, for example, the preinitiation complex, polymerase (such as RNA polymerase, e.g., bacterial RNA polymerase (RNAP) or RNA polymerase I, II or III), TATA-binding protein (TBP), Transcription Factor IIA (TFIIA), Transcription Factor IIB (TFIIB), Transcription Factor IID (TFIID), Transcription Factor IIE (TFIIE), Transcription Factor IIF (TFIIF) and Transcription Factor IIH (TFIIH).

Transcriptional reagents comprise any of the transcriptional components or transcriptional regulatory elements described herein.

The aqueous object may comprise a vector comprising the expression system described herein. The vector is typically a linear double-stranded DNA molecule or a continuous (e.g. circular) double-stranded DNA molecule. The vector may be for example, plasmid, virus or phage vectors provided with an origin of replication, and, optionally, one or more regulatory elements. The vector may be a retrovirus, lentivirus, adenovirus, adeno-associated virus, baculovirus or herpes simplex virus vector. The vector may be a pXTl, pSG5 (Stratagene), pSVK3, pBPV, pMSG, and pSVLSV40 (Pharmacia). Other suitable vectors would be apparent to persons skilled in the art. By way of further example in this regard reference is made to Sambrook *et al.* The vector may contain one or more selectable marker genes, for example an ampicillin resistance gene.

The vector may be any suitable expression vector. The expression vector may then be introduced into a suitable host cell.

The expression system or vector may additionally comprise a signal peptide sequence. The signal peptide sequence is generally inserted in operable linkage with the promoter such that the signal peptide is expressed and facilitates targeting to a membrane (such as a lipid bilayer) of, or secretion of, a peptide or protein encoded by a coding sequence also in operable linkage with the promoter.

The promoter and/or the other regulatory elements may be selected to be compatible with the environment in which the promoter, expression system or vector is introduced and expressed.

An uncoupling agent may be provided to the aqueous object to enhance, increase or initiate expression from the activatable promoter. The uncoupling agent is capable of uncoupling the one or more transcription inhibition moieties from the one or more components of the promoter, and a transcript is expressed following uncoupling. The uncoupling agent can be any agent which is capable of uncoupling the one or more transcription inhibition moieties from the one or more components of the promoter. The uncoupling agent can be an agent which is capable of cleaving the one or more cleavable moieties. Preferably providing the uncoupling agent can result in photocleavage of the one or more photocleavable moieties. For example, the agent may directly or indirectly photocleave the photocleavable moieties. Thus the agent can be electromagnetic radiation such as the types and wavelengths described herein.

The agent may be provided by any suitable means. The way the agent is provided depends in part on the array also being provided. For example, whether the array is, for example, *in vitro, in vivo* or *ex vivo,* will affect how the agent can be provided. A skilled person will be readily able to determine how the agent can be provided. For example, if the agent is electromagnetic radiation, the electromagnetic radiation may be provided by any suitable method or apparatus such as by a light microscope (e.g. fluorescence), optical fibres, LED driven light delivery systems, fixed spot illuminators, galvo-driven spot illuminators, flexible array-based patterned illuminators or polygon grid scanning.

A peptide, oligopeptide, polypeptide or protein may be produced in the aqueous objects by expressing a transcipt and translating the transcript into a peptide, oligopeptide, polypeptide or protein.

A skilled person will readily know the machinery required for translation of the coding nucleotide.

The components required for transcription are well known to those of skill in the art. The components will typically comprise a polymerase enzyme, a suitable buffer, triphosphate molecules such as ribonucleotide triphosphates, and cofactors such as magnesium ions. The exact components and conditions required will depend upon the circumstances but can readily be ascertained by one of skill in the art.

Typically, the components required for transcription are provided within the aqueous medium of the aqueous object.

The components required for transcription may be provided as a "cell-free" system or in vitro transcription system. Many such systems are well known to those skilled in the art (for a review see e.g. Beckert, B et al, Synthesis of RNA by in vitro transcription. Methods Mol. Biol. 2011; 703: pp29-41; doi: 10.1007/978-1-59745-248-9_3). For example, systems based on rabbit reticulocyte lysates, wheat germ extract, bacterial or insect lysates or extracts are commonly employed. Systems based on e.g. T7, T3 or SP6 RNA phage polymerase are available. Such systems are available widely from commercial suppliers. Such components may be directly provided within the aqueous medium described herein or of the aqueous object described herein.

Similarly, in situations where translation of the relevant transcript is required, the components required for translation may additionally be supplied. Cell-free systems for *in vitro* translation are widely available and may be combined with cell-free systems for *in vitro* transcription. Such systems may comprise components both for in vitro transcription and for in vitro translation.

Such cell-free systems may be made bespoke or are available commercially, e.g. the PURExpress^{®} system from New England Biolabs, Inc. (https://www.neb.com/products/e6800-purexpress-invitro-protein-synthesis-kit) and the 1-Step Human IVT from Thermo Fisher Scientific Inc. (https://www.thermofisher.com/uk/en/home/life-science/protein-biology/protein-expression/cell-free-protein-expression/mammalian-cell-free-protein-expression/overview-thermo-scientific-1-step-ivt-systems.html).

Synthetic cells are well known to a skilled person. A synthetic cell may be a minimal cell, artificial cell, cell-like system, semi-synthetic cell or cell-mimetic. For example the sythentic cell may comprise a lipid, e.g. phospholipid, monolayer or bilayer. A synthetic cell may be any synthetic cell discussed further in Dahl et al. (2015) "Microfluidic Strategies for Understanding the Mechanics of Cells and Cell-Mimetic Systems", Annu Rev Chem Biomol Eng. 2015;6:293-317; Murtas (2009) "Artificial assembly of a minimal cell", Mol Biosyst. 2009 Nov;5(11):1292-7; Stano (2011) "Minimal cells: relevance and interplay of physical and biochemical factors" Biotechnol J. 2011 Jul;6(7):850-9; and Arkin (2001) "Synthetic cell biology"; Curr Opin Biotechnol. 2001 Dec;12(6):638-44.

Reagents, e.g. solutions comprising the promoters, expression systems and vectors, as defined herein, may be comprised within one or more of the aqueous objects defined herein.

The aqueous medium of the aqueous object or objects may comprise an *in vitro* transcription system. The aqueous medium of the aqueous object or objects may comprise an *in vitro* transcription system and an *in vitro* translation system.

In certain embodiments the aqueous object, such as an aqueous droplet or hydrogel object, may contain a promoter, expression system and/or vector. In such embodiments, the aqueous medium may contain additional reagents required to give functional effect to the promoter, expression system and/or vector. Such additional reagents are discussed herein. The skilled person will appreciate that the promoters, expression systems and/or vectors may be operated by conventional means. Thus the skilled person will readily appreciate the nature of the additional reagents which are needed to give functional effect to the promoter, expression system and/or vector in the required context.

One important property of the aqueous medium is pH and this can be varied over a wide range. In some embodiments, for instance, the pH of the aqueous medium within the aqueous object or objects may be in the range of from 5 to 9 (or for instance in the range of from 6 to 8) although higher and lower pHs are also possible. The aqueous medium may therefore be an aqueous buffer solution. Any suitable buffer can be employed, depending on the desired pH. The buffer solution may for instance comprise Tris HCl and KCl. In some embodiments the pH of the aqueous buffer solution is from 5 to 9, or for instance from 6 to 8. The nature and concentration of the solutes can be varied to vary the properties of the solution.

In situations where the aqueous objects defined herein harbour promoters, expression systems and/or vectors, the skilled person will readily appreciate the pH parameters which are needed to give functional effect to the promoter, expression system and/or vector in the required context.

The present invention is further illustrated in following Example.

### EXAMPLE

The present inventors have developed an array of bR-based droplet pixels (bio-pixels) arranged on a hydrogel structure. Protons are pumped from the illuminated droplets into the hydrogel, generating a current across the membrane. The currents generated in each bio-pixel are combined to form an image. The device constitutes a synthetic biological (synbio) retina, a soft biological camera.

### Developing a bR bio-pixel

Lipid monolayers form on the surfaces of aqueous droplets and hydrogels in lipid-containing oil. A single droplet can be contacted with a hydrogel surface to form a droplet-hydrogel-bilayer (DHB)²¹, or two droplets can be brought together to form a droplet-interface-bilayer (DIB)²². The present inventors have created light-sensing DHB and DIB bio-pixels by incorporating the light-activated proton pump bR into the bilayers. The present inventors used detergent to treat bR-containing purple membrane from *H. salinarum*¹³*.* The resulting bR suspension was then pipetted into a mixture of hexadecane and silicone oil (1:1) containing the lipid 1,2-diphytanoyl-sn-glycero-phosphatidylcholine (DPhPC) to create a bR-containing aqueous droplet. After bilayer formation with a bR-free droplet or at a hydrogel surface, current responses with respect to the bR droplet were recorded with Ag/AgCl electrodes (Fig 1 and 5). The bio-pixels produced currents under 560 nm illumination, as previously reported^{13, 23, 24}. The present inventors designated an arbitrary cut-off current of 1 pA to give each bio-pixel a binary response. Below 1 pA a pixel is considered to be 'OFF' and above 1 pA a pixel is considered to be 'ON' (Fig 1d).

When the positions of the ground and recording electrodes were switched, the sign of the current changed, indicating that the observed current corresponds to the directional movement of charge across the bilayer (Fig 6). In *Halobacterium salinarum,* bR pumps protons from its C-terminal face, inside the cell, to the N-terminal face, outside the cell²⁵. In the present inventors' experiments, positive charge moves into the hydrogel, which indicates that bR inserts into the bilayer predominantly N-terminus first. When no bR was present in the bio-pixels, no current was generated during illumination, indicating that artifacts arising from photochemistry at the Ag/AgCl electrodes did not occur (Fig 7).

### Prototype imaging device

Previously, a 4x4 array for screening ion channels and pores was developed²⁶, which employed individual droplets held in electrode-containing poly(methyl methacrylate) (PMMA) wells. A mobile droplet, attached to an electrode on a micromanipulator, was brought into contact with each of the droplets in turn and a membrane current recorded.

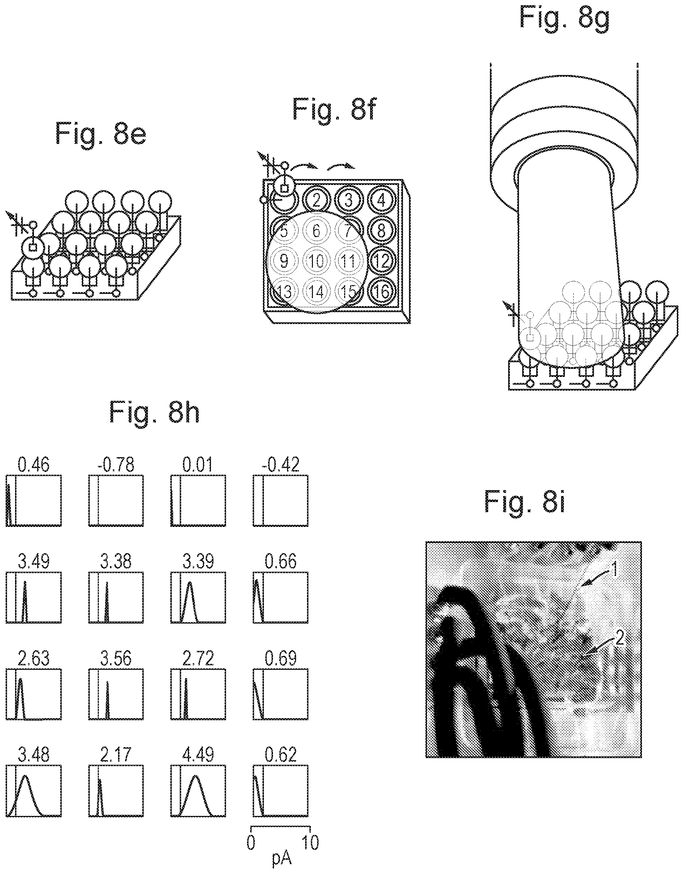

As a proof of concept for the present inventors' synbio retina, a prototype 4x4 array of bR DIB bio-pixels was made. Following the previous example, currents from each pixel were read one by one with a mobile buffer droplet (Fig 8). By combining the current outputs from each bio-pixel, the present inventors could determine the shape of a light beam incident on the array (Fig 8h), suggesting that shape recognition would be possible with a further advanced device.

### Synbio retina

The present inventors then sought to develop a synbio retina in which all the bio-pixels were part of a single soft structure (Fig 2). This would allow the present inventors to use a common ground electrode and detect each bio-pixel individually but also simultaneously. Sixteen bR droplets were patterned in a 4x4 array onto a hydrogel structure formed from agarose (Fig 2a, 9, 10 and 1). To form the structure, a melted agarose solution was injected into a PMMA chamber (Fig 9 and 10) with a removable lid (Fig 11a-d), which contained cylindrical PMMA columns to shield the electrodes. Once the agarose had gelled, the lid was removed to uncover a rectangular block with a 4x4 array of cylindrical cavities (Fig 11e-g). An Ag/AgCl recording electrode was situated at the bottom of each cavity, while a common ground electrode was inserted into the hydrogel (Fig 11h-i). The electrodes were connected to a 16-channel amplifier. A solution of 14 mM DPhPC lipid in hexadecane and silicone oil (1:1) was introduced to form a lipid monolayer on the surface of the hydrogel. bR-containing droplets were pre-incubated in a separate chamber in the lipid-in-oil solution, so that each became encapsulated in a lipid monolayer. One droplet was then introduced into each of the cylindrical columns and allowed to insert on a recording electrode and form a bilayer with the hydrogel structure (Fig 2b).

The currents from all sixteen bR-containing DHB bio-pixels were recorded simultaneously with a multichannel amplifier during illumination of the hydrogel array from above, with a 560 nm LED (Fig 2d). The current measurements from each bio-pixel were analysed with custom software, which filtered the data and corrected the baselines of the traces (Fig 12a). The data for each bio-pixel are displayed on a 4x4 output grid in three different ways: (1) as current over time graphs (Fig 2e); (2) as histograms of the steady-state current (Fig 2f); and (3) as pixel representations with or without a star based on whether the current is above or below the 1 pA arbitrary cut-off (Fig 12b). Accordingly, the shape of the illuminating light beam could be recognized.

The bio-pixels exhibited a current above the cut-off only when bR droplets were present in the cavities of the hydrogel array and when the device was illuminated (Fig 13). As expected, bilayer capacitance had an effect on the current profile^{23, 24, 27}, which was manifested in different current waveforms from each bio-pixel (Fig 2e and 14) due to variation in the contact areas between the droplets and the hydrogel. No matter the profile of the current, the steady-state cut-off current of 1 pA was able to discriminate between ON and OFF states for each bio-pixel.

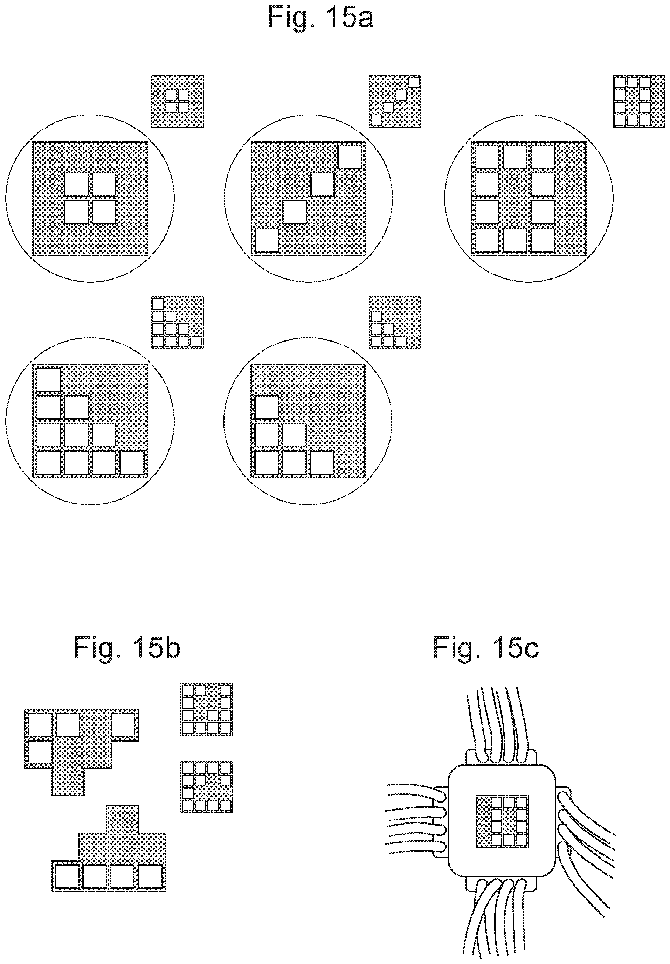

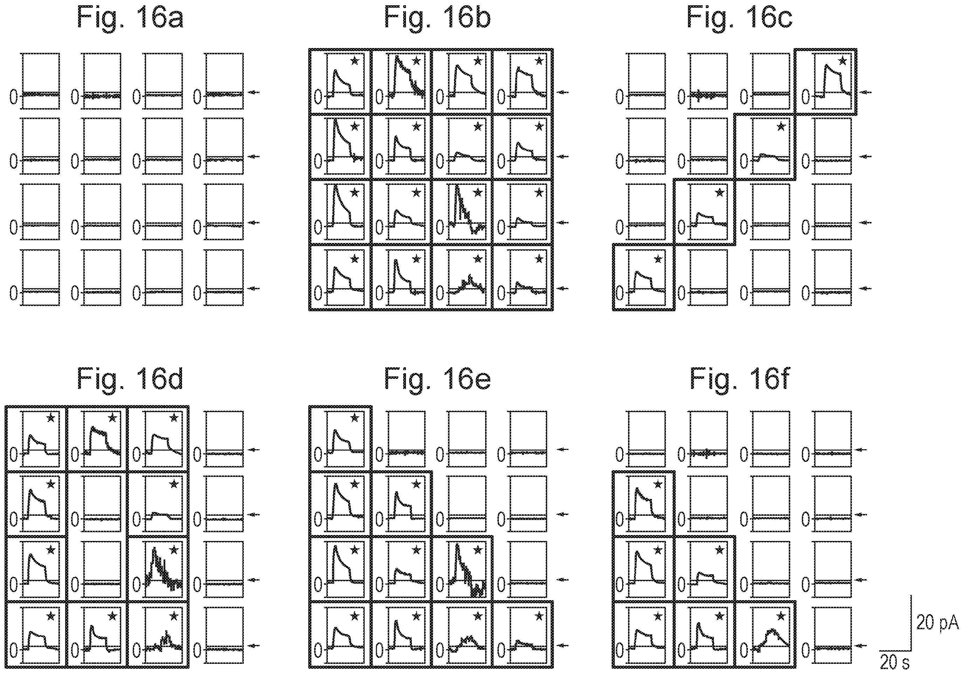

In order to use the device to identify static shapes, photomasks were prepared that projected different images onto the bio-pixels (Fig 15a). The photomasks were placed on top of the synbio retina (Fig 15c) and illuminated from above while the electrical activity in each bio-pixel was monitored. Several static images, produced by different photomasks, were identified through the current outputs of the bio-pixels (Fig 3 and 16).

The present inventors next sought to detect moving images with the synbio retina. To do this the present inventors used 2x3 photomasks that were moved across the surface of the array, while the electrical activity of each bio-pixel was monitored (Fig 4). The present inventors used photomasks that represent two different Tetris-based shapes (Fig 15b). A single shape was detected as it moved across the device, followed by a second shape, culminating in the detection of both shapes moving together after the bottom row had been fully occupied (Fig 4, 17). Therefore, the present inventors demonstrate that the synbio retina can detect multiple moving shapes, through the light-dependent current generated at each bio-pixel.

The present inventors have formed a 12 x 12 synbio retina (Fig 18).

The present inventors have formed aqueous objects inside a hydrogel microcavity (Fig 19).

### Discussion

The present inventors have developed light-sensing DHB bio-pixels, incorporating bR-containing aqueous droplets. The present inventors created a 4x4 array of the bio-pixels on a common hydrogel base, and monitored them individually and simultaneously. The present inventors used this synbio retina to detect both static and moving images. By altering the chromophore of bR²⁸, through mutagenesis²⁹ or by varying the light-activated membrane protein^{30, 31}, the present inventors could potentially detect colour in images, even beyond the human visible spectrum. Also, higher resolution imaging might be accomplished by reducing the size of the droplets and the electrodes and increasing the number of bio-pixels¹¹. The present inventors synbio retinas might be interfaced with living tissues or used to power synthetic tissues^{32, 33}. The patterned generation of proton currents might be used to power selected regions of synthetic tissues. Synthetic biological light-driven arrays, produced with soft materials, might be interfaced with synthetic or living tissues to power physiological processes.

### Materials and Methods

### Buffer Preparation

The present inventors used two different buffer solutions throughout. Buffer A contained 10 mM HEPES (Sigma) and 100 mM NaCl (Sigma) at pH 7.5 (titrated with NaOH) and Buffer B contained 100 mM MES (Sigma) and 100 mM NaCl (Sigma) at pH 6.5 (titrated with NaOH). Double-distilled 'ultrapure' water (Millipore, Milli-Q: 18.2 MΩ cm) was used throughout.

### Preparation and Gel Analysis of bR

Purple membrane (PM) from *Halobacterium salinarum* contains bacteriorhodopsin (bR) in the form of two-dimensional crystals. Lyophilized PM from *H. salinarum* strain S9 (1 mg protein; Sigma, B0184) was suspended in 40 µL of Buffer A containing 0.01% (w/v) of the detergent DDM. The suspension was sonicated for 30 min at 20 °C (Branson 2800, Cleanosonic), diluted 10-fold in Buffer A and aliquoted into 1.5 mL vials. Prior to use, the bR suspension was centrifuged for 5 seconds and as much supernatant was removed as possible, without disturbing the pellet. The pellet was used to prepare stock solutions of concentrated bR in Buffer A, which were sonicated for 15 min and homogenised (Vortex-Genie 2, Scientific Industries) before use for bR droplets. The concentration was measured as ~5 mg ml⁻¹ (concentration measured by nanodrop 1000, assuming an extinction coefficient of 63000) and stored at -80°C. Aliquots of the bR suspension were run on a denaturing PAGE gel (Mini-Protean^{®} TGX^{™} 10% Precast gel) with SDS running buffer to confirm the purity of the protein monomer, which located at 27 kDa corresponding to bR's molecular mass.

### Preparation of Silver Chloride Electrodes

Individual wires of silver (100 µm diameter, Sigma) were soldered into a male crimp-terminal (RS Components). The tips of the wires were incubated in sodium hypochlorite, NaClO (10% active chlorine, Sigma) for 1 h to form Ag/AgCl electrodes. The tips of the electrodes were coated with a hydrogel layer by pipetting melted agarose (1% low-melt agarose, Sigma) onto their surfaces. For single DIB experiments, each electrode was plugged into a female crimp-terminal, which was attached to a micromanipulator (Narishige, NMN-21). The other end of the female crimp-terminal (RS Components) was soldered to a cable that terminates with a male crimp, which connects to the headstage of the amplifier.

### Preparation of Stocks of DPhPC in Oil

1,2-diphytanoyl-sn-glycero-phosphatidylcholine (DPhPC) (Avanti, 4ME 16:0 PC) was dissolved in pentane, aliquoted into glass vials (7 mL, Supelco) and then dried with a stream of nitrogen gas. The dried films were dissolved at the requisite concentrations in filtered (0.22 µm Millex GP filters, Millipore) hexadecane (Sigma) and silicone oil (AR20, Sigma) mixed in a 1:1 ratio.

### Preparation of DPhPC and DPPE-mPEG2000 Lipid in Oil Stocks

DPhPC (Avanti, 4ME 16:0 PC) and DPPE-mPEG2000 (Avanti, 16:0 PEG2000 PE) were weighed out, dissolved in chloroform and combined in a glass vial. The solvent was removed in a stream of nitrogen gas and the residue desiccated for >3 h, before storage at -20°C. The dried films contained 2 µmol of total lipid and 2.5% (moles) of DPPE-mPEG2000. Before use, dried films were dissolved in hexadecane (1 mL, Sigma), and then silicone oil (1 mL, AR20, Sigma) to give a total lipid concentration of 1 mM.

### Electrophysiology Chambers and Arrays

The chambers and arrays used throughout were manufactured by micromilling of poly (methyl methacrylate) (PMMA). Computer aided design (CAD) software (SolidWorks) was used to design the chambers in a format that was then executed by a subtractive computerized numerical control (CNC) machine (Roland Modela MDX-40A).

### General Electrical Recording Setup

Electrical recordings were conducted inside a Faraday cage, which enclosed a stage (Mechanical Workshop, University of Oxford) supporting the headstage of a conventional patch-clamp amplifier (Axopatch 200B, Axon Instruments) and two micromanipulators (Narishige, NMN-21) directing the Ag/AgCl electrodes. The PMMA chamber, containing lipid-in-oil, was placed at the center of the stage.

### Fiber-Coupled LED

A 560 nm fiber-coupled LED (100 mA) was used as an illumination source (Mightex, WFC-H7-0560). The Fiber-coupled LED was inserted from the top of the Faraday cage through an adaptor (Mechanical Workshop, University of Oxford) and was aligned with the PMMA chamber. The light source was held at 4 cm with respect to the synbio retina. The illumination settings were controlled from a computer using the manufacturer's software (Mightex).

### General Electrical Recording

A current signal was recorded with a digitizer (Digidata 1440A, Axon Instruments) operating in gap-free acquisition mode at a sampling frequency of 10 kHz, and using a 2 kHz filter and five-fold gain. Data were analysed using Clamp fit (version 10.3, Axon Instruments) by postfiltering with a 10 Hz low pass filter cut-off. All electrical recordings were conducted at 22.0±1.5°C.

### General DIB Formation for Electrophysiology

Using micromanipulators (Narishige, NMN-21) and a stereo-microscope (Nikon, SMZ660), two hydrogel-coated electrodes were placed inside a micromilled square chamber with sides of length 5 mm and a depth of 3 mm. In this chamber, a 200 nL droplet was pipetted onto each of the two electrodes in the lipid-in-oil solution. Once a droplet had spontaneously adhered to the hydrogel coating, the electrode was lifted off the surface of the chamber. As a result, the droplet hung on the electrode tip. After 5 min of incubation, the two droplets, one on each electrode, were gently brought together and spontaneously formed a droplet interface bilayer (DIB). To confirm that a bilayer had been formed, the capacitance was measured by applying a triangular voltage waveform (± 15 mV, 30 ms peak-to-peak). A capacitance of ≥ 20 pF was taken to demonstrate that a bilayer had been formed.

### DHB Bio-pixel Recording

A PMMA mold (5 mm², 3 mm depth) made with the CNC machine was used to form an agarose shape. A ground electrode (cis) was inserted into the hydrogel, while the working electrode (trans) was inserted into a 200 nL bR droplet, both in a 14 mM DPhPC lipid in oil solution. After 20 min of incubation, the monolayer-coated hydrogel and droplet were gently brought together to form a droplet hydrogel bilayer (DHB). To confirm that a bilayer had been formed, the capacitance was measured by applying a triangular voltage waveform (± 15 mV, 30 ms peak-to-peak). A capacitance of ≥ 20 pF was taken to demonstrate that a bilayer had been formed. DHB bio-pixel formation was confirmed by the appearance of a current in the range of 1-15 pA, only when the device was illuminated as described in 'Fiber-Coupled LED'.

### DIB Bio-pixel Formation

DIB bio-pixels were formed in the DPhPC lipid in hexadecane:silicone 1:1 oil solution (7 mM lipid) with the recording electrode (trans) in the 200 nL bR-containing droplet and the ground electrode (cis) in the 200 nL Buffer A containing droplet. The activity of each bio-pixel was confirmed by the measurement of a positive current under illumination in the arbitrary range of 1-15 pA.

### Electrical Response of Buffer A DIBs

Bare Ag/AgCl electrodes were placed in the Faraday cage in a DPhPC-containing oil solution (hexadecane:silicone 1:1 oil solution, 7 mM lipid). The current output was measured with and without illumination. Buffer A 200 nL droplets were then pipetted onto the electrodes and the current recorded with and without illumination, prior to DIB formation. The two droplets were then brought into contact and a bilayer was formed, and the current was again recorded with and without illumination.

### Effect of DIB Area on the Current Profile Produced by bR

Bio-pixels were formed from two droplets in 7 mM DPhPC in hexadecane:silicone 1:1 oil solution. The bilayer area was altered by pulling the droplets apart or pushing the droplets together with a micromanipulator (Narishige, NMN-21). The pixels were illuminated and the current profiles recorded.

### Direction of Insertion of bR in the Pixels

A DIB bio-pixel was formed in 7 mM DPhPC in 1:1 hexadecane:silicone oil. Initially, the droplet pair had bR in the trans droplet and Buffer A in the cis droplet. Light pulses of various durations were made. Part way through the experiment, the Faraday cage was opened and the droplets separated before the configuration of the electrodes was changed to bR/ cis and Buffer A/ trans, and the light pulses repeated.

### 4x4 PMMA Device

The 4x4 device was built from two micromilled plastic parts (Fig 9). Part 1 had four equally spaced holes on each of its sides and a central cavity with a rectangular cut-through (Fig 9 a, b and d). At the bottom, it had four rectangular bases at the edges (Fig 9 b-d). Part 2 had a rectangular cavity with a 4x4 array of equally spaced hole-containing pillars (Fig 9 e-h). The parts were then glued together and the electrical components integrated (Fig 10). A gold over nickel-plated female crimp (RS Components, 446-800) was glued (Adhesive araldite rapid, SLS) into each of the circular holes. 16 individual Ag/AgCl wire electrodes were soldered into each female crimp and glued to the bottom of the PMMA device with the ends of the wires emerging from each of the holes in part 2. From the top, the female crimp was then soldered to individual cables (RS Components) 30 cm long and ~2 mm wide. The other end of each of these cables was soldered to a ring terminal (RS Components), used to connect to screw terminals on the multichannel amplifier's electrode probe holders (Terrapin, Tecella LLC).

### Multichannel Electrical Recordings

Electrical recordings for the synbio retina arrays were conducted with a multichannel amplifier (Triton⁺, Tecella LLC) at 22.0±1.5 °C. Electrodes were connected to the amplifier via two 8-channel electrode probe holders (Terrapin, Tecella LLC), with their channels each ending in a screw-terminal for connecting an electrode. These probe holders were contained in a Faraday cage and the 16 screw-terminals were each connected to one of the 16 electrodes in the 4x4 PMMA device, for the individual recording of each electrode.

With the aid of a stereo-microscope (Nikon, SMZ660), a droplet was pipetted onto each of the 16 hydrogel-coated (1% w/v low-gelling agarose, Sigma) Ag/AgCl wire electrodes in the PMMA array. (The electrodes were formed and treated as described in 'Preparation of Silver Chloride Electrodes').

The current signal was obtained by gap-free acquisition with a feedback resistor of 1 GΩ. Data were acquired at 20 kHz with the use of a 5 kHz filter through the `TecellaLab v0.90 type 2' software.

### Recognition of Light Shapes with a Prototype Light-sensing DIB 4x4 Array

The PMMA device was filled with 200 µL of the DPhPC and DPPE-mPEG2000 lipid in a 1:1 hexadecane:silicone oil solution. bR droplets (100 nL) were placed on the end of each of the 16 electrodes (trans) and a droplet containing Buffer A was formed on the end of the moving electrode (cis) (Fig 8). The moving droplet was guided through the array, forming a bilayer (and hence a bio-pixel) with each bR droplet in turn.

The system was illuminated with the LED as described in 'Fiber-Coupled LED'. The steady state current signals for each bio-pixel were plotted as histograms and a normal distribution fitted to each one. This allowed the discrimination of the ON and OFF pixels, using the mean steady state current value and a cut-off of 1 pA.

### 4x4 Array Lid

A removable lid (Fig. 11) was designed to fit inside the 4x4 array described previously. The lid has a 4x4 arrangement of 16 circular pillars. The pillars had the same center-to-center spacing as the PMMA 4x4 array. Two holes, each at opposite edges of the lid, were used to introduce the melted agarose.

### Design of 4x4 DHB Array with a Common Ground

A solution of 1.7 % w/v low-gelling agarose (Sigma) in Buffer B was held at ~100°C, removed from heating and then pipetted through the holes in the 4x4 array lid (previously greased using hexadecane: silicone oil 1:1). The solution was left to gel for 30 min at room temperature. The lid was then carefully removed, resulting in a hydrogel covering over the 4x4 array, with cavities that exposed the electrodes. An Ag/AgCl ground electrode was inserted into the hydrogel.

### Bio-Pixel Formation in the 4x4 DHB Array with a Common Ground

Droplets containing the suspension of bR were incubated in a 14 mM DPhPC lipid in a 1:1 hexadecane: silicone oil solution for 30 min. The common ground hydrogel was incubated under the same conditions. A bR droplet was pipetted into each cavity. Each droplet made contact with its respective electrode and formed a lateral bilayer with the surrounding hydrogel. DHB bio-pixel formation was confirmed by the appearance of a current in the range of 1-15 pA, only when the device was illuminated as described in 'Fiber-Coupled LED'. No current was detected when no droplets or droplets containing only Buffer B were used.

### Photomasks

A 4x4 pixel mask, with the dimensions of the 4x4 PMMA device, was created in Illustrator (Adobe). Shapes were formed by colouring selected pixels black. The shapes were printed using A4 transparency sheets for mono printers (Xerox) and cropped as required. To allow movement of the Tetris-based photomasks across the PMMA device, they were cut to smaller sizes than the area of the 4x4 array.

### Recognition of Light Shapes with a 4x4 Synbio Retina

Photomasks were rested on top of the PMMA device and aligned with the 4x4 bio-pixel array. The Tetris-based photomasks were manually moved across the PMMA device. The system was illuminated with the LED. The mean steady state current from each pixel was determined. We used the 1 pA cut-off to determine whether a pixel was ON or OFF.

### Data Analysis Software

The data stream of current measurements was saved to disk in Tecella's tlc binary file type. The measurements were analysed and displayed using custom software written in LabVIEW. First, the tic file was accessed by calling a custom C++ program, which acted as a wrapper to call data-reading functions provided by a Tecella API (TecellaTLC API v0.3). The data from each channel was then processed through a low pass Bessel filter (8th order, 5 Hz cutoff) to remove noise. For display purposes, the data was then re-sampled at 30 Hz. Next, a linear fit was performed for each channel independently using two user-specified portions of the data (typically corresponding to "OFF" states at the beginning and end of the measurement period). Any linear drift or offset was then removed by subtracting this fitted function from the filtered data. Finally, the results were displayed in two ways: a two-dimensional grid of graphs (plotting current against time), and a visualiser, on which each channel was represented by a "colour block" that switches from grey to green as the current transitions through an arbitrary threshold value defined by the user (1 pA in the present work). This threshold value defines "OFF" and "ON" states, and was also displayed on the graphs. A text overlay on the visualiser displays the current (in pA). Before being displayed on the visualiser, the data were further processed by applying an additional filter (median filter, rank 30), in order to make the resulting video easier to read by further reducing high frequency components.

### Tetris Video Processing

Tetris-based photomask shapes were positioned at nine different locations on the synbio retina as described in `Recognition of Light Shapes with a 4x4 Synbio Retina'. For each positioning of the photomasks, a video of the "visualiser" described in `Data Analysis Software' was generated using our custom LabVIEW software. The visualiser displays a "colour block" and text overlay of the current (in pA) for each channel. The nine videos, each corresponding to one of the nine photomask positions (see figure 17), were then combined using Windows Movie Maker.

### Formation of the hydrogel mould

A 12×12 array of wells, of a predetermined size from 100-400 µm, are drilled on a metal surface. A synthetic resin (in this case, PMMA) is melted onto the metal surface, forming a 12×12 array of pillars.

This method achieves cavity sizes <400 µm across. It also has the advantage of achieving miniaturised features without the need of using a clean room.

The 12x12 array of pillars is used as the hydrogel mould. The mould is placed on top of the circuit board and the un-polymerised gel is added through the opening. A hydrogel-free cavity is formed above each of the 144 electrodes of the circuit board. When the mould is removed a hydrogel structure with 144 cavities for bio-pixels is formed - A hydrogel bio-pixel cavity, with an electrode in the middle of the well.

### Formation of the microelectrode circuit board

The printed circuit board laminate has a coating that is sensitive to light. An image of the 12x12 microelectrode array and its tracks is transferred by shining light on the laminate. Where light strikes the board, the coating weakens and will be dissolved away by the etching acid. The board is submerged in silver with only the 12x12 microelectrode pads exposed. The silver pads were incubated in sodium hypochlorite, NaClO (10% active chlorine) for 1 h to form Ag/AgCl electrodes.

### ACKNOWLEDGMENTS

This work was supported by a European Research Council Advanced Grant. The work leading to this invention has received funding from the European Research Council under the European Union's Seventh Framework Programme (FP7/2007-2013) / ERC grant agreement n° 294443.

### REFERENCES

1. Purves D, A.G., Fitzpatrick D, et al. (ed.) Neuroscience, Edn. 5th. (Sinauer Associates, 2011).
2. Yuodelis, C. & Hendrickson, A. A qualitative and quantitative analysis of the human fovea during development. Vision Res. 26, 847-855 (1986).
3. Palczewski, K. G protein-coupled receptor rhodopsin. Annu. Rev. Biochem. 75, 743-767 (2006).
4. Durini, D. (ed.) High Performance Silicon Imaging, Edn. 1. (Woodhead Publishing, 2014).
5. Roda, A. et al. Progress in chemical luminescence-based biosensors: A critical review. Biosens. Bioelectro.n 76, 164-179 (2016).
6. Briscoe, A.D. & Chittka, L. The evolution of color vision in insects. Annu. Rev. Entomol. 46, 471-510 (2001).
7. Bowmaker, J.K. Evolution of colour vision in vertebrates. Eye (Lond.) 12 ( Pt 3b), 541-547 (1998).
8. Ali, M.A. (ed.) Vision in Vertebrates. (Springer, 2013).
9. Warrant, E. & Nilsson, D.E. Invertebrate Vision. (Cambridge University Press, 2006).
10. Song, Y.M. et al. Digital cameras with designs inspired by the arthropod eye. Nature. 497, 95-99 (2013).
11. Huang, S., Romero-Ruiz, M., Castell, O.K., Bayley, H. & Wallace, M.I. Highthroughput optical sensing of nucleic acids in a nanopore array. Nat. Nanotechnol. 10, 986-991 (2015).
12. Holden, M.A., Needham, D. & Bayley, H. Functional bionetworks from nanoliter water droplets. J. Am. Chem. Soc. 129, 8650-8655 (2007).
13. Oesterhelt, D. & Stoeckenius, W. Rhodopsin-like protein from the purple membrane of Halobacterium halobium. Nat. New. Biol. 233, 149-152 (1971).
14. Wickstrand, C., Dods, R., Royant, A. & Neutze, R. Bacteriorhodopsin: Would the real structural intermediates please stand up? Biochim. Biophys. Acta. 1850, 536-553 (2015).
15. Kayushin, L.P. & Skulachev, V.P. Bacteriorhodopsin as an electrogenic proton pump: reconstitution of bacteriorhodopsin proteoliposomes generating delta psi and delta pH. FEBS Lett. 39, 39-42 (1974).
16. Birge, R.R. et al. Biomolecular Electronics: Protein-Based Associative Processors and Volumetric Memories. J. Phys. Chem. B. 103, 10746-10766 (1999).
17. Chen, Z. & Birge, R.R. Protein-based artificial retinas. Trends Biotechnol. 11, 292-300 (1993).
18. Choi, H.-G., Jung, W.-C., Min, J., Lee, W.H. & Choi, J.-W. Color image detection by biomolecular photoreceptor using bacteriorhodopsin-based complex LB films. Biosens. Bioelectron. 16, 925-935 (2001).
19. Haronian, D. & Lewis, A. Micro fabricating bacteriorhodopsin films for imaging and computing. Appl. Phys. Lett. 61, 2237-2239 (1992).
20. Miyasaka, T., Koyama, K. & Itoh, I. Quantum conversion and image detection by a bacteriorhodopsin-based artificial photoreceptor. Science. 255, 342-344 (1992).
21. Thompson, J.R., Heron, A.J., Santoso, Y. & Wallace, M.I. Enhanced stability and fluidity in droplet on hydrogel bilayers for measuring membrane protein diffusion. Nano. Lett. 7, 3875-3878 (2007).
22. Leptihn, S. et al. Constructing droplet interface bilayers from the contact of aqueous droplets in oil. Nat. Protoc. 8, 1048-1057 (2013).
23. Horn, C. & Steinem, C. Photocurrents generated by bacteriorhodopsin adsorbed on nano-black lipid membranes. Biophys. J. 89, 1046-1054 (2005).
24. Bamberg, E. et al. Photocurrents generated by bacteriorhodopsin on planar bilayer membranes. Eur. Biophys. J. 5, 277-292 (1979).
25. Kimura, Y. et al. Surface of bacteriorhodopsin revealed by high-resolution electron crystallography. Nature. 389, 206-211 (1997).
26. Syeda, R., Holden, M.A., Hwang, W.L. & Bayley, H. Screening blockers against a potassium channel with a droplet interface bilayer array. J. Am. Chem. Soc. 130, 15543-15548 (2008).
27. Hwang, W.L., Holden, M.A., White, S. & Bayley, H. Electrical behavior of droplet interface bilayer networks: experimental analysis and modeling. J. Am. Chem. Soc. 129, 11854-11864 (2007).
28. Bayley, H., Padhakrishnan, R., Huang, K.S. & Khorana, H.G. Light-driven proton translocation by bacteriorhodopsin reconstituted with the phenyl analog of retinal. J. Biol. Chem. 256, 3797-3801 (1981).
29. Orekhov, F.S., Shaitan, A.K. & Shaitan, K.V. Calculation of spectral shifts of the mutants of bacteriorhodopsin by QM/MM methods. Biophysics. 57, 221-231 (2012).
30. Chuong, A.S. et al. Noninvasive optical inhibition with a red-shifted microbial rhodopsin. Nat. Neurosci. 17, 1123-1129 (2014).
31. Townson, S.M. et al. Honeybee blue- and ultraviolet-sensitive opsins: cloning, heterologous expression in Drosophila, and physiological characterization. J. Neurosci. 18, 2412-2422 (1998).
32. Booth, M.J., Schild, V.R., Graham, A.D., Olof, S.N. & Bayley, H. Light-activated communication in synthetic tissues. Sci. Adv. 2, e1600056 (2016).
33. Villar, G., Graham, A.D. & Bayley, H. A tissue-like printed material. Science. 340, 48-52 (2013).

## Claims

1. An array of aqueous objects configured to pass an electrical current between a first aqueous object and a second aqueous object, wherein:
(a) the array comprises a scaffold, two or more of the first aqueous objects and at least one of the second aqueous objects wherein each of the first and second aqueous objects comprises an aqueous droplet or a hydrogel;
(b) said first aqueous objects of (a) each comprise amphipathic molecules on at least part of the surface of the first aqueous objects;
(c) said second aqueous objects of (a) each comprise amphipathic molecules on at least part of the surface of the second aqueous objects;
(d) said first aqueous objects of (b) each form an interface with the second aqueous object of (c), wherein the second aqueous object is:
(i) a single common second aqueous object, or
(ii) a different individual second aqueous object;
(e) said interface of (d) comprises a bilayer of said amphipathic molecules of (b) and (c), and a light-sensitive protein is dispersed in the bilayer; and
(f) the scaffold isolates said first aqueous objects of (b) from each other.

2. An array according to claim 1, wherein:
(i) the scaffold extends between adjacent first aqueous objects;
(ii) the scaffold forms a barrier between adjacent first aqueous objects;
(iii) the scaffold provides predefined positions in the array for the first aqueous obj ects;
(iv) the array is planar;
(v) the array is biocompatible; and/or
(vi) the scaffold comprises a plurality of cavities which in turn comprise the first aqueous objects.

3. An array according to claim 1 or 2, wherein the scaffold comprises a plurality of cavities which in turn comprise the first aqueous objects, and wherein the cavities traverse the scaffold.

4. An array according to any one of the preceding claims, wherein:
(I) the first aqueous objects are in electrical contact with two or more first communication means;
(II) the or each second aqueous object is in electrical contact with at least one second communication means; and/or
(III) (a) the first aqueous objects are in electrical contact with two or more first communication means and/or (b) the or each second aqueous object is in electrical contact with at least one second communication means; and (c):
(i) wherein each of the first communication means is in electrical contact with a different individual one of the said first aqueous objects;
(ii) wherein:
(I) the or each of the second communication means is in electrical contact with one of the said different individual second aqueous object; or
(II) the or each of the second communication means is in electrical contact with one of the said different individual second aqueous object, and/or wherein the or each of the second communication means is in physical contact with one of the said different individual second aqueous object; or
(III) the second communication means is a single common second communication means and is in electrical contact with the single common second aqueous object; or
(IV) the second communication means is a single common second communication means and is in electrical contact with the single common second aqueous object, and wherein the single common second communication means is in physical contact with the single common second aqueous object;
(iii) wherein each of the first communication means is in physical contact with a different individual one of the said first aqueous object;
(iv) wherein the array further comprises the said first communication means;
(v) wherein the array further comprises the said second communication means;
(vi) wherein each first communication means comprises a first electrode; and/or
(vii) wherein each second communication means comprises a second electrode.

5. An array according to any one of the preceding claims, wherein:
(I) the scaffold comprises the single common second aqueous object; and/or
(II) each first aqueous object comprises an aqueous droplet, the single common second aqueous object is the scaffold and the single common second aqueous object comprises a hydrogel object.

6. An array according to any one of the preceding claims, wherein:
(i) the array further comprises a droplet assembly;
(ii) the array further comprises a droplet assembly, and wherein the droplet assembly comprises the single common second aqueous object;
(iii) the array further comprises a droplet assembly, wherein the droplet assembly comprises the single common second aqueous object, and wherein the droplet assembly is the single common second aqueous object;
(iv) the second aqueous object comprises one or more cells;
(v) the second aqueous object comprises one or more cells, and wherein the cells are neural cells;
(vi) the scaffold comprises a hydrogel object; and/or
(vii) the scaffold is a hydrogel object.

7. An array according to any one of the preceding claims, wherein:
(I) the scaffold does not comprise the single common second aqueous object; or
(II) the scaffold is the single common second aqueous object.

8. An array according to any one of claims 3 to 5, wherein:
a) the scaffold is the single common second aqueous object;
b) the scaffold comprises a hydrogel object and two or more cavities;
c) the cavities of (b) traverse the scaffold;
d) the scaffold is located on a surface comprising said two or more first communication means;
e) the scaffold is in electrical contact with the single common second communication means;
f) the cavities of (b) are situated over the first communication means of (d);
g) each cavity of (b) is situated over a different individual one of the first communication means of (d);
h) each cavity of (b) contains a different individual one of the first aqueous objects;
i) each first aqueous object of (h) forms a different said interface with the scaffold; and
j) each first aqueous object of (h) is in electrical contact with the first communication means of (g) which the said cavity is situated over;
optionally, wherein:
(I) each first communication means comprises a different individual first electrode and the single common second communication means comprises a second electrode; and/or
(II) the scaffold is in physical contact with the single common second communication means and each first aqueous object is in physical contact with the first communication means of (g) which the cavity is situated over.

9. An array according to any one of the preceding claims, further comprising:
(I) one or more further aqueous objects which are provided within and/or adjacent to one or more of the first aqueous objects of (d) in a portion of the array isolated by the scaffold; or
(II) one or more further aqueous objects which are provided within and/or adjacent to one or more of the first aqueous objects of (d) in a portion of the array isolated by the scaffold, wherein:
(i) in a portion of the array isolated by the scaffold one or more of the one or more further aqueous objects form an interface with the second aqueous object;
(ii) in a portion of the array isolated by the scaffold one or more of the one or more further aqueous objects form an interface with the first aqueous object;
(iii) in a portion of the array isolated by the scaffold one or more of the one or more further aqueous objects form an interface with another one or more of the one or more further aqueous objects; and/or
(iv) one or more of the first aqueous objects and/or one or more of the further aqueous objects comprises one or more cells and/or one or more vesicles.

10. An array according to any one of the preceding claims, wherein said interface of (d) does not comprise a bilayer of amphipathic molecules.

11. An array according to any one of claims 1 to 9, wherein:
(i) a protein is dispersed in the bilayer;
(ii) a protein is dispersed in the bilayer, and wherein the protein is a membrane protein;
(iii) the light-sensitive protein is:
(I) a light-sensitive ion channel,
(II) a light-sensitive ion pump,
(III) a light-sensitive proton pump, or
(IV) a photoreceptor protein;
and/or
(iv) the light-sensitive protein is a photoreceptor protein, and the protein is a rhodopsin, optionally bacteriorhodopsin.

12. An array according to any one of the preceding claims, wherein:
(a) the amphipathic molecules comprise lipid molecules;
(b) the amphipathic molecules comprise phospholipid molecules;
(c) the amphipathic molecules comprise phospholipid molecules, and wherein the phospholipids comprise cross-linked lipids;
(d) the amphipathic molecules comprise phospholipid molecules, and wherein the phospholipids comprise block copolymers; and/or
(e) the amphipathic molecules comprise phospholipid molecules, wherein the phospholipids comprise block copolymers, wherein the phospholipids comprise non-PEGylated phospholipids and PEGylated phospholipids, and wherein:
(i) from 2.5 to 15 mol% of the phospholipids are PEGylated phospholipids;
(ii) from 5 to 15 mol% of the phospholipids are PEGylated phospholipids;
(iii) from 7.5 to 15 mol% of the phospholipids are PEGylated phospholipids; or
(iv) from 10 to 15 mol% of the phospholipids are PEGylated phospholipids.

13. An array according to claims 12(e), wherein:
(I) the PEGylated phospholipids comprise a PEG group which has a molecular weight of from 1500 to 5000 g/mol;
(II) the PEGylated phospholipids comprise a PEG group which has a molecular weight of from 1800 to 2200 g/mol;
(III) the non-PEGylated phospholipids are glycerophospholipids and/or the PEGylated phospholipids are glycerophospholipids; and/or
(IV) the non-PEGylated phospholipids are glycerophospholipids and/or the PEGylated phospholipids are glycerophospholipids, and wherein:
(i) the non-PEGylated phospholipids are phospholipids of formula (I): 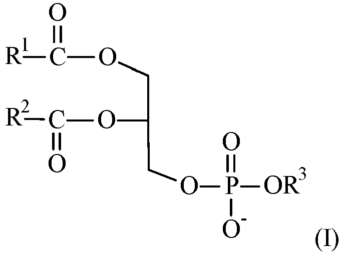 wherein:
R¹ and R², which are the same or different, are selected from C₁₀-C₂₅ alkyl groups and C₁₀-C₂₅ alkenyl groups;
R³ is absent such that OR³ is O⁻, or R³ is present and is H, CH₂CH₂N(R4)₃⁺, a sugar group, or an amino acid group; and
each R⁴, which is the same or different, is independently selected from Hand unsubstituted C₁-C₄ alkyl;
(ii) the PEGylated phospholipids are phospholipids of the following formula (II) 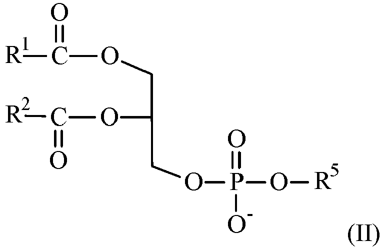 wherein:
R¹ and R² are as defined above for the phospholipids of formula (I), and R⁵ is a group which comprises polyethylene glycol),
optionally wherein:
R⁵ is -CH₂CH₂NHC(O)-(OCH₂CH₂)_{q}OCH₃, -CH₂CH₂NHC(O)(CH₂)₃C(O)-(OCH₂CH₂)_{q}OCH₃, -CH₂CH₂NHC(O)-(OCH₂CH₂)_{q}OH, or - CH₂CH₂NHC(O)(CH₂)₃C(O)-(OCH₂CH₂)_{q}OH, wherein q is an integer from 5 to 10,000;
(iii) the non-PEGylated phospholipids comprise DPhPC;
(iv) the PEGylated phospholipids comprise DPPE-mPEG2000; and/or
(v) the phospholipids comprise DPhPC and DPPE-mPEG2000, and wherein the phospholipids comprise from 2.5 to 15 mol% of DPPE-mPEG2000, optionally from 5 to 15 mol% of DPPE-mPEG2000.

14. An array according to any one of the preceding claims, further comprising:
(I) a hydrophobic medium, wherein one or more of the first aqueous objects are disposed in the hydrophobic medium; and/or
(II) a hydrophobic medium, wherein one or more of the first aqueous objects are disposed in the hydrophobic medium, and wherein:
(i) the hydrophobic medium comprises an oil;
(ii) the hydrophobic medium comprises an oil, wherein the oil comprises silicone oil, a hydrocarbon, or a fluorocarbon, or a mixture of two or more thereof;
(iii) the hydrophobic medium comprises an oil, wherein the hydrophobic medium comprises a mixture of a hydrocarbon and silicone oil;
(iv) the hydrophobic medium comprises an oil, wherein the hydrophobic medium comprises a mixture of a hydrocarbon and silicone oil, and wherein the hydrophobic medium comprises a ratio of hydrocarbon: silicone oil of from 50:50 to 20:80 by volume, or from 50:50 to 80:20 by volume, preferably in a ratio of from 50:50 to 40:60 by volume; and/or
(v) the hydrophobic medium comprises an oil, wherein the oil comprises silicone oil, a hydrocarbon, or a fluorocarbon, or a mixture of two or more thereof, and wherein the hydrocarbon is a C₁₀-C₂₀ alkane, preferably wherein the hydrocarbon is hexadecane.

15. An electrochemical circuit comprising the array according to any one of the preceding claims.

16. A method for detecting electromagnetic radiation, comprising exposing electromagnetic radiation to the array according to any one of claims 1 to 14 and measuring ion flux generated as an electrical current.

17. A method for making the array according to any one of claims 1 to 14, comprising:
(I) molding the scaffold and assembling the array;
(II) molding the scaffold and assembling the array, wherein the scaffold is the single common second aqueous object and comprises a plurality of cavities; or
(III) molding the scaffold and assembling the array, wherein the scaffold is the single common second aqueous object and comprises a plurality of cavities, and wherein the method further comprises placing each first aqueous object into a different one of the said cavities.

18. Use of the array according to any one of claims 11 to 14 for testing the activity or function of the said protein.

19. Use of the array according to any one of claims 1 to 14 for stimulating a voltage-sensitive membrane protein.

20. A method of generating an electrical signal, comprising exposing electromagnetic radiation to the array according to any one of claims 1 to 14, optionally wherein the electromagnetic radiation is light.

## Patentansprüche

1. Array von wässrigen Objekten, das konfiguriert ist, um einen elektrischen Strom zwischen einem ersten wässrigen Objekt und einem zweiten wässrigen Objekt zu leiten, wobei:
(a) das Array ein Gerüst, zwei oder mehr der ersten wässrigen Objekte und mindestens eines der zweiten wässrigen Objekte umfasst, wobei jedes der ersten und zweiten wässrigen Objekte ein wässriges Tröpfchen oder ein Hydrogel umfasst,
(b) die ersten wässrigen Objekte von (a) jeweils amphipathische Moleküle auf mindestens einem Teil der Oberfläche der ersten wässrigen Objekte umfassen,
(c) die zweiten wässrigen Objekte von (a) jeweils amphipathische Moleküle auf mindestens einem Teil der Oberfläche der zweiten wässrigen Objekte umfassen,
(d) die ersten wässrigen Objekte von (b) jeweils eine Grenzfläche mit dem zweiten wässrigen Objekt von (c) bilden, wobei das zweite wässrige Objekt Folgendes ist:
(i) ein einziges gemeinsames zweites wässriges Objekt oder
(ii) ein anderes individuelles zweites wässriges Objekt,
(e) die Grenzfläche von (d) eine Doppelschicht aus den amphipathischen Molekülen von (b) und (c) umfasst und ein lichtempfindliches Protein in der Doppelschicht dispergiert ist und
(f) das Gerüst die ersten wässrigen Objekte von (b) voneinander isoliert.

2. Array nach Anspruch 1, wobei:
(i) sich das Gerüst zwischen benachbarten ersten wässrigen Objekten erstreckt,
(ii) das Gerüst eine Barriere zwischen benachbarten ersten wässrigen Objekten bildet,
(iii) das Gerüst vordefinierte Positionen in dem Array für die ersten wässrigen Objekte bereitstellt,
(iv) das Array planar ist,
(v) das Array biokompatibel ist und/oder
(vi) das Gerüst eine Vielzahl von Kavitäten umfasst, die wiederum die ersten wässrigen Objekte umfassen.

3. Array nach Anspruch 1 oder 2, wobei das Gerüst eine Vielzahl von Kavitäten umfasst, die wiederum die ersten wässrigen Objekte umfassen, und wobei die Kavitäten das Gerüst durchziehen.

4. Array nach einem der vorhergehenden Ansprüche, wobei:
(I) die ersten wässrigen Objekte in elektrischem Kontakt mit zwei oder mehr ersten Kommunikationsmitteln stehen,
(II) das oder jedes zweite wässrige Objekt in elektrischem Kontakt mit mindestens einem zweiten Kommunikationsmittel steht und/oder
(III) (a) die ersten wässrigen Objekte in elektrischem Kontakt mit zwei oder mehr ersten Kommunikationsmitteln stehen und/oder (b) das oder jedes zweite wässrige Objekt in elektrischem Kontakt mit mindestens einem zweiten Kommunikationsmittel steht und (c):
(i) wobei jedes der ersten Kommunikationsmittel in elektrischem Kontakt mit einem anderen individuellen der ersten wässrigen Objekte steht,
(ii) wobei:
(I) das oder jedes der zweiten Kommunikationsmittel in elektrischem Kontakt mit einem des anderen individuellen zweiten wässrigen Objekts steht oder
(II) das oder jedes der zweiten Kommunikationsmittel in elektrischem Kontakt mit einem des anderen individuellen zweiten wässrigen Objekts steht und/oder wobei das oder jedes der zweiten Kommunikationsmittel in physischem Kontakt mit einem des anderen individuellen zweiten wässrigen Objekts steht oder
(III) das zweite Kommunikationsmittel ein einziges gemeinsames zweites Kommunikationsmittel ist und in elektrischem Kontakt mit dem einzigen gemeinsamen zweiten wässrigen Objekt steht oder
(IV) das zweite Kommunikationsmittel ein einziges gemeinsames zweites Kommunikationsmittel ist und in elektrischem Kontakt mit dem einzigen gemeinsamen zweiten wässrigen Objekt steht und wobei das einzige gemeinsame zweite Kommunikationsmittel in physischem Kontakt mit dem einzigen gemeinsamen zweiten wässrigen Objekt steht,
(iii) wobei jedes der ersten Kommunikationsmittel in physischem Kontakt mit einem anderen individuellen des ersten wässrigen Objekts steht,
(iv) wobei das Array ferner die ersten Kommunikationsmittel umfasst,
(v) wobei das Array ferner die zweiten Kommunikationsmittel umfasst,
(vi) wobei jedes erste Kommunikationsmittel eine erste Elektrode umfasst und/oder
(vii) wobei jedes zweite Kommunikationsmittel eine zweite Elektrode umfasst.

5. Array nach einem der vorhergehenden Ansprüche, wobei:
(I) das Gerüst das einzige gemeinsame zweite wässrige Objekt umfasst und/oder
(II) jedes erste wässrige Objekt ein wässriges Tröpfchen umfasst, das einzige gemeinsame zweite wässrige Objekt das Gerüst ist und das einzige gemeinsame zweite wässrige Objekt ein Hydrogel-Objekt umfasst.

6. Array nach einem der vorhergehenden Ansprüche, wobei:
(i) das Array ferner eine Tröpfchenanordnung umfasst,
(ii) das Array ferner eine Tröpfchenanordnung umfasst und wobei die Tröpfchenanordnung das einzige gemeinsame zweite wässrige Objekt umfasst,
(iii) das Array ferner eine Tröpfchenanordnung umfasst, wobei die Tröpfchenanordnung das einzige gemeinsame zweite wässrige Objekt umfasst und wobei die Tröpfchenanordnung das einzige gemeinsame zweite wässrige Objekt ist,
(iv) das zweite wässrige Objekt eine oder mehrere Zellen umfasst,
(v) das zweite wässrige Objekt eine oder mehrere Zellen umfasst und wobei die Zellen Nervenzellen sind,
(vi) das Gerüst ein Hydrogel-Objekt umfasst und/oder
(vii) das Gerüst ein Hydrogel-Objekt ist.

7. Array nach einem der vorhergehenden Ansprüche, wobei:
(I) das Gerüst das einzige gemeinsame zweite wässrige Objekt nicht umfasst oder
(II) das Gerüst das einzige gemeinsame zweite wässrige Objekt ist.

8. Array nach einem der Ansprüche 3 bis 5, wobei:
a) das Gerüst das einzige gemeinsame zweite wässrige Objekt ist,
b) das Gerüst ein Hydrogel-Objekt und zwei oder mehr Kavitäten umfasst,
c) die Kavitäten von (b) das Gerüst durchziehen,
d) sich das Gerüst auf einer Oberfläche befindet, die die zwei oder mehr ersten Kommunikationsmittel umfasst,
e) das Gerüst in elektrischem Kontakt mit dem einzigen gemeinsamen zweiten Kommunikationsmittel steht,
f) die Kavitäten von (b) über den ersten Kommunikationsmitteln von (d) liegen,
g) jede Kavität von (b) über einem anderen individuellen der ersten Kommunikationsmittel von (d) liegt,
h) jede Kavität von (b) ein anderes individuelles der ersten wässrigen Objekte enthält,
i) jedes erste wässrige Objekt von (h) eine andere Grenzfläche mit dem Gerüst bildet und
j) jedes erste wässrige Objekt von (h) in elektrischem Kontakt mit dem ersten Kommunikationsmittel von (g) steht, über dem die Kavität liegt,
optional wobei:
(I) jedes erste Kommunikationsmittel eine andere individuelle erste Elektrode umfasst und das einzige gemeinsame zweite Kommunikationsmittel eine zweite Elektrode umfasst und/oder
(II) das Gerüst in physischem Kontakt mit dem einzigen gemeinsamen zweiten Kommunikationsmittel steht und jedes erste wässrige Objekt in physischem Kontakt mit dem ersten Kommunikationsmittel von (g) steht, über dem die Kavität liegt.

9. Array nach einem der vorhergehenden Ansprüche, ferner umfassend:
(I) ein oder mehrere weitere wässrige Objekte, die in und/oder neben einem oder mehreren der ersten wässrigen Objekte von (d) in einem Abschnitt des Arrays, der durch das Gerüst isoliert ist, bereitgestellt sind, oder
(II) ein oder mehrere weitere wässrige Objekte, die in und/oder neben einem oder mehreren der ersten wässrigen Objekte von (d) in einem Abschnitt des Arrays, der durch das Gerüst isoliert ist, bereitgestellt sind, wobei:
(i) in einem Abschnitt des Arrays, der durch das Gerüst isoliert ist, eines oder mehrere des einen oder der mehreren weiteren wässrigen Objekte eine Grenzfläche mit dem zweiten wässrigen Objekt bilden,
(ii) in einem Abschnitt des Arrays, der durch das Gerüst isoliert ist, eines oder mehrere des einen oder der mehreren weiteren wässrigen Objekte eine Grenzfläche mit dem ersten wässrigen Objekt bilden,
(iii) in einem Abschnitt des Arrays, der durch das Gerüst isoliert ist, eines oder mehrere des einen oder der mehreren weiteren wässrigen Objekte eine Grenzfläche mit einem anderen einen oder mehreren des einen oder der mehreren weiteren wässrigen Objekte bilden und/oder
(iv) eines oder mehrere der ersten wässrigen Objekte und/oder eines oder mehrere der weiteren wässrigen Objekte eine oder mehrere Zellen und/oder ein oder mehrere Vesikel umfasst.

10. Array nach einem der vorhergehenden Ansprüche, wobei die Grenzfläche von (d) keine Doppelschicht aus amphipathischen Molekülen umfasst.

11. Array nach einem der Ansprüche 1 bis 9, wobei:
(i) ein Protein in der Doppelschicht dispergiert ist,
(ii) ein Protein in der Doppelschicht dispergiert ist und wobei das Protein ein Membranprotein ist,
(iii) das lichtempfindliche Protein Folgendes ist:
(I) ein lichtempfindlicher Ionenkanal,
(II) eine lichtempfindliche Ionenpumpe,
(III) eine lichtempfindliche Protonenpumpe oder
(IV) ein Fotorezeptorprotein,
und/oder
(iv) das lichtempfindliche Protein ein Fotorezeptorprotein ist und das Protein ein Rhodopsin, optional Bakteriorhodopsin ist.

12. Array nach einem der vorhergehenden Ansprüche, wobei:
(a) die amphipathischen Moleküle Lipidmoleküle umfassen,
(b) die amphipathischen Moleküle Phospholipidmoleküle umfassen,
(c) die amphipathischen Moleküle Phospholipidmoleküle umfassen und wobei die Phospholipide vernetzte Lipide umfassen,
(d) die amphipathischen Moleküle Phospholipidmoleküle umfassen und wobei die Phospholipide Blockcopolymere umfassen und/oder
(e) die amphipathischen Moleküle Phospholipidmoleküle umfassen, wobei die Phospholipide Blockcopolymere umfassen, wobei die Phospholipide nicht-PEGylierte Phospholipide und PEGylierte Phospholipide umfassen und wobei:
(i) 2,5 bis 15 Mol-% der Phospholipide PEGylierte Phospholipide sind,
(ii) 5 bis 15 Mol-% der Phospholipide PEGylierte Phospholipide sind,
(iii) 7,5 bis 15 Mol-% der Phospholipide PEGylierte Phospholipide sind oder
(iv) 10 bis 15 Mol-% der Phospholipide PEGylierte Phospholipide sind.

13. Array nach Ansprüchen 12(e), wobei:
(I) die PEGylierten Phospholipide eine PEG-Gruppe umfassen, die ein Molekulargewicht von 1500 bis 5000 g/mol aufweist,
(II) die PEGylierten Phospholipide eine PEG-Gruppe umfassen, die ein Molekulargewicht von 1800 bis 2200 g/mol aufweist,
(III) die nicht-PEGylierten Phospholipide Glycerophospholipide sind und/oder die PEGylierten Phospholipide Glycerophospholipide sind und/oder
(IV) die nicht-PEGylierten Phospholipide Glycerophospholipide sind und/oder die PEGylierten Phospholipide Glycerophospholipide sind und wobei:
(i) die nicht-PEGylierten Phospholipide Phospholipide der Formel (I) sind: 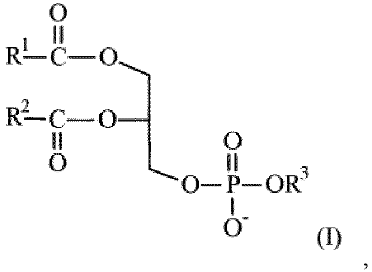 wobei:
R¹ und R², die gleich oder unterschiedlich sind, aus C₁₀-C₂₅-Alkyl gruppen und C₁₀-C₂₅-Alkenylgruppen ausgewählt sind,
R³ abwesend ist derart, dass OR³ O⁻ ist oder R³ vorhanden ist und H, CH₂CH₂N(R4)₃⁺, eine Zuckergruppe oder eine Aminosäuregruppe ist,
jedes R⁴, das gleich oder unterschiedlich ist, unabhängig aus H und unsubstituiertem C₁-C₄-Alkyl ausgewählt ist,
(ii) die PEGylierten Phospholipide Phospholipide der folgenden Formel (II) sind: 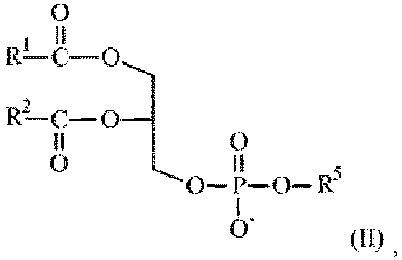 wobei:
R¹ und R² wie vorstehend für die Phospholipide der Formel (I) definiert sind und R⁵ eine Gruppe ist, die Poly(ethylenglykol) umfasst,
optional wobei:
R⁵ -CH₂CH₂NHC(O)-(OCH₂CH₂)_{q}OCH₃, -CH₂CH₂NHC(O)(CH₂)₃C(O)-(OCH₂CH₂)_{q}OCH₃, -CH₂CH₂NHC(O)-(OCH₂CH₂)_{q}OH oder -CH₂CH₂NHC(O)(CH₂)₃C(O)-(OCH₂CH₂)_{q}OH ist, wobei q eine ganze Zahl von 5 bis 10.000 ist,
(iii) die nicht-PEGylierten Phospholipide DPhPC umfassen,
(iv) die PEGylierten Phospholipide DPPE-mPEG2000 umfassen und/oder
(v) die Phospholipide DPhPC und DPPE-mPEG2000 umfassen und wobei die Phospholipide 2,5 bis 15 Mol-% DPPE-mPEG2000, optional 5 bis 15 Mol-% DPPE-mPEG2000 umfassen.

14. Array nach einem der vorhergehenden Ansprüche, ferner umfassend:
(I) ein hydrophobes Medium, wobei eines oder mehrere der ersten wässrigen Objekte in dem hydrophoben Medium angeordnet sind, und/oder
(II) ein hydrophobes Medium, wobei eines oder mehrere der ersten wässrigen Objekte in dem hydrophoben Medium angeordnet sind und wobei:
(i) das hydrophobe Medium ein Öl umfasst,
(ii) das hydrophobe Medium ein Öl umfasst, wobei das Öl Silikonöl, einen Kohlenwasserstoff oder einen Fluorkohlenstoff oder eine Mischung von zwei oder mehr davon umfasst,
(iii) das hydrophobe Medium ein Öl umfasst, wobei das hydrophobe Medium eine Mischung von einem Kohlenwasserstoff und Silikonöl umfasst,
(iv) das hydrophobe Medium ein Öl umfasst, wobei das hydrophobe Medium eine Mischung von einem Kohlenwasserstoff und Silikonöl umfasst und wobei das hydrophobe Medium ein Volumenverhältnis von Kohlenwasserstoff:Silikonöl von 50:50 bis 20:80 oder von 50:50 bis 80:20, vorzugsweise in einem Volumenverhältnis von 50:50 bis 40:60 umfasst, und/oder
(v) das hydrophobe Medium ein Öl umfasst, wobei das Öl Silikonöl, einen Kohlenwasserstoff oder einen Fluorkohlenstoff oder eine Mischung von zwei oder mehr davon umfasst und wobei der Kohlenwasserstoff ein C₁₀-C₂₀-Alkan ist, vorzugsweise wobei der Kohlenwasserstoff Hexadecan ist.

15. Elektrochemische Schaltung, umfassend das Array nach einem der vorhergehenden Ansprüche.

16. Verfahren zum Detektieren von elektromagnetischer Strahlung, umfassend Aussetzen des Arrays nach einem der Ansprüche 1 bis 14 elektromagnetischer Strahlung und Messen von Ionenfluss, der als ein elektrischer Strom erzeugt ist.

17. Verfahren zum Herstellen des Arrays nach einem der Ansprüche 1 bis 14, umfassend:
(I) Formen des Gerüsts und Zusammenbauen des Arrays,
(II) Formen des Gerüsts und Zusammenbauen des Arrays, wobei das Gerüst das einzige gemeinsame zweite wässrige Objekt ist und eine Vielzahl von Kavitäten umfasst, oder
(III) Formen des Gerüsts und Zusammenbauen des Arrays, wobei das Gerüst das einzige gemeinsame zweite wässrige Objekt ist und eine Vielzahl von Kavitäten umfasst und wobei das Verfahren ferner Platzieren jedes ersten wässrigen Objekts in eine andere der Kavitäten umfasst.

18. Verwendung des Arrays nach einem der Ansprüche 11 bis 14 zum Testen der Aktivität oder Funktion des Proteins.

19. Verwendung des Arrays nach einem der Ansprüche 1 bis 14 zum Stimulieren eines spannungsempfindlichen Membranproteins.

20. Verfahre zum Erzeugen eines elektrischen Signals, umfassend Aussetzen des Arrays nach einem der Ansprüche 1 bis 14 elektromagnetischer Strahlung, optional wobei die elektromagnetische Strahlung Licht ist.

## Revendications

1. Réseau d'objets aqueux configurés pour faire passer un courant électrique entre un premier objet aqueux et un second objet aqueux, dans lequel :
(a) le réseau comprend un échafaudage, deux, ou plus, des premiers objets aqueux et au moins un des seconds objets aqueux, dans lequel chacun des premiers et seconds objets aqueux comprend une gouttelette aqueuse ou un hydrogel ;
(b) lesdits premiers objets aqueux de (a) comprennent chacun des molécules amphipathiques sur au moins une partie de la surface des premiers objets aqueux ;
(c) lesdits seconds objets aqueux de (a) comprennent chacun des molécules amphipathiques sur au moins une partie de la surface des seconds objets aqueux ;
(d) lesdits premiers objets aqueux de (b) forment chacun une interface avec le second objet aqueux de (c), dans lequel le second objet aqueux est :
(i) un second objet aqueux commun unique, ou
(ii) un second objet aqueux individuel différent ;
(e) ladite interface de (d) comprend une bicouche desdites molécules amphipathiques de (b) et (c), et une protéine photosensible est dispersée dans la bicouche ; et
(f) l'échafaudage isole lesdits premiers objets aqueux de (b) les uns des autres.

2. Réseau selon la revendication 1, dans lequel :
(i) l'échafaudage s'étend entre des premiers objets aqueux adjacents ;
(ii) l'échafaudage forme une barrière entre des premiers objets aqueux adjacents ;
(iii) l'échafaudage fournit des positions prédéfinies dans le réseau pour les premiers objets aqueux ;
(iv) le réseau est plan ;
(v) le réseau est biocompatible ; et/ou
(vi) l'échafaudage comprend une pluralité de cavités qui comprennent à leur tour les premiers objets aqueux.

3. Réseau selon la revendication 1 ou 2, dans lequel l'échafaudage comprend une pluralité de cavités qui comprennent à leur tour les premiers objets aqueux, et dans lequel les cavités traversent l'échafaudage.

4. Réseau selon l'une quelconque des revendications précédentes, dans lequel :
(I) les premiers objets aqueux sont en contact électrique avec deux, ou plus, premiers moyens de communication ;
(II) le ou chaque second objet aqueux est en contact électrique avec au moins un second moyen de communication ; et/ou
(III) (a) les premiers objets aqueux sont en contact électrique avec deux, ou plus, premiers moyens de communication et/ou (b) le ou chaque second objet aqueux est en contact électrique avec au moins un second moyen de communication ; et (c) :
(i) dans lequel chacun des premiers moyens de communication est en contact électrique avec un objet aqueux individuel différent, desdits premiers objets aqueux ;
(ii) dans lequel :
(I) le ou chacun du second moyen de communication est en contact électrique avec un dudit second objet aqueux individuel différent ; ou
(II) le ou chacun du second moyen de communication est en contact électrique avec un dudit second objet aqueux individuel différent, et/ou dans lequel le ou chacun du second moyen de communication est en contact physique avec un dudit second objet aqueux individuel différent ; ou
(III) le second moyen de communication est un second moyen de communication commun unique et est en contact électrique avec le second objet aqueux commun unique ; ou
(IV) le second moyen de communication est un second moyen de communication commun unique et est en contact électrique avec le second objet aqueux commun unique, et dans lequel le second moyen de communication commun unique est en contact physique avec le second objet aqueux commun unique ;
(iii) dans lequel chacun des premiers moyens de communication est en contact physique avec un objet aqueux individuel différent, dudit premier objet aqueux ;
(iv) dans lequel le réseau comprend en outre lesdits premiers moyens de communication ;
(v) dans lequel le réseau comprend en outre ledit second moyen de communication ;
(vi) dans lequel chaque premier moyen de communication comprend une première électrode ; et/ou
(vii) dans lequel chaque second moyen de communication comprend une seconde électrode.

5. Réseau selon l'une quelconque des revendications précédentes, dans lequel :
(I) l'échafaudage comprend le second objet aqueux commun unique ; et/ou
(II) chaque premier objet aqueux comprend une gouttelette aqueuse, le second objet aqueux commun unique est l'échafaudage et le second objet aqueux commun unique comprend un objet en hydrogel.

6. Réseau selon l'une quelconque des revendications précédentes, dans lequel :
(i) le réseau comprend en outre un ensemble de gouttelettes ;
(ii) le réseau comprend en outre un ensemble de gouttelettes, et dans lequel l'ensemble de gouttelettes comprend le second objet aqueux commun unique ;
(iii) le réseau comprend en outre un ensemble de gouttelettes, dans lequel l'ensemble de gouttelettes comprend le second objet aqueux commun unique, et dans lequel l'ensemble de gouttelettes est le second objet aqueux commun unique ;
(iv) le second objet aqueux comprend une ou plusieurs cellules ;
(v) le second objet aqueux comprend une ou plusieurs cellules, et dans lequel les cellules sont des cellules neurales ;
(vi) l'échafaudage comprend un objet en hydrogel ; et/ou
(vii) l'échafaudage est un objet en hydrogel.

7. Réseau selon l'une quelconque des revendications précédentes, dans lequel :
(I) l'échafaudage ne comprend pas le second objet aqueux commun unique ; ou
(II) l'échafaudage est le second objet aqueux commun unique.

8. Réseau selon l'une quelconque des revendications 3 à 5, dans lequel :
a) l'échafaudage est le second objet aqueux commun unique ;
b) l'échafaudage comprend un objet en hydrogel et deux, ou plus, cavités ;
c) les cavités de (b) traversent l'échafaudage ;
d) l'échafaudage est placé sur une surface comprenant lesdits deux, ou plus, premiers moyens de communication ;
e) l'échafaudage est en contact électrique avec le second moyen de communication commun unique ;
f) les cavités de (b) sont situées par-dessus les premiers moyens de communication de (d) ;
g) chaque cavité de (b) est située par-dessus un premier moyen de communication individuel différent, des premiers moyens de communication de (d) ;
h) chaque cavité de (b) contient un objet aqueux individuel différent, des premiers objets aqueux ;
i) chaque premier objet aqueux de (h) forme une dite interface différente avec l'échafaudage ; et
j) chaque premier objet aqueux de (h) est en contact électrique avec le premier moyen de communication de (g) par-dessus lequel ladite cavité est située ;
optionnellement, dans lequel :
(I) chaque premier moyen de communication comprend une première électrode individuelle différente et le second moyen de communication commun unique comprend une seconde électrode ; et/ou
(II) l'échafaudage est en contact physique avec le second moyen de communication commun unique et chaque premier objet aqueux est en contact physique avec le premier moyen de communication de (g) par-dessus lequel la cavité est située.

9. Réseau selon l'une quelconque des revendications précédentes, comprenant en outre :
(I) un ou plusieurs objets aqueux supplémentaires qui sont prévus à l'intérieur d'un ou de plusieurs, et/ou de façon adjacente à un ou plusieurs, des premiers objets aqueux de (d) dans une portion du réseau isolée par l'échafaudage ; ou
(II) un ou plusieurs objets aqueux supplémentaires qui sont prévus à l'intérieur d'un ou de plusieurs, et/ou de façon adjacente à un ou plusieurs, des premiers objets aqueux de (d) dans une portion du réseau isolée par l'échafaudage, dans lequel :
(i) dans une portion du réseau isolée par l'échafaudage, un ou plusieurs de l'un ou des plusieurs objets aqueux supplémentaires forment une interface avec le second objet aqueux ;
(ii) dans une portion du réseau isolée par l'échafaudage, un ou plusieurs de l'un ou des plusieurs objets aqueux supplémentaires forment une interface avec le premier objet aqueux ;
(iii) dans une portion du réseau isolée par l'échafaudage, un ou plusieurs de l'un ou des plusieurs objets aqueux supplémentaires forment une interface avec un ou plusieurs autres de l'un ou des plusieurs objets aqueux supplémentaires ; et/ou
(iv) un ou plusieurs des premiers objets aqueux et/ou un ou plusieurs des objets aqueux supplémentaires comprennent une ou plusieurs cellules et/ou une ou plusieurs vésicules.

10. Réseau selon l'une quelconque des revendications précédentes, dans lequel ladite interface de (d) ne comprend pas de bicouche de molécules amphipathiques.

11. Réseau selon l'une quelconque des revendications 1 à 9, dans lequel :
(i) une protéine est dispersée dans la bicouche ;
(ii) une protéine est dispersée dans la bicouche, et dans lequel la protéine est une protéine membranaire ;
(iii) la protéine photosensible est :
(I) un canal d'ions photosensible,
(II) une pompe à ions photosensible,
(III) une pompe à protons photosensible, ou
(IV) une protéine photoréceptrice ;
et/ou
(iv) la protéine photosensible est une protéine photoréceptrice, et la protéine est une rhodopsine, optionnellement une bactériorhodopsine.

12. Réseau selon l'une quelconque des revendications précédentes, dans lequel :
(a) les molécules amphipathiques comprennent des molécules lipidiques ;
(b) les molécules amphipathiques comprennent des molécules phospholipidiques ;
(c) les molécules amphipathiques comprennent des molécules phospholipidiques, et dans lequel les phospholipides comprennent des lipides réticulés ;
(d) les molécules amphipathiques comprennent des molécules phospholipidiques, et dans lequel les phospholipides comprennent des copolymères séquencés ; et/ou
(e) les molécules amphipathiques comprennent des molécules phospholipidiques, dans lequel les phospholipides comprennent copolymères séquencés, dans lequel les phospholipides comprennent des phospholipides non PEGylés et des phospholipides PEGylés, et dans lequel :
(i) de 2,5 à 15 % molaire des phospholipides sont des phospholipides PEGylés ;
(ii) de 5 à 15 % molaire des phospholipides sont des phospholipides PEGylés ;
(iii) de 7,5 à 15 % molaire des phospholipides sont des phospholipides PEGylés ; ou
(iv) de 10 à 15 % molaire des phospholipides sont des phospholipides PEGylés.

13. Réseau selon la revendication 12(e), dans lequel :
(I) les phospholipides PEGylés comprennent un groupe PEG qui a un poids moléculaire de 1500 à 5000 g/mol ;
(II) les phospholipides PEGylés comprennent un groupe PEG qui a un poids moléculaire de 1800 à 2200 g/mol ;
(III) les phospholipides non PEGylés sont des glycérophospholipides et/ou les phospholipides PEGylés sont des glycérophospholipides ; et/ou
(IV) les phospholipides non PEGylés sont des glycérophospholipides et/ou les phospholipides PEGylés sont des glycérophospholipides, et dans lequel :
(i) les phospholipides non PEGylés sont des phospholipides de la formule (I) : 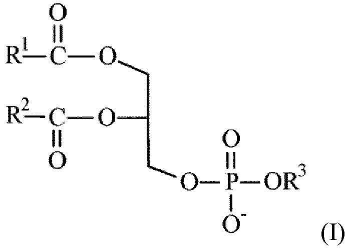 dans lequel :
R¹ et R², qui sont les mêmes ou différents, sont sélectionnés parmi des groupes alkyle C₁₀-C₂₅ et des groupes alcényle C₁₀-C₂₅ ;
R³ est absent de telle sorte que OR³ est O⁻, ou R³ est présent et est H, CH₂CH₂N(R4)₃⁺, un groupe sucre, ou un groupe acide aminé ; et
chaque R⁴, qui est le même ou différent, est indépendamment sélectionné parmi H et alkyle C₁-C₄ non substitué ;
(ii) les phospholipides PEGylés sont des phospholipides de la formule suivante (II) 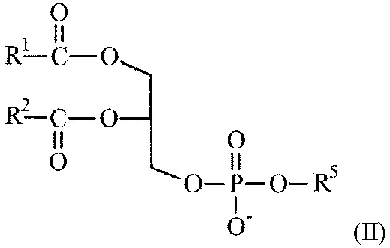 dans lequel :
R¹ et R² sont tels que définis ci-dessus pour les phospholipides de la formule (I), et R⁵ est un groupe qui comprend du poly(éthylène glycol),
optionnellement dans lequel :
R⁵ est -CH₂CH₂NHC(O)-(OCH₂CH₂)_{q}OCH₃, -CH₂CH₂NHC(O)(CH₂)₃C(O)-(OCH₂CH₂)_{q}OCH₃, -CH₂CH₂NHC(O)-(OCH₂CH₂)_{q}OH, ou -CH₂CH₂NHC(O)(CH₂)₃C(O)-(OCH₂CH₂)_{q}OH, dans lequel q est un nombre entier relatif de 5 à 10000 ;
(iii) les phospholipides non PEGylés comprennent DPhPC ;
(iv) les phospholipides PEGylés comprennent DPPE-mPEG2000 ; et/ou
(v) les phospholipides comprennent DPhPC et DPPE-mPEG2000, et dans lequel les phospholipides comprennent de 2,5 à 15 % molaire de DPPE-mPEG2000, optionnellement de 5 à 15 % molaire de DPPE-mPEG2000.

14. Réseau selon l'une quelconque des revendications précédentes, comprenant en outre :
(I) un milieu hydrophobe, dans lequel un ou plusieurs des premiers objets aqueux sont disposés dans le milieu hydrophobe ; et/ou
(II) un milieu hydrophobe, dans lequel un ou plusieurs des premiers objets aqueux sont disposés dans le milieu hydrophobe, et dans lequel :
(i) le milieu hydrophobe comprend une huile ;
(ii) le milieu hydrophobe comprend une huile, dans lequel l'huile comprend de l'huile de silicone, un hydrocarbure, ou un fluorocarbure, ou un mélange de deux, ou plus, de ceux-ci ;
(iii) le milieu hydrophobe comprend une huile, dans lequel le milieu hydrophobe comprend un mélange d'un hydrocarbure et d'huile de silicone ;
(iv) le milieu hydrophobe comprend une huile, dans lequel le milieu hydrophobe comprend un mélange d'un hydrocarbure et d'huile de silicone, et dans lequel le milieu hydrophobe comprend un rapport hydrocarbure:huile de silicone de 50:50 à 20:80 en volume, ou de 50:50 à 80:20 en volume, de préférence en un rapport de 50:50 à 40:60 en volume ; et/ou
(v) le milieu hydrophobe comprend une huile, dans lequel l'huile comprend de l'huile de silicone, un hydrocarbure, ou un fluorocarbure, ou un mélange de deux, ou plus, de ceux-ci, et dans lequel l'hydrocarbure est un alcane C₁₀-C₂₀, de préférence dans lequel l'hydrocarbure est un hexadécane.

15. Circuit électrochimique, comprenant le réseau selon l'une quelconque des revendications précédentes.

16. Procédé pour détecter un rayonnement électromagnétique, comprenant l'exposition, à un rayonnement électromagnétique, du réseau selon l'une quelconque des revendications 1 à 14 et la mesure de flux d'ions généré sous forme de courant électrique.

17. Procédé pour réaliser le réseau selon l'une quelconque des revendications 1 à 14, comprenant :
(I) le moulage de l'échafaudage et l'assemblage du réseau ;
(II) le moulage de l'échafaudage et l'assemblage du réseau, dans lequel l'échafaudage est le second objet aqueux commun unique et comprend une pluralité de cavités ; ou
(III) le moulage de l'échafaudage et l'assemblage du réseau, dans lequel l'échafaudage est le second objet aqueux commun unique et comprend une pluralité de cavités, et dans lequel le procédé comprend en outre le placement de chaque premier objet aqueux dans une cavité différente, desdites cavités.

18. Utilisation du réseau selon l'une quelconque des revendications 11 à 14 pour tester l'activité ou la fonction de ladite protéine.

19. Utilisation du réseau selon l'une quelconque des revendications 1 à 14 pour stimuler une protéine membranaire sensible à la tension.

20. Procédé de génération d'un signal électrique, comprenant l'exposition, à un rayonnement électromagnétique, du réseau selon l'une quelconque des revendications 1 à 14, optionnellement dans lequel le rayonnement électromagnétique est de la lumière.
